# EUROPEAN PATENT SPECIFICATION

(11) **EP 3 136 461 B1**
(45) Date of publication and mention of the grant of the patent: **26.06.2019**
(21) Application number: 15782901.1
(22) Date of filing: 16.04.2015
(51) Int. Cl.: H01L 51/44, H01L 51/42

(54) **PHOTOELECTRIC CONVERSION ELEMENT, SOLAR CELL IN WHICH SAME IS USED, AND METHOD FOR MANUFACTURING PHOTOELECTRIC CONVERSION ELEMENT**
ELEMENT ZUR PHOTOELEKTRISCHEN UMWANDLUNG, VERWENDUNG DES ELEMENTS IN EINER SOLARZELLE UND VERFAHREN ZUR HERSTELLUNG EINES ELEMENTS ZUR PHOTOELEKTRISCHEN UMWANDLUNG
ÉLÉMENT DE CONVERSION PHOTOÉLECTRIQUE, CELLULE SOLAIRE DANS LAQUELLE IL EST UTILISÉ, ET PROCÉDÉ DE FABRICATION D'UN ÉLÉMENT DE CONVERSION PHOTOÉLECTRIQUE

(30) Priority: 25.04.2014 JP 2014092110; 09.03.2015 JP 2015046441
(43) Date of publication of application: 01.03.2017
(73) Proprietor: Fujifilm Corporation, Minato-ku Tokyo 106-8620 (JP)
(72) Inventor: SATOU, Hirotaka, Ashigarakami-gun Kanagawa 258-8577 (JP); KOBAYASHI, Katsumi, Ashigarakami-gun Kanagawa 258-8577 (JP)
(74) Representative: Hoffmann Eitle
(86) International application number: PCT/JP2015/061725
(87) International publication number: WO 2015/163233

(56) References cited:
- WO-A1-2014/050527
- JP-A- 2012 216 496
- KR-A- 20140 035 284
- GIANCARLO S. LORENA ET AL.: 'Electronic Properties and Device Fabrication of Soluble Organic-Inorganic Copper Halide Based Perovskites, Extended Abstracts;' JSAP AUTUMN MEETING vol. 74, 31 August 2013, pages 12 - 055, XP055335260

## Description

### BACKGROUND OF THE INVENTION

### 1. Field of the Invention

The present invention relates to a photoelectric conversion element, a solar cell using the same, and a method for manufacturing a photoelectric conversion element.

### 2. Description of the Related Art

Photoelectric conversion elements are used in a variety of optical sensors, copiers, solar cells, and the like. It is anticipated that solar cells will be actively put into practical use as cells using non-exhaustible solar energy. Among them, active research and development is underway regarding dye sensitized solar cells in which an organic coloring agent, a Ru bipyridyl complex, or the like is used as a sensitizer, and the photoelectric conversion efficiency thereof reaches approximately 11%.

Meanwhile, in recent years, there have been reports of research results that solar cells in which a metal halide is used as a compound having a perovskite-type crystal structure (perovskite compound) are capable of achieving a relatively high conversion efficiency, and these solar cells have been attracting attention.

KR10-1172374B describes a solar cell comprising a light-absorbing layer including a perovskite represented by CH₃NH₃MX₃ (M represents Pb or Sn, and X represents a halogen atom) and a semiconductor fine particle layer and an electrolyte layer made of an electrolytic solution.

WO2013/171517A1 describes a photoelectric conversion element having a light absorber having a perovskite structure of mixed anions and a solid hole transportation layer.

WO2014/050527 A1 describes a photoelectric conversion element that comprises a conductive supporting body, a photosensitive layer that contains an electrolyte, a charge transfer layer that contains an electrolyte, and a counter electrode. The photosensitive layer contains fine semiconductor particles, each of which supports a metal complex dye.

JP 2012-216496 A describes a dye-sensitized solar cell to which an adsorbent is added to the dye-sensitized layer. The adsorbent has an acidic group selected from a sulfonic acid group, or a phosphoric acid group, or a phosphonic acid group, or a carboxylic acid group.

Lorena *et al.* describe electroni properties and device fabrication of soluble organic-inorganic copper halide based perovskites of structure R₂CuX₄ including tetramethyl-p-phenylenediamine on the surface thereof (see JSAP Autumn Meeting, 2013, vol. 74, page 12-055).

As described above, solar cells in which a perovskite compound is used have produced a certain result in terms of improvement in the photoelectric conversion efficiency. However, these solar cells have just been developed, and thus there is only an insufficient amount of research and studies regarding cell performance.

In such a situation, the present inventors produced solar cells by repeating the same manufacturing method using a perovskite compound and found that the fluctuation (variation) of photoelectric conversion efficiency is great among the obtained solar cells and there is a problem in terms of realizing the stability of cell performance.

Therefore, an object of the present invention is to provide a photoelectric conversion element which has a photoelectric conversion efficiency that varies only to a small extent and exhibits stable cell performance and a solar cell comprising the same.

In addition, another object of the present invention is to provide a method for manufacturing a photoelectric conversion element exhibiting stable cell performance.

### SUMMARY OF THE INVENTION

As a result of a variety of studies regarding solar cells for which a perovskite compound is used as a light absorber (also referred to as perovskite sensitized solar cells), the present inventors found that the adhesiveness (compatibility) between a layer forming the surface of a first electrode and a solid hole transportation layer has an influence on the fluctuation of photoelectric conversion efficiency. As a result of additional studies, the present inventors found that, when a specific compound is interposed between the surface of the first electrode and the solid hole transportation layer, the adhesiveness between the surface of the first electrode and the solid hole transportation layer enhances and, furthermore, it is possible to prevent backward electron migration. Furthermore, it was found that, even in solar cells provided with a layer other than the hole transportation layer (also referred to as the non-hole-transportation layer) between the first electrode and a second electrode, when a specific compound is provided on the surface of the first electrode, the adhesiveness between the surface of the first layer and the non-hole-transportation layer enhances and, furthermore, it is possible to prevent backward charge migration (backward electron migration or backward hole migration). The present invention has been completed on the basis of the above-described findings.

That is, the objects are achieved by means of the following means.
A photoelectric conversion element comprising: a first electrode having a photosensitive layer including a light absorber on a conductive support; and a second electrode facing the first electrode, in which the light absorber includes a compound having a perovskite-type crystal structure represented by Formula (I) below having a cation of a cationic organic group A, a cation of a metallic atom M, and an anion that is an anionic atom or atomic group X, and a layer of at least one compound selected from compounds represented by any formula of Formulae (3) to (5) below is provided on a surface of the first electrode:

Formula (I): AₐMₘXₓ

in Formula (I), A represents a cationic organic group represented by Formula (1) below, M represents Pb, Sn, or Pb and Sn, X represents an anionic atom or atomic group, a represents 1 or 2, m represents 1, and a, m, and x satisfy a+2m=x,

Formula (1): R^{1a}-NH₃

in Formula (1), R^{1a} represents a substituent;

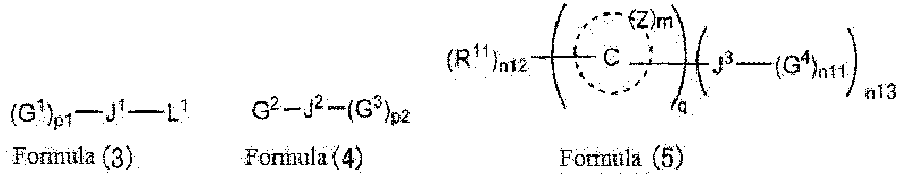

in Formula (3), G¹ represents a group or a salt selected from the group consisting of -OR^{a}, -O⁻Ya⁺, -SR^{a}, -S⁻Ya⁺, -NR^{a}R^{b}, and -(NR^{a}R^{b}R^{c})⁺ Ya⁻, R^{a}, R^{b}, and R^{c} each independently represent a hydrogen atom or a substituent, Ya represents a counter salt, L¹ represents an alkyl group, a cycloalkyl group, a cycloalkenyl group, or a cycloalkadiene group, J¹ represents a single bond or at least one linking group selected from the group consisting of linking groups represented by Formulae J-1 to J-8 below, and p1 is an integer of 1 or higher,
in Formula (4), G² and G³ are each independently identical to G¹, J² represents a linking group, and p2 represents an integer of 1 or higher,
in Formula (5), a ring C represents an aromatic hetero ring, Z represents a hetero atom or NR¹², m represents 1 or 2, R¹¹ represents a substituent, R¹² represents a hydrogen atom or a substituent, G⁴ is identical to G¹, J³ represents a single bond or a linking group, n11 represents an integer of 1 or higher, and n12 and n13 each independently represent an integer of 0 or higher; here, in a case in which a nitrogen atom is not a constituent atom of the ring C, n13 represents an integer of 1 or higher, and q represents an integer of 1 or higher, 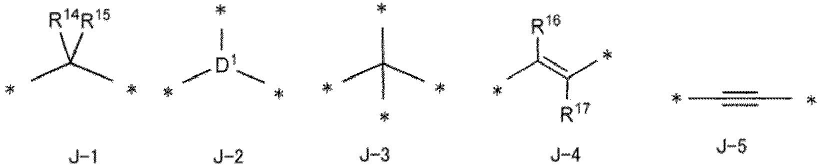 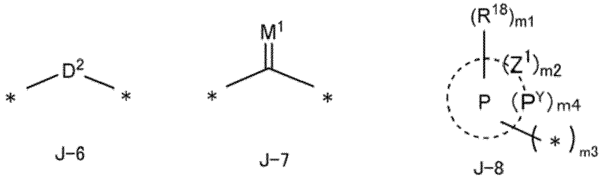 in the formulae, * represents a linking portion to L¹, G¹, G², or G³, or a linking portion to other linking groups represented by any formula of Formulae J-1 to J-8, D¹ represents a nitrogen atom, N⁺R¹⁹, or CR²⁰, D² represents an oxygen atom, a sulfur atom, or NR²¹, M¹ represents an oxygen atom, a sulfur atom, or NR²², Z¹ represents a hetero atom or NR¹³, P^{Y} represents >C=CR^{Y1}R^{Y2}, >C=S, or >C=O, a ring P represents an aliphatic hydrocarbon ring or an aliphatic hetero ring, R¹³ to R¹⁷ and R¹⁹ to R²² each independently represent a hydrogen atom or a substituent, R¹⁸, R^{Y1}, and R^{Y2} each independently represent a substituent, m1 represents an integer of 0 or higher, m2 represents an integer of 0 or higher, m3 represents an integer of 2 or higher, and m4 represents an integer of 0 or higher.

A method for manufacturing a photoelectric conversion element, in which a first electrode having, on a conductive support, a photosensitive layer in which a compound having a perovskite-type crystal structure represented by Formula (I) below having a cation of a cationic organic group A, a cation of a metallic atom M, and an anion that is an anionic atom or atomic group X is included as a light absorber is brought into contact with liquid containing at least one compound selected from compounds represented by any formula of Formulae (3) to (5) below, thereby forming a layer of the compound on a surface of the first electrode:

Formula (I): AₐMₘXₓ

in Formula (I), A represents a cationic organic group represented by Formula (1) below, M represents Pb, Sn, or Pb and Sn, X represents an anionic atom or atomic group, a represents 1 or 2, m represents 1, and a, m, and x satisfy a+2m=x,

Formula (1): R^{1a}-NH₃

in Formula (1), R^{1a} represents a substituent;

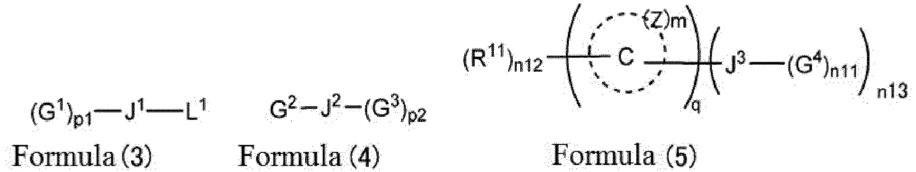

in Formula (3), G¹ represents a group or a salt selected from the group consisting of -OR^{a}, -O⁻Ya⁺, -SR^{a}, -S⁻Ya⁺, -NR^{a}R^{b}, and -(NR^{a}R^{b}R^{c})⁺ Ya⁻, R^{a}, R^{b}, and R^{c} each independently represent a hydrogen atom or a substituent, Ya represents a counter salt, L¹ represents an alkyl group, a cycloalkyl group, a cycloalkenyl group, or a cycloalkadiene group, J¹ represents a single bond or at least one linking group selected from the group consisting of linking groups represented by Formulae J-1 to J-8 below, and p1 is an integer of 1 or higher,
in Formula (4), G² and G³ are each independently identical to G¹, J² represents a linking group, and p2 represents an integer of 1 or higher,
in Formula (5), a ring C represents an aromatic hetero ring, Z represents a hetero atom or NR¹², m represents 1 or 2, R¹¹ represents a substituent, R¹² represents a hydrogen atom or a substituent, G⁴ is identical to G¹, J³ represents a single bond or a linking group, n11 represents an integer of 1 or higher, and n12 and n13 each independently represent an integer of 0 or higher; here, in a case in which a nitrogen atom is not a constituent atom of the ring C, n13 represents an integer of 1 or higher, and q represents an integer of 1 or higher, 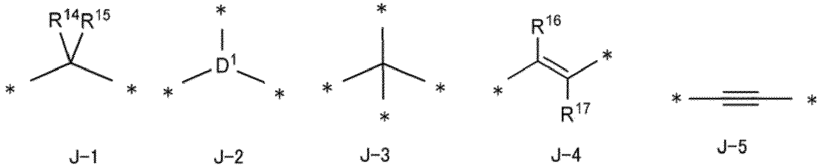 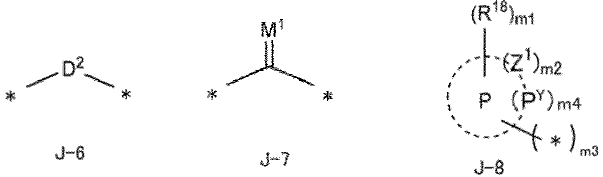 in the formulae, represents a linking portion to L¹, G¹, G², or G³, or a linking portion to other linking groups represented by any formula of Formulae J-1 to J-8, D¹ represents a nitrogen atom, N⁺R¹⁹, or CR²⁰, D² represents an oxygen atom, a sulfur atom, or NR²¹, M¹ represents an oxygen atom, a sulfur atom, or NR²², Z¹ represents a hetero atom or NR¹³, P^{Y} represents >C=CR^{Y1}R^{Y2}, >C=S, or >C=O, a ring P represents an aliphatic hydrocarbon ring or an aliphatic hetero ring, R¹³ to R¹⁷ and R¹⁹ to R²² each independently represent a hydrogen atom or a substituent, R¹⁸, R^{Y1}, and R^{Y2} each independently represent a substituent, m1 represents an integer of 0 or higher, m2 represents an integer of 0 or higher, m3 represents an integer of 2 or higher, and m4 represents an integer of 0 or higher.

Preferred embodiments of the invention are described in the appended claims.

In the present specification, regarding the expression of the respective formulae, there are cases in which a part of the formula is expressed as a rational formula in order for understanding of the chemical structure of a compound. Accordingly, in the respective formulae, partial structures are called groups (substituents), ions, atoms, or the like; however, in the present specification, there are cases in which the partial structures will refer to element groups or elements constituting groups (substituents) or ions represented by the above-illustrated formulae in addition to groups (substituents), ions, atoms, or the like.

In the present specification, the expression of compounds (including complexes and coloring agents) is used to indicate not only the compounds themselves but also salts or ions thereof. In addition, the expression indicates compounds and the like having a structure that is partially modified within the intended effects. Furthermore, compounds in which it is not clear whether the compounds are substituted or unsubstituted compounds may have an arbitrary substituent as long as a desired effect is exhibited. What has been described above shall also apply to substituents, linking groups, and the like (hereinafter, substituents and the like).

In the present specification, when there are multiple substituents and the like expressed using a specific reference symbol or multiple substituents and the like are specified at the same time, the respective substituents and the like may be identical to or different from each other unless particularly otherwise described. What has been described above shall also apply to the specification regarding the number of substituents and the like. In addition, when multiple substituents and the like are close to each other (for example, are adjacent to each other), the substituents and the like may be linked to each other and thus form a ring unless particularly otherwise described. In addition, rings, for example, alicycles, aromatic rings, and hetero rings may be further fused together and thus form a fused ring.

In addition, in the present specification, numerical ranges expressed using "to" include numerical values before and after the "to" as the lower limit value and the upper limit value.

Due to the present invention, it becomes possible to provide a photoelectric conversion element which has a photoelectric conversion efficiency that varies only to a small extent among products and exhibits stable cell performance and a solar cell comprising the same.

In addition, it becomes possible to provide a method for manufacturing a photoelectric conversion element exhibiting the above-described stable cell performance.

The above-described and other characteristics and advantages of the present invention will be further clarified from the following description with appropriate reference to the accompanying drawings.

### BRIEF DESCRIPTION OF THE DRAWINGS

Fig. 1 is a cross sectional view schematically illustrating a preferred aspect of a photoelectric conversion element of the present invention including an enlarged view of a circled portion in a layer.
Fig. 2 is a cross sectional view schematically illustrating a preferred aspect of the photoelectric conversion element of the present invention including a thick photosensitive layer.
Fig. 3 is a cross sectional view schematically illustrating another preferred aspect of the photoelectric conversion element of the present invention and an enlarged view of a circled portion in a layer.
Fig. 4 is a cross sectional view schematically illustrating still another preferred aspect of the photoelectric conversion element of the present invention.
Fig. 5 is a cross sectional view schematically illustrating still another preferred aspect of the photoelectric conversion element of the present invention.
Fig. 6 is a cross sectional view schematically illustrating still another preferred aspect of the photoelectric conversion element of the present invention and an enlarged view of a circled portion in a layer.

### DESCRIPTION OF THE PREFERRED EMBODIMENTS

### <<Photoelectric conversion element>>

A photoelectric conversion element of the present invention includes a first electrode having a photosensitive layer including a light absorber on a conductive support and a second electrode facing the first electrode. The first electrode has a compound represented by any formula of Formulae (3) to (5) on a surface thereof.

In the present invention, the photosensitive layer being provided on the conductive support means an aspect in which the photosensitive layer is provided in contact with the surface of the conductive support or an aspect in which the photosensitive layer is provided above the surface of the conductive support through another layer.

In the aspect in which the photosensitive layer is provided above the surface of the conductive support through another layer, the layer that is provided between the conductive support and the photosensitive layer is not particularly limited as long as the layer does not degrade the cell performance of the solar cell. Examples thereof include porous layers, blocking layers, electron transportation layers, hole transportation layers, and the like.

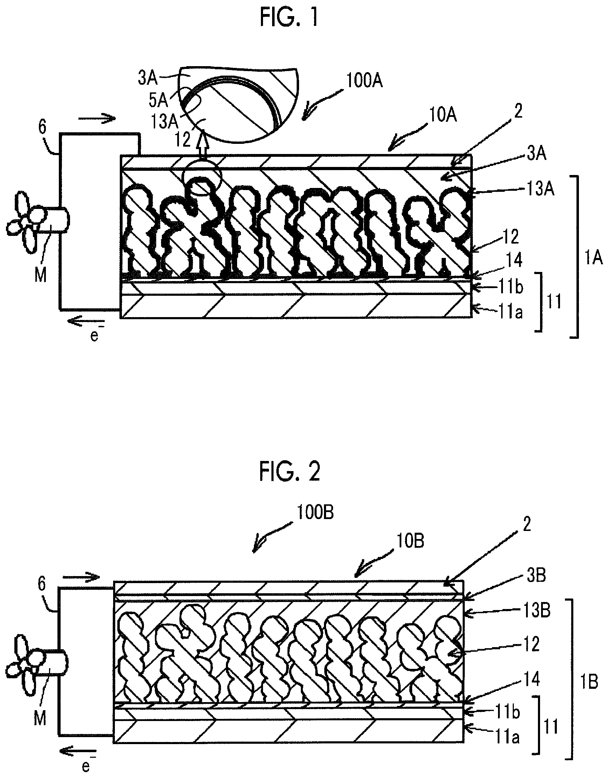

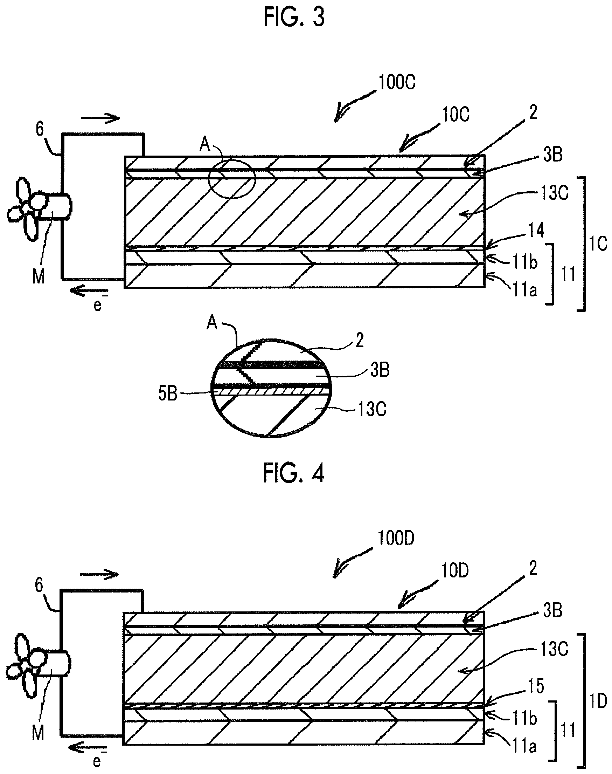

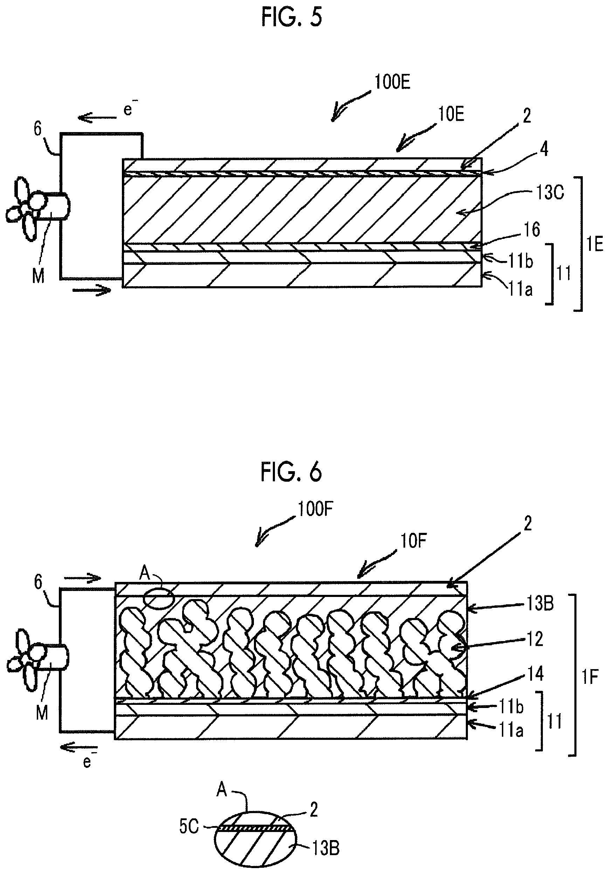

In the present invention, example of the aspect in which the photosensitive layer is provided above the surface of the conductive support through another layer include an aspect in which the photosensitive layer is provided on the surface of a porous layer in a thin film shape or the like (refer to Fig. 1), an aspect in which the photosensitive layer is provided on the surface of a porous layer in a thick film shape (refer to Figs. 2 and 6), an aspect in which the photosensitive layer is provided on the surface of a blocking layer in a thin film shape and an aspect in which the photosensitive layer is provided on the surface of a blocking layer in a thick film shape (refer to Fig. 3), an aspect in which the photosensitive layer is provided on the surface of an electron transportation layer in a thin film shape or a thick film shape (refer to Fig. 4), and an aspect in which the photosensitive layer is provided on the surface of a hole transportation layer in a thin film shape or a thick film shape (refer to Fig. 5). The photosensitive layer may be provided in a linear shape or a dispersed pattern, but is preferably provided in a film shape.

In addition, in the present invention, "the surface of the first electrode" refers to the surface on the second electrode side of a layer forming the surface of the first electrode, for example, the photosensitive layer provided on the first electrode.

In the present invention, "having at least one of the compound on the surface of the first electrode" means that the compound is present on the surface of the first electrode or in the vicinity thereof. An aspect of the compound being present on the surface of the first electrode or in the vicinity thereof may be a case in which the compound is bonded, adhered, fixed, or adsorbed to or supported by the surface of the first electrode due to a chemical bonding or a physical interaction. Examples thereof all include an aspect in which the compound is covalent-bonded, ion-bonded, or coordinate-bonded to the surface of the first electrode and an aspect in which the compound is physically adsorbed to the surface of the first electrode. In the present invention, it does not matter how the compound is present on the surface of the first electrode in actual cases, and the compound simply needs to be present on the surface of the first electrode or in the vicinity thereof. Therefore, the compound or a compound layer may be present in, for example, pores in the porous layer or a part of the structure of a compound forming a compound layer may be implanted in the photosensitive layer.

In the present invention, regardless of the state of the compound being present on the surface of the first electrode, aggregation of the compounds being present on the surface of the first electrode will be referred to as a layer of a compound (compound layer) for convenience.

The compound or the compound layer simply needs to be on the surface of the first electrode and, similar to the photosensitive layer 13, may have a film shape or a linear shape, be in a dispersed state, or be in a mixed state thereof. The compound or the compound layer is preferably provided in a monomolecular film shape. Therefore, the compound layer may not always form a layer or a film that uniformly covers the surface of the first electrode.

The present inventors found that there is no particular limitation regarding layers being provided in contact with the compound layer in terms of improvement in the adhesiveness to the compound layer or the prevention of backward charge migration. Therefore, layers being provided in contact with the compound layer simply need to be any layers constituting the solar cell, and examples thereof include the (solid) hole transportation layer, the electron transportation layer, the second electrode, and the like.

In the photoelectric conversion element of the present invention, the photosensitive layer and the compound layer can be formed in a variety of forms depending on the shapes of layers provided with the photosensitive layer and the compound layer, the amount of the light absorber or the compound being provided, and the like. Therefore, in the present invention, the forms of the photosensitive layer and the compound layer do not matter as described above.

There is no particular limitation regarding constitutions unless particularly specified in the present invention, and well-known constitutions relating to photoelectric conversion elements and solar cells can be employed for the photoelectric conversion element of the present invention. The respective layers constituting the photoelectric conversion element of the present invention are designed according to their purposes and may have a monolayer form or a multilayer form. For example, it is also possible to provide the porous layer between the conductive support and the photosensitive layer (refer to Figs. 1, 2 and 6).

Hereinafter, preferred aspects of the photosensitive conversion element of the present invention will be described.

In Figs. 1 to 6, the same reference symbol indicates the same constituent element (member).

Meanwhile, in Figs. 1, 2, and 6, fine particles forming a porous layer 12 are illustrated in an enlarged manner. These fine particles are preferably jammed with each other (accumulated or in close contact with each other) in the horizontal direction and the vertical direction with respect to a conductive support 11 and thus form a porous structure.

In the present specification, in the case of being simply mentioned, a photoelectric conversion element 10 refers to photoelectric conversion elements 10A to 10F unless particularly otherwise mentioned. This also shall apply to a system 100 and a first electrode 1. In addition, in the case of being simply mentioned, a photosensitive layer 13 or a compound layer 5 refers to photosensitive layers 13A to 13C or compound layers 5A to 5C unless particularly otherwise mentioned. Similarly, in the case of being simply mentioned, a hole transportation layer 3 refers to hole transportation layers 3A and 3B unless particularly otherwise mentioned.

Examples of the preferred aspects of the photoelectric conversion element of the present invention include the photoelectric conversion element 10A illustrated in Fig. 1. A system 100A illustrated in Fig. 1 is a system to which the photoelectric conversion element 10A is applied as a cell that causes action means M (for example, an electric motor) to operate through an external circuit 6.

The photoelectric conversion element 10A includes a first electrode 1A, the compound layer 5A (refer to the enlarged portion in Fig. 1) and a second electrode 2 on the photosensitive layer 13A in the first electrode 1A, and the hole transportation layer 3A between the compound layer 5A and the second electrode 2.

The first electrode 1A includes the conductive support 11 made up of a support 11a and a transparent electrode 11b, the porous layer 12, and the photosensitive layer 13A on the porous layer 12. In addition, a blocking layer 14 is provided on the transparent electrode 11b, and the porous layer 12 is formed on the blocking layer 14. In the photoelectric conversion element 10A including the porous layer 12 as described above, since the surface area of the photosensitive layer 13A increases, it is assumed that the charge separation and charge transfer efficiency improves.

The photoelectric conversion element 10B illustrated in Fig. 2 is a schematic illustration of a preferred aspect in which the photosensitive layer 13A in the photoelectric conversion element 10A illustrated in Fig. 1 is provided to be thick. In Fig. 2, a compound layer in the photoelectric conversion element 10B is the same as the compound layer 5A in the photoelectric conversion element 10A illustrated in Fig. 1, and thus an enlarged view of the compound layer is not illustrated. In this photoelectric conversion element 10B, the hole transportation layer 3B is provided to be thin. The photoelectric conversion element 10B is different from the photoelectric conversion element 10A illustrated in Fig. 1 in terms of the film thicknesses of the photosensitive layer 13B and the hole transportation layer 3B and is constituted in the same manner as the photoelectric conversion element 10A except for the film thicknesses.

The photoelectric conversion element 10C illustrated in Fig. 3 is a schematic illustration of another preferred aspect of the photoelectric conversion element of the present invention (the compound layer 5B is illustrated in the enlarged portion A in Fig. 3). The photoelectric conversion element 10C is different from the photoelectric conversion element 10B illustrated in Fig. 2 in terms of the porous layer 12 being not provided and is constituted in the same manner as the photoelectric conversion element 10B except for the porous layer. That is, in the photoelectric conversion element 10C, the photosensitive layer 13C is formed on the surface of the blocking layer 14 in a thick film shape, and the compound layer 5B is formed on the surface of the photosensitive layer 13C. In the photoelectric conversion element 10C, it is also possible to provide the hole transportation layer 3B to be thick like the hole transportation layer 3A.

The photoelectric conversion element 10D illustrated in Fig. 4 is a schematic illustration of still another preferred aspect of the photoelectric conversion element of the present invention. In Fig. 4, a compound layer in the photoelectric conversion element 10D is the same as the compound layer 5B in the photoelectric conversion element 10C illustrated in Fig. 3, and thus an enlarged view of the compound layer is not illustrated. The photoelectric conversion element 10D is different from the photoelectric conversion element 10C illustrated in Fig. 3 in terms of an electron transportation layer 15 being provided instead of the blocking layer 14 and is constituted in the same manner as the photoelectric conversion element 10C except for the electron transportation layer. A first electrode 1D includes the conductive support 11 and the electron transportation layer 15 and the photosensitive layer 13C which are sequentially formed on the conductive support 11. The photoelectric conversion element 10D is preferred since the respective layers are formed of an organic material. Therefore, the productivity of the photoelectric conversion element improves, and furthermore, it becomes possible to reduce the thickness of the photoelectric conversion element or make the photoelectric conversion element flexible.

The photoelectric conversion element 10E illustrated in Fig. 5 is a schematic illustration of still another preferred aspect of the photoelectric conversion element of the present invention. In Fig. 5, a compound layer in the photoelectric conversion element 10E is the same as the compound layer 5B in the photoelectric conversion element 10C illustrated in Fig. 3 except for the fact that an electron transportation layer 4 is formed on the surface of the compound layer instead of the hole transportation layer 3B, and thus an enlarged view of the compound layer is not illustrated. A system 100E including the photoelectric conversion element 10E is a system to which the photoelectric conversion element is applied as a cell like the system 100A.

The photoelectric conversion element 10E includes a first electrode 1E, the second electrode 2, and an electron transportation layer 4 between the first electrode 1E and the second electrode 2. The first electrode 1E includes the conductive support 11 and a hole transportation layer 16 and the photosensitive layer 13C which are sequentially formed on the conductive support 11. The photoelectric conversion element 10E is preferred since the respective layers are formed of an organic material as in the photoelectric conversion element 10D.

The photoelectric conversion element 10F illustrated in Fig. 6 is a schematic illustration of still another preferred aspect of the photoelectric conversion element of the present invention (the compound layer 5C is illustrated in the enlarged portion A in Fig. 6). The photoelectric conversion element 10F is different from the photoelectric conversion element 10B illustrated in Fig. 2 in terms of the hole transportation layer 3B being not provided and is constituted in the same manner as the photoelectric conversion element 10B except for the hole transportation layer.

In the present invention, the system 100 to which the photoelectric conversion element 10 is applied functions as a solar cell in the following manner.

That is, in the photoelectric conversion element 10, light that has passed through the conductive support 11 or the second electrode 2 and has entered the photosensitive layer 13 excites a light absorber. The excited light absorber has high-energy electrons and is capable of emitting the electrons. The light absorber which has emitted high-energy electrons turns into an oxidant.

In the photoelectric conversion elements 10A to 10D and 10F, electrons emitted from the light absorber migrate in the light absorber and reach the conductive support 11. The electrons which have reached the conductive support 11 do their work in the external circuit 6 and then return to the photosensitive layer 13 through the second electrode 2 (in a case in which the hole transportation layer 3 is provided, through the hole transportation layer 3 as well). The light absorber is reduced by the electrons which had returned to the photosensitive layer 13.

On the other hand, in the photoelectric conversion element 10E, electrons emitted from the light absorber reach the second electrode 2 through the electron transportation layer 4 from the photosensitive layer 13C, do their work in the external circuit 6, and then return to the photosensitive layer 13 through the conductive support 11. The light absorber is reduced by the electrons which had returned to the photosensitive layer 13.

The system 100 functions as a solar cell due to the above-described cycle of the excitement of the light absorber and electron migration being repeated in the photoelectric conversion element 10.

In the photoelectric conversion elements 10A to 10D and 10F, the flow direction of electrons from the photosensitive layer 13 to the conductive support 11 varies depending on the presence or absence, kind, and the like of the porous layer 12. In the photoelectric conversion element 10 of the present invention, electron conduction in which electrons migrate in the light absorber occurs. Therefore, in a case in which the porous layer 12 is provided, the porous layer 12 can be formed of an insulating body other than semiconductors in the related art. In a case in which the porous layer 12 is formed of a semiconductor, electron conduction in which electrons migrate inside or between semiconductor fine particles in the porous layer 12 also occurs. On the other hand, in a case in which the porous layer 12 is formed of an insulating body, electron conduction in the porous layer 12 does not occur. In a case in which the porous layer 12 is formed of an insulating body, when aluminum oxide (Al₂O₃) fine particles are used as insulating body fine particles, a relatively high electromotive force (Voc) is obtained.

In a case in which the blocking layer 14, as other layers, is formed of a conductor or a semiconductor as well, electron conductor occurs in the blocking layer 14.

In addition, electron conduction also occurs in the electron transportation layer 15.

The photoelectric conversion element and the solar cell of the present invention are not limited to the above-described preferred aspects, and the constitutions and the like of the respective aspects can be appropriately combined together within the scope of the gist of the present invention. For example, the photoelectric conversion element 10C or 10D can also be provided with a constitution in which the hole transportation layer 3B is not provided like the photoelectric conversion element 10F.

In the present invention, materials and the respective members which are used in the photoelectric conversion element and the solar cell can be prepared using ordinary methods except for materials and members that are specified in the present invention. Regarding photoelectric conversion elements or solar cells in which a perovskite compound is used as a light absorber, it is possible to refer to, for example, KR10-1172374B, WO2013/171517A, J. Am. Chem. Soc., 2009, 131 (17), pp. 6050 and 6051, and Science, 338, p. 643 (2012). In addition, regarding materials and individual members which are used in dye sensitized solar cells, it is possible to refer to the following documents. For example, for dye sensitized solar cells, it is possible to refer to JP2001-291534A, the specification of US4927721A, the specification of US4684537A, the specification of US5084365A, the specification of US5350644A, the specification of US5463057A, the specification of US5525440A, JP1995-249790A (JP-H7-249790A), JP2004-220974A, and JP2008-135197A.

Hereinafter, main members constituting the solar cell and functions thereof will be roughly described.

### <First electrode 1>

The first electrode 1 includes the conductive support 11 and the photosensitive layer 13 and functions as a working electrode in the photoelectric conversion element 10.

The first electrode 1 preferably includes at least one layer of the porous layer 12, the blocking layer 14, the electron transportation layer 15, and the hole transportation layer 16 as illustrated in Figs. 1 to 6.

The first electrode 1 preferably includes at least the blocking layer 14 in terms of short circuit prevention and more preferably includes the porous layer 12 and the blocking layer 14 in terms of light absorption efficiency and short circuit prevention.

In addition, the first electrode 1 preferably includes the electron transportation layer 15 or the hole transportation layer 16 which is formed of an organic material in terms of improvement of the productivity of the photoelectric conversion element, thickness reduction, or the photoelectric conversion element becoming flexible.

### - Conductive support 11 -

The conductive support 11 is not particularly limited as long as the conductive support is conductive and is capable of supporting the photosensitive layer 13 or the like. The conductive support 11 preferably has a constitution in which the conductive support is formed of a conductive material, for example, metal or a constitution in which the glass or plastic support 11a and the transparent electrode 11b formed on the surface of the support 11a as a conductive film are provided.

Among these, the conductive support 11 in which the transparent electrode 11b is formed by applying a conductive metallic oxide onto the surface of the glass or plastic support 11a as illustrated in Figs. 1 to 6 is more preferred. Examples of the support 11a formed of plastic include transparent polymer films described in Paragraph 0153 of JP2001-291534A. As a material used to form the support 11a, it is possible to use, in addition to glass or plastic, ceramics (JP2005-135902A) or conductive resins (JP2001-160425A). The metallic oxide is preferably tin oxide (TO) and particularly preferably an indium-tin oxide (a tin-doped indium oxide, ITO) or a fluorine-doped tin oxide such as a fluorine-doped tin oxide (FTO). At this time, the amount of the metallic oxide applied is preferably in a range of 0.1 to 100 g per the surface area of the support 11a of square meter. In a case in which the conductive support 11 is used, light preferably enters the conductive support through the support 11a side.

The conductive support 11 is preferably substantially transparent. In the present invention, "being substantially transparent" means that the transmittance of light (having a wavelength in a range of 300 to 1,200 nm) is 10% or higher, preferably 50% or higher, and particularly preferably 80% or higher.

The thicknesses of the support 11a and the conductive support 11 are not particularly limited and are set to appropriate thicknesses. For example, the thicknesses are preferably in a range of 0.01 µm to 10 mm, more preferably in a range of 0.1 µm to 5 mm, and particularly preferably in a range of 0.3 µm to 4 mm.

In a case in which the transparent electrode 11b is provided, the film thickness of the transparent electrode 11b is not particularly limited and is, for example, preferably in a range of 0.01 to 30 µm, more preferably in a range of 0.03 to 25 µm, and particularly preferably in a range of 0.05 to 20 µm.

The conductive support 11 or the support 11a may have a light management function on the surface. For example, the conductive support 11 or the support 11a may have on the surface an antireflection film obtained by alternately laminating high-refractive index films and low-refractive index oxide films which is described in JP2003-123859A or may have a light guide function described in JP2002-260746A.

### - Blocking layer 14 -

In the present invention, as in the photoelectric conversion elements 10A to 10C and 10F, the blocking layer 14 is preferably provided on the surface of the transparent electrode 11b, that is, between the conductive support 11 and the porous layer 12, the photosensitive layer 13, the hole transportation layer 3, or the like.

In the photoelectric conversion element and the solar cell, for example, when the photosensitive layer 13 or the hole transportation layer 3 and the transparent electrode 11b or the like are electrically connected to each other, reverse currents are generated. The blocking layer 14 performs a function of preventing these reverse currents. The blocking layer 14 is also referred to as a short circuit prevention layer.

It is also possible to make the blocking layer 14 function as a scaffold for carrying the light absorber.

The blocking layer 14 may also be provided in a case in which the photoelectric conversion element includes an electron transportation layer. For example, in the case of the photoelectric conversion element 10D, the blocking layer may be provided between the conductive support 11 and the electron transportation layer 15, and in the case of the photoelectric conversion element 10E, the blocking layer may be provided between the second electrode 2 and the electron transportation layer 4.

A material used to form the blocking layer 14 is not particularly limited as long as the material is capable of performing the above-described function, but is preferably a substance transmitting visible light and an insulating substance with respect to the conductive support 11 (the transparent electrode 11b) and the like. The "insulating substance with respect to the conductive support 11 (the transparent electrode 11b)" specifically refers to a compound having an energy level of the conduction band which is equal to or higher than the energy level of the conduction band of a material used to form the conductive support 11 (a metallic oxide used to form the transparent electrode 11b) and is lower than the energy level of the conduction band of a material constituting the porous layer 12 or the ground state of the light absorber (n-type semiconductor compound).

Examples of a material used to form the blocking layer 14 include silicon oxide, magnesium oxide, aluminum oxide, calcium carbonate, cesium carbonate, polyvinyl alcohols, polyurethanes, and the like. In addition, the material may be a material that is ordinarily used as a photoelectric conversion material, and examples thereof include titanium oxide, tin oxide, zinc oxide, niobium oxide, tungsten oxide, and the like. Among these, titanium oxide, tin oxide, magnesium oxide, aluminum oxide, and the like are preferred.

The film thickness of the blocking layer 14 is preferably in a range of 0.001 to 10 µm, more preferably in a range of 0.005 to 1 µm, and particularly preferably in a range of 0.01 to 0.1 µm.

In the present invention, the film thicknesses of the respective layers can be measured by observing cross sections of the photoelectric conversion element 10 using a scanning electron microscope (SEM) or the like.

### - Porous layer 12 -

In the present invention, as in the photoelectric conversion elements 10A, 10B, and 10F, the porous layer 12 is preferably provided on the transparent electrode 11b. In a case in which the photoelectric conversion element includes the blocking layer 14, the porous layer is preferably formed on the blocking layer 14.

The porous layer 12 is a layer that functions as a scaffold for carrying the photosensitive layer 13 on the surface. In solar cells, in order to increase the light absorption efficiency, it is preferable to increase the surface area of at least a portion receiving light such as sunlight, and it is preferable to increase the surface area of the porous layer 12 as a whole.

The porous layer 12 is preferably a fine particle layer having pores which is formed of fine particles of a material used to form the porous layer 12 being accumulated or in close contact with each other. The porous layer 12 may be a fine particle layer formed of two or more kinds of fine particles being accumulated together. When the porous layer 12 is a fine particle layer having pores, it is possible to increase the amount of the light absorber carried (adsorption amount).

In order to increase the surface area of the porous layer 12, it is preferable to increase the surface area of individual fine particles that constitute the porous layer 12. In the present invention, the surface area of fine particles used to form the porous layer 12 in a state in which the fine particles are applied onto the conductive support 11 and the like is preferably 10 or more times and more preferably 100 or more times the projected area. The upper limit thereof is not particularly limited, but is, generally, approximately 5,000 times. Regarding the particle diameters of the fine particles used to form the porous layer 12, the average particle diameter of the diameters of equivalent circles of the projected areas is preferably in a range of 0.001 to 1 µm for the primary particles diameter. In a case in which the porous layer 12 is formed using a dispersion of the fine particles, the average particle diameter of the fine particles is preferably in a range of 0.01 to 100 µm in terms of the average particle diameter in the dispersion.

For the material used to form the porous layer 12, there is no particular limitation regarding conductivity, and thus the material may be an insulating body (insulating material), a conductive material, or a semiconductor (semi-conductive material).

As the material used to form the porous layer 12, it is possible to use, for example, chalcogenides (for example, oxides, sulfides, selenides, and the like) of metal, compounds having a perovskite-type crystal structure (except for perovskite compounds being used as light absorbers), oxides of silicon (for example, silicon dioxide and zeolite), or carbon nanotubes (including carbon nanowires, carbon nanorods, and the like).

The chalcogenides of metal are not particularly limited, and preferred examples thereof include individual oxides of titanium, tin, zinc, tungsten, zirconium, hafnium, strontium, indium, cerium, yttrium, lanthanum, vanadium, niobium, aluminum, or tantalum, cadmium sulfide, cadmium selenide, and the like. Examples of the crystal structure of the chalcogenides of metal include an anatase-type crystal structure, a brookite-type crystal structure, and a rutile-type crystal structure, and an anatase-type crystal structure and a brookite-type crystal structure are preferred.

The compounds having a perovskite-type crystal structure are not particularly limited, and examples thereof include transition metal oxides and the like. Examples thereof include strontium titanate, calcium titanate, barium titanate, lead titanate, barium zirconate, barium stannate, lead zirconate, strontium zirconate, strontium tantalate, potassium niobate, bismuth ferrite, barium strontium titanate, lanthanum barium titanate, calcium titanate, sodium titanate, and bismuth titanate. Among these, strontium titanate, calcium titanate, and the like are preferred.

The carbon nanotubes have a shape obtained by rolling a carbon film (graphene sheet) in a tubular shape. Carbon nanotubes are classified into single-walled carbon nanotubes (SWCNT) obtained by coiling one graphene sheet in a cylindrical shape, double-walled carbon nanotubes (DWCNT) obtained by coiling two graphene sheets in a concentric shape, and multi-walled carbon nanotubes (MWCNT) obtained by coiling multiple graphene sheets in a concentric shape. As the porous layer 12, any carbon nanotubes can be used without any particular limitation.

Among these, the material used to form the porous layer 12 is preferably an oxide of titanium, tin, lead, zirconium, aluminum, or silicon or a carbon nanotube and more preferably titanium oxide or aluminum oxide.

The porous layer 12 may be formed of one or more of the chalcogenide of metal, the compound having a perovskite-type crystal structure, the oxide of silicon, and the carbon nanotube.

The film thickness of the porous layer 12 is not particularly limited and is generally in a range of 0.05 to 100 µm and preferably in a range of 0.1 to 100 µm. In the case of being used as a solar cell, the film thickness is preferably in a range of 0.1 to 50 µm, more preferably in a range of 0.2 to 30 µm, and still more preferably in a range of 0.3 to 30 µm.

### - Electron transportation layer 15 -

In the present invention, as in the photoelectric conversion element 10D, the electron transportation layer 15 is preferably provided on the surface of the transparent electrode 11b.

The electron transportation layer 15 has a function of transporting electrons generated in the photosensitive layer 13 to the conductive support 11. The electron transportation layer 15 is formed of an electron-transporting material capable of exhibiting the above-described function. The electron-transporting material is not particularly limited and is preferably an organic material (organic electron-transporting material). Examples of the organic electron-transporting material include fullerene compounds such as [6,6]-phenyl-C61-butyric acid methyl ester (PC₆₁BM), perylene compounds such as perylene tetracarboxylic diimide (PTCDI), additionally, low-molecular-weight compounds such as tetracyanoquinodimethane (TCNQ), high-molecular-weight compounds, and the like.

The film thickness of the electron transportation layer 15 is not particularly limited and is preferably in a range of 0.001 to 10 µm and more preferably in a range of 0.01 to 1 µm.

### - Hole transportation layer 16 -

In the present invention, as in the photoelectric conversion element 10E, the hole transportation layer 16 is preferably provided on the surface of the transparent electrode 11b.

The hole transportation layer 16 is the same as the hole transportation layer 3 described below except for the location of the hole transportation layer being formed.

### - Photosensitive layer (light-absorbing layer) 13 -

The photosensitive layer 13 is preferably provided on the surfaces (including the surfaces in recesses portions in a case in which surfaces provided with the photosensitive layer 13 are uneven) of the respective layers of the porous layer 12 (in the photoelectric conversion elements 10A, 10B, and 10F), the blocking layer 14 (in the photoelectric conversion element 10C), the electron transportation layer 15 (in the photoelectric conversion element 10D), and the hole transportation layer 16 (in the photoelectric conversion element 10E).

In the present invention, the light absorber needs to contain at least one perovskite compound specified below and may contain two or more perovskite compounds. In addition, the light absorber may contain a light absorber other than the perovskite compound together with the perovskite compound. Examples of the light absorber other than the perovskite compound include metallic complex coloring agents and organic coloring agents. At this time, the ratio between the perovskite compound and the light absorber other than the perovskite compound is not particularly limited.

The photosensitive layer 13 may be a single layer or a laminate of two or more layers. In a case in which the photosensitive layer 13 is a laminate structure of two or more layers, the laminate structure may be a laminate structure formed by laminating layers made of mutually different light absorbers or a laminate structure having an interlayer including a hole-transporting material between the photosensitive layer and the photosensitive layer.

An aspect of the photosensitive layer 13 being present on the conductive support 11 is as described above. The photosensitive layer 13 is preferably provided on the surface of each of the conductive support and the second electrode so that excited electrons flow into the conductive support 11 or the second electrode 2. At this time, the photosensitive layer 13 may be provided on the entire surface or on a part of the surface of the conductive support and the second electrode.

The photosensitive layer 13 includes a compound represented by any formula of Formulae (3) to (5) on the surface. An aspect of this compound being present on the surface is as described above.

The film thickness of the photosensitive layer 13 is appropriately set according to aspects of the photosensitive layer 13 provided on the conductive support 11 and is not particularly limited. The film thickness of the photosensitive layer is, for example, preferably in a range of 0.001 to 100 µm, more preferably in a range of 0.01 to 10 µm, and particularly preferably in a range of 0.01 to 5 µm.

In a case in which the porous layer 12 is provided, the total film thickness including the film thickness of the porous layer 12 is preferably 0.01 µm or more, more preferably 0.05 µm or more, still more preferably 0.1 µm or more, and particularly preferably 0.3 µm or more. In addition, the total film thickness is preferably 100 µm or less, more preferably 50 µm or less, and still more preferably 30 µm or less. The total film thickness can be set in a range obtained by appropriately combining the above-described values. Here, in a case in which the photosensitive layer 13 has a thin film shape as illustrated in Fig. 1, the film thickness of the photosensitive layer 13 refers to the distance between the interface with the porous layer 12 and the interface with the hole transportation layer 3 described below in a direction perpendicular to the surface of the porous layer 12.

In the photoelectric conversion element 10, the total film thickness of the porous layer 12, the photosensitive layer 13, the compound layer 5, and the hole transportation layer 3 is not particularly limited, but is, for example, preferably 0.01 µm or more, more preferably 0.05 µm or more, still more preferably 0.1 µm or more, and particularly preferably 0.5 µm or more. In addition, the total film thickness is preferably 200 µm or less, more preferably 50 µm or less, still more preferably 30 µm or less, and particularly preferably 5 µm or less. The total film thickness can be set in a range obtained by appropriately combining the above-described values.

In the present invention, in a case in which the photosensitive layer is provided in a thick film shape (the photosensitive layers 13B and 13C), the light absorber included in the photosensitive layer also functions as a hole-transporting material.

The amount of the perovskite compound used needs to be an amount at which at least a part of the surface of the first electrode 1 can be covered and is preferably an amount at which the entire surface can be covered.

### [Light absorber in photosensitive layer]

The photosensitive layer 13 contains as a light absorber at least one perovskite compound (also referred to as the perovskite-type light absorber) having a cationic organic group A", "a metallic atom M", and "an anionic atom or atomic group X".

The cationic organic group A, the metallic atom M, and the anionic atom or atomic group X in the perovskite compound are present as individual constituent ions of the cation (for convenience, in some cases, referred to as the cation A), the metallic cation (for convenience, in some cases, referred to as the cation M), and an anion (for convenience, in some cases, referred to as the anion X) respectively in the perovskite-type crystal structure.

In the present invention, the cationic organic group refers to an organic group having a property of becoming cationic in the perovskite-type crystal structure, and the anionic atom or atomic group refers to an atom or atomic group having a property of becoming anionic in the perovskite-type crystal structure.

In the perovskite compound that is used in the present invention, the cation A is a cationic organic group A.

The organic cation is represented by Formula (1) below.

Formula (1): R^{1a}-NH₃

In the formula, R^{1a} represents a substituent. R^{1a} is not particularly limited as long as R^{1a} is an organic group, but is preferably an alkyl group, a cycloalkyl group, an alkenyl group, an alkynyl group, an aryl group, a heteroaryl group, or a group that can be represented by Formula (2) below. Among these, an alkyl group and a group that can be represented by Formula (2) below are more preferred.

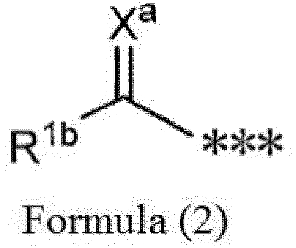

In the formula, X^{a} represents NR^{1c}, an oxygen atom, or a sulfur atom. R^{1b} and R^{1c} each independently represent a hydrogen atom or a substituent. *** represents a bonding location to the nitrogen atom in Formula (1).

In the present invention, the organic cation made of the cationic organic group A is preferably an organic ammonium cation (R^{1a}-NH₃⁺) made of an ammonium cationic organic group A which is formed by R^{1a} and NH₃ in Formula (1) which are bonded together. In a case in which this organic ammonium cation has a resonant structure, the organic cation includes a cation having a resonant structure in addition to the organic ammonium cation. For example, in a case in which X^{a} is NH (R^{1c} represents a hydrogen atom) in a group represented by Formula (2), the organic cation includes an organic amidinium cation which is one of the resonant structures of the organic ammonium cation in addition to an organic ammonium cation of an ammonium cationic organic group formed of the group that can be represented by Formula (2) and NH₃ which are bonded to each other. Examples of the organic amidinium cation made of an amidinium cationic organic group include cations represented by Formula (A^{am}) below. In the present specification, the cations represented by Formula (A^{am}) below will be expressed as "R^{1b}C(=NH)-NH₃" in some cases for convenience.

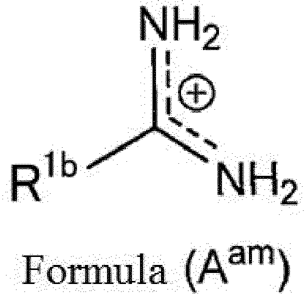

The alkyl is preferably an alkyl group having 1 to 18 carbon atoms, more preferably an alkyl group having 1 to 6 carbon atoms, and still more preferably an alkyl group having 1 to 3 carbon atoms. Examples thereof include methyl, ethyl, propyl, isopropyl, butyl, tert-butyl, pentyl, hexyl, decyl, and the like.

The cycloalkyl group is preferably a cycloalkyl group having 3 to 8 carbon atoms, and examples thereof include cyclopropyl, cyclopentyl, cyclohexyl, and the like.

The alkenyl group is preferably an alkenyl group having 2 to 18 carbon atoms and more preferably an alkenyl group having 2 to 6 carbon atoms. Examples thereof include vinyl, allyl, butenyl, hexenyl, and the like.

The alkynyl group is preferably an alkynyl group having 2 to 18 carbon atoms and more preferably an alkynyl group having 2 to 4 carbon atoms. Examples thereof include ethynyl, butynyl, hexynyl, and the like.

The aryl group is preferably an aryl group having 6 to 14 carbon atoms and more preferably an aryl group having 6 to 12 carbon atoms, and examples thereof include phenyl.

Examples of the heteroaryl group include groups made of an aromatic hetero ring alone and groups made of a fused hetero ring obtained by fusing a ring other than the aromatic hetero ring, for example, an aromatic ring, an aliphatic ring, or a hetero ring with the aromatic hetero ring.

A ring-constituting hetero atom constituting the aromatic hetero ring is, for example, preferably a nitrogen atom, an oxygen atom, or a sulfur atom. In addition, the number of ring members of the aromatic hetero ring is preferably in a range of 3 to 8 and more preferably 5 or 6.

Examples of a five-membered aromatic hetero ring and a fused hetero ring including the five-membered aromatic hetero ring include individual ring groups of a pyrole ring, an imidazole ring, a pyrazole ring, a thiazole ring, a triazole ring, a furan ring, a thiophene ring, a benzimidazole ring, a benzoxazole ring, a benzothiazole ring, an indoline ring, and an indazole ring. In addition, examples of a six-membered aromatic hetero ring and a fused hetero ring including the six-membered aromatic hetero ring include individual ring groups of a pyridine ring, a pyrimidine ring, a triazine ring, a quinoline ring, and a quinazoline ring.

In the group that can be represented by Formula (2), X^{a} represents NR^{1c}, an oxygen atom, or a sulfur atom and is preferably NR^{1c}. Here, R^{1c} represents a hydrogen atom or a substituent and is preferably a hydrogen atom, an alkyl group, a cycloalkyl group, an alkenyl group, an alkynyl group, an aryl group, or a heteroaryl group and more preferably a hydrogen atom.

R^{1b} represents a hydrogen atom or a substituent and is preferably a hydrogen atom. Examples of a substituent that can be employed by R^{1b} include a hydrogen atom, an alkyl group, a cycloalkyl group, an alkenyl group, an alkynyl group, an aryl group, a heteroaryl group, and an amino group.

An alkyl group, a cycloalkyl group, an alkenyl group, an alkynyl group, an aryl group, and a heteroaryl group that can be respectively employed by R^{1b} and R^{1c} are identical to the respective groups of R^{1a}, and preferred groups are also identical thereto.

Examples of the group that can be represented by Formula (2) include a (thio)acyl group, a (thio)carbamoyl group, an imidoyl group, and an amidino group.

Examples of the (thio)acyl group include an acyl group and a thioacryl group. The acyl group is preferably an acyl group having 1 to 7 carbon atoms in total, and examples thereof include formyl, acetyl (r-34), propionyl, hexanoyl, and the like. The thioacyl group is preferably a thioacryl group having 1 to 7 carbon atoms in total, and examples thereof include thioformyl, thioacetyl (r-36), thiopropionyl, and the like.

Examples of the (thio)carbamoyl group include a carbamoyl group (r-35) and a thiocarbamoyl group (H₂NC(=S)-).

The imidoyl group is a group represented by R^{1b}-C(=NR^{1c})-, and R^{1b} and R^{1c} are each preferably a hydrogen atom or an alkyl group, and the alkyl group is more preferably identical to the alkyl group as R^{1a}. Examples thereof include formimidoyl (r-37), acetoimidoyl (r-39), propionimidoyl (CH₃CH₂C(=NH)-), and the like. Among these, formimidoyl is preferred.

The amidino group as the group that can be represented by Formula (2) has a structure (r-38) in which R^{1b} in the imidoyl group is an amino group and R^{1c} is a hydrogen atom.

The alkyl group, the cycloalkyl group, the alkenyl group, the alkynyl group, the aryl group, the heteroaryl group, and the group that can be represented by Formula (2) which can be employed by R^{1a} may all have a substituent. Substituents W^{P} that R^{1a} may have are not particularly limited, and examples thereof include an alkyl group, a cycloalkyl group, an alkenyl group, an alkynyl group, an aryl group, a heterocyclic group, an alkoxy group, an alkylthio group, an amino group, an alkyl amino group, an aryl amino group, an acyl group, an alkyl carbonyloxy group, an aryloxy group, an alkoxycarbonyl group, an aryloxy carbonyl group, an acyl amino group, a sulfone amide group, a carbamoyl group, a sulfamoyl group, a halogen atom, a cyano group, a hydroxy group, a mercapto group, and a carboxy group. The respective substituents that R^{1a} may have may be further substituted with another substituent.

Hereinafter, r-1 to r-39 will be illustrated as the specific examples of R^{1a} in Formula (1), but the present invention is not limited thereto. In the following specific examples, "*" represents a bonding portion to a nitrogen atom, "Me" represents a methyl group, and "Et" represents an ethyl group.

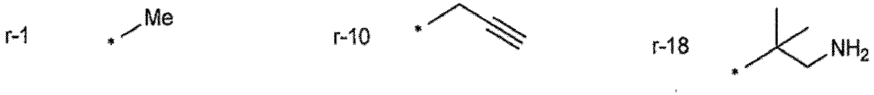

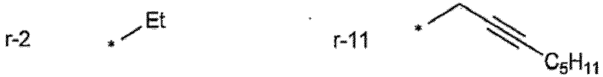

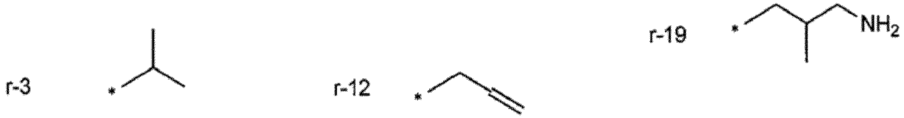

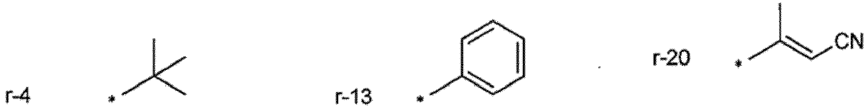

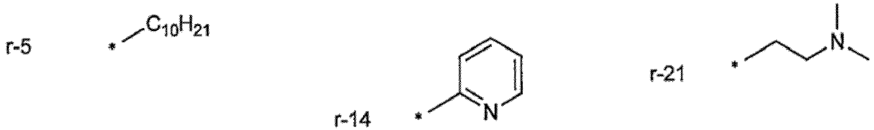

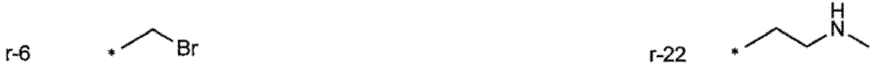

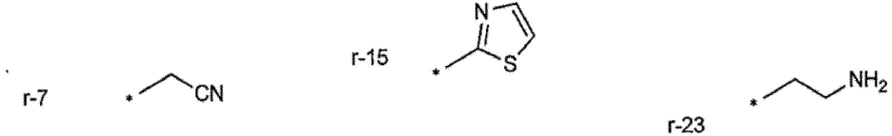

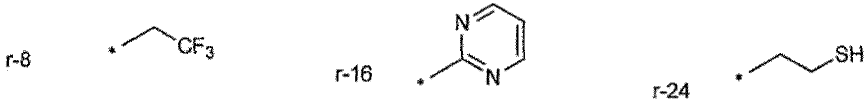

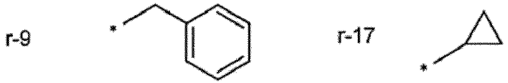

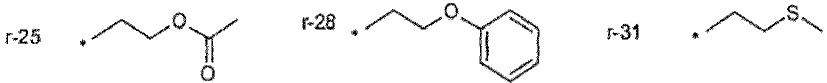

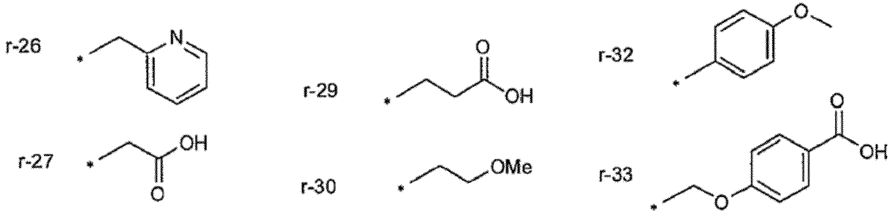

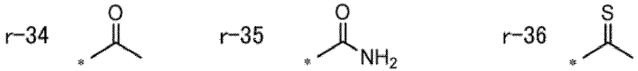

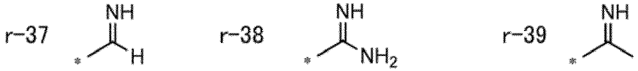

In the perovskite compound that is used in the present invention, the metallic cation M is tin (Sn) or lead (Pb). M may be one kind of metallic atom or two kinds of metallic atoms. In a case in which M is two kinds of metallic atoms, M is Sn and Pb. The ratio between the metallic atoms at this time is not particularly limited.

In the perovskite compound that is used in the present invention, the anion X represents an anion that is an anionic atom or atomic group. Preferred examples of the anion include anions of halogen atoms and anions of individual atomic groups such as NCS⁻, NCO⁻, CH₃COO⁻, and HCOO⁻. Among these, anions of halogen atoms are more preferred. Examples of the halogen atoms include a fluorine atom, a chlorine atom, a bromine atom, an iodine atom, and the like.

The anion X may be an anion of one kind of anionic atom or atomic group or an anion of two or more kinds of anionic atoms or atomic groups. In a case in which the anion is an anion of one kind of anionic atom or atomic group, an anion of an iodine atom is preferred. Meanwhile, in a case in which the anion is an anion of two or more kinds of anionic anions or atomic groups, anions of two or more kinds of halogen atoms, particularly, an anion of a chlorine atom and an anion of an iodine atom are preferred. The ratio of two or more kinds of anions is not particularly limited.

The perovskite compound that is used in the present invention is a perovskite compound which has the perovskite-type crystal structure including the respective constituent ions described above and is represented by Formula (I) below.

Formula (I): AₐMₘXₓ

Subject to the appended claims, in the formula, A represents a cationic organic group, M represents a metallic atom, and X represents an anionic atom or atomic group.
a represents 1 or 2, m represents 1, and a, m, and x satisfy a+2m=x.

In Formula (I), the cationic organic group A forms the cation A in the perovskite-type crystal structure. Therefore, the cationic organic group A is not particularly limited as long as the cationic organic group A is a group which turns into the cation A and is capable of constituting the perovskite-type crystal structure. The cationic organic group A is identical to the cationic organic group described in the section of the cation A, and preferred elements or cationic organic groups are also identical thereto.

The metallic atom M is a metallic atom forming the metallic cation M in the perovskite-type crystal structure. The metallic atom M is identical to the metallic atom described in the section of the metallic cation M.

The anionic atom or atomic group X forms the anion X in the perovskite-type crystal structure. Therefore, the anionic atom or atomic group X is not particularly limited as long as the anionic atom or atomic group X is an atom or atomic group which turns into the anion X and is capable of constituting the perovskite-type crystal structure. The anionic atom or atomic group X is identical to the anionic atom or atomic group described in the section of the anion X, and preferred atoms or groups are also identical thereto.

The perovskite compound represented by Formula (I) is a perovskite compound represented by Formula (I-1) below in a case in which a is 1 and a perovskite compound represented by Formula (1-2) below in a case in which a is 2.

Formula (I-1): AMX₃

Formula (1-2): A₂MX₄

In Formulae (I-1) and (I-2), A represents a cationic organic group and is identical to A in Formula (I), and a preferred group is also identical thereto.

M represents a metallic atom and is identical to M in Formula (I), and a preferred atom is also identical thereto.

X represents an anionic atom or atomic group and is identical to X in Formula (I), and a preferred atom or atomic group is also identical thereto.

The perovskite compound that is used in the present invention may be any one of the compound represented by Formula (I-1) and the compound represented by Formula (I-2) or may be a mixture thereof. Therefore, in the present invention, at least one kind of the perovskite compound needs to be present as the light absorber, and it is not necessary to clearly differentiate which compound is used using the compositional formula, the molecular formula, the crystal structure, and the like.

Hereinafter, specific examples of perovskite compounds that can be used in the present invention will be exemplified, but the present invention is not limited by these specific examples. In the following description, compounds represented by Formula (I-1) and compounds represented by Formula (I-2) will be separately described. However, there are cases in which, depending on synthesis conditions and the like, compound exemplified as the compounds represented by Formula (I-1) turn into the compounds represented by Formula (1-2) or a mixture of the compound represented by Formula (I-1) and the compound represented by Formula (I-2). Similarly, there are cases in which compound exemplified as the compounds represented by Formula (I-2) turn into the compounds represented by Formula (I-1) or a mixture of the compound represented by Formula (I-1) and the compound represented by Formula (1-2).

Specific examples of the compounds represented by Formula (I-1) include CH₃NH₃PbCl₃, CH₃NH₃PbBr₃, CH₃NH₃PbI₃, CH₃NH₃PbBrI₂, CH₃NH₃PbBr₂I, CH₃NH₃SnBr₃, CH₃NH₃SnI₃, and CH (= NH) NH₃PbI₃.

Specific examples of the compounds represented by Formula (I-2) include (C₂H₅NH₃)₂Pbl₄, (CH₂=CHNH₃)₂PbI₄, (CH≡CNH₃)₂PbI₄, (n-C₃H₇NH₃)₂PbI₄, (n-C₄H₉NH₃)₂PbI₄, (C₁₀H₂₁NH₃)₂PbI₄, (C₆H₅NH₃)₂PbI₄, (C₆H₅CH₂CH₂NH₃)₂PbI₄, (C₆H₃F₂NH₃)₂PbI₄, (C₆F₅NH₃)₂PbI₄, and (C₄H₃SNH₃)₂PbI₄. Here, C₄H₃SNH₃ in (C₄H₃SNH₃)₂PbI₄ is aminothiophene.

The perovskite compound can be synthesized from a compound represented by Formula (II) below and a compound represented by Formula (III) below.

Formula (II): AX

Formula (III): MX₂

In Formula (II), A represents a cationic organic group and is identical to A in Formula (I), and preferred elements or cationic organic groups are also identical thereto. In Formula (II), X represents an anionic atom or atomic group and is identical to X in Formula (I), and preferred anionic atoms or atomic groups are also identical thereto.

In Formula (III), M represents a metallic atom and is identical to M in Formula (I), and preferred metallic atoms are also identical thereto. In Formula (III), X represents an anionic atom or atomic group and is identical to X in Formula (I), and preferred anionic atoms or atomic groups are also identical thereto.

Examples of a method for synthesizing the perovskite compound include methods described in KR10-1172374B and WO2013/171517A. In addition, examples thereof also include methods described in Akihiro Kojima, Kenjiro Teshima, Yasuo Shirai, and Tsutomu Miyasaka, "Organometal Halide Perovskites as Visible-Light Sensitizers for Photovoltaic Cells", J. Am. Chem. Soc., 2009, 131 (17), pp. 6050 and 6051.

The amount of the light absorber used needs to be an amount at which at least a part of the surface of the first electrode 1 can be covered with the light absorber and is preferably an amount at which the entire surface can be covered with the light absorber.

In the photosensitive layer 13, the content of the perovskite compound is generally in a range of 1% to 100% by mass.

### <Compound layer 5>

In the present invention, the compound represented by any formula of Formulae (3) to (5) is present on the surface of the first electrode. The aspect and state of the compound being present on the surface of the first electrode are as described above. In the photoelectric conversion element of the present invention, preferably, the hole transportation layer 3, the electron transportation layer 4, or the second electrode 2 is provided on the first electrode 1. In this case, the compound layer 5 is interposed between the surface of the first electrode 1 and the layer provided on the first electrode 1.

The compound may be present on the surface of the first electrode. Whether or not the compound is present on the surface of the first electrode can be confirmed in the following manner. That is, the surface of the first electrode having a sufficient area is washed with an organic solvent capable of dissolving the compound or water. Liquid obtained by filtering the obtained cleaning liquid is condensed and purified as necessary and is analyzed by means of gel permeation chromatography (GPC), high-speed high-performance liquid chromatography (HPLC), or individual nuclear magnetic resonance (NMR) spectroscopies. In this manner, the presence or absence of the compound on the surface of the first electrode can be confirmed, and the abundance thereof can be determined.

The abundance of the compound present on the surface is not particularly limited as long as the effects of the present invention are exhibited. The abundance of the compound on the first electrode can be changed depending on the concentration of liquid including the compound, the area of a surface which the compound is brought into contact with, and the like. The abundance of the compound cannot be specified to a certain value, but is, for example, 0.1 mg/m² to 100 g/m² or, furthermore, 1 mg/m² to 1 g/m².

In the present invention, the compound preferably uniformly covers the surface of the first electrode and is present so that compound molecules do not superimpose each other (is present in a monomolecular film shape) in terms of improvement of photoelectric conversion characteristics, realization of the stability of cell performance, and the like.

The presence aspect of the compound and the abundance of the compound are realized by bringing liquid including the compound into contact with the surface of the first electrode and, preferably, bringing the liquid into contact with the entire surface of the first electrode.

The reason for the capability of decreasing the change in the photoelectric conversion efficiency when the compound represented by any formula of Formulae (3) to (5) is used on the surface of the first electrode is not yet clear, but is assumed as described below.

The compatibility or interaction between the layer constituting the surface of the first electrode, generally, the photosensitive layer (perovskite compound) and the layer provided thereon (referred to as the upper layer), for example, the solid hole transportation layer, the electron transportation layer, or the second electrode is considered to be weak. Therefore, it is difficult for the adhesion stability in the interface between the surface of the first electrode and the upper layer to become constant. As a result, in a case in which the upper layer is made of a hole transportation layer, this fact is considered to suppress electron migration from the hole transportation layer and, depending on cases, induce backward electron migration. In addition, in a case in which the upper layer is the electron transportation layer, this fact is considered to suppress hole migration from the electron transportation layer and, depending on cases, induce backward hole migration. Furthermore, in a case in which the upper layer is an electrode, this fact is considered to suppress electron migration from the electrode.

However, when the compound represented by any formula of Formulae (3) to (5) is interposed between both layers, the perovskite compound and the upper layer are chemically or physically bonded to each other, and the compatibility, interaction, or the like between the surface of the first electrode and the upper layer increases. Therefore, it is considered that adhesiveness therebetween increases and is stabilized and electron rapidly migrate in a regular direction.

In addition, in a case in which the compound represented by any formula of Formulae (3) to (5) has a bulky branched group or a hydrophobic group such as a halogen, the above-described effects are considered to further improve, which is preferable. Furthermore, in a case in which the compound represented by any formula of Formulae (3) to (5) has a hetero ring or an aromatic ring as a partial structure, it is considered that this ring exhibits an effect of not hindering electron transportation essentially required on the surface of the first electrode (the interface between the first electrode and the upper layer) while suppressing backward electron migration.

The compound layer needs to include at least one of the following compounds and may include multiple kinds of the compounds.

Hereinafter, the compound represented by any formula of Formulae (3) to (5) will be described.

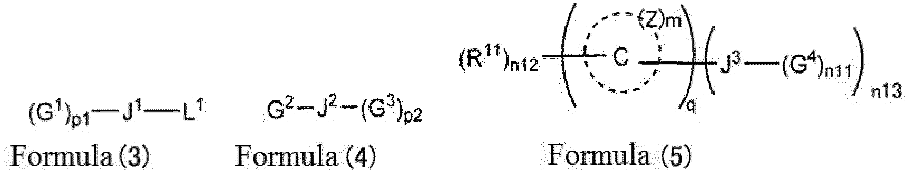

The compound represented by Formula (3) will be described.

G¹ represents a group or a salt selected from the group consisting of -OR^{a}, -O⁻Ya⁺, -SR^{a}, -S⁻Ya⁺, -NR^{a}R^{b}, and -(NR^{a}R^{b}R^{c})⁺ Ya⁻.

Here, R^{a}, R^{b}, and R^{c} each independently represent a hydrogen atom or a substituent. In a case in which R^{a}, R^{b}, and R^{c} represent a substituent, the substituent is not particularly limited, and examples thereof include the substituents W^{P}. The substituent is preferably an alkyl group having 1 or 2 carbon atoms. All of R^{a}, R^{b}, and R^{c} particularly preferably represent a hydrogen atom.

A counter salt Ya is not particularly limited, and examples thereof include a variety of cations or anions. Examples of the cations include a lithium ion (Li⁺), a cesium ion (Cs⁺), a sodium ion (Na⁺), a potassium ion (K⁺), a silver ion (Ag⁺), a copper ion (Cu⁺), an ammonium ion (NR^{d}₄⁺), a phosphonium ion (PR^{d}₄⁺), and the like. R^{d} represents a hydrogen atom or a substituent. Examples of the substituent include the substituents W^{P}. Examples of the anions include halide ions (a fluoride ion (F⁻), an iodide ion (I⁻), a bromide ion (Br⁻), a chloride ion (Cl⁻), and the like), O²⁻, and the like. Among these, halide ions are preferred, and an iodide ion (I⁻) is more preferred.

From the viewpoint of substitution feasibility into the perovskite-type crystal structure, G¹ is preferably -OR^{a}, -O⁻Ya⁺, -NR^{a}R^{b}, or -(NR^{a}R^{b}R^{c})⁺ Ya⁻, more preferably -NR^{a}R^{b} or -(NR^{a}R^{b}R^{c})⁺ Ya⁻, still more preferably -(NR^{a}R^{b}R^{c})⁺ Ya⁻, and particularly preferably -NH₃⁺I⁻.

L¹ represents an alkyl group, a cycloalkyl group, a cycloalkenyl group, or a cycloalkadiene group. Among these, an alkyl group or a cycloalkyl group is preferred.

The alkyl group is preferably an alkyl group having 1 to 30 carbon atoms and more preferably an alkyl group having 1 to 10 carbon atoms. In addition, the alkyl group may be a linear chain or a branched chain, but is preferably a branched chain in terms of the compatibility between the photosensitive layer and the upper layer and suppression of backward charge migration. Examples of the linear alkyl group include methyl, ethyl, propyl, butyl, pentyl, hexyl, decyl, octadecy, and the like.

The branched alkyl group is preferably an alkyl group having 3 to 30 carbon atoms and more preferably 3 to 10 carbon atoms, and examples thereof include i-propyl, i-butyl, t-butyl, 3-ethylpentyl, and the like.

The alkyl group may have a substituent. Examples of the substituent include substituents which do not satisfy the G¹ specification out of the above-described substituents W^{P}. Preferred examples thereof include halogen atoms (a fluorine atom, a chlorine atom, and a bromine atom), and a fluorine atom is more preferred in terms of the compatibility between the photosensitive layer and the upper layer and suppression of backward charge migration. The number of hydrogen atoms in an alkyl group substituted with a fluorine atom is not particularly limited, and all hydrogen atoms may be substituted. Examples of an alkyl group substituted with a fluorine atom (referred to as alkyl fluoride group) include perfluoroalkyl groups obtained by substituting all hydrogen atoms in the alkyl group exemplified above, fluoroalkyl groups obtained by substituting part of hydrogen atoms (for example, monofluoromethyl(-CH₂F), difluoromethyl (-CHF₂), 4,4,5,5,6,6,6-heptafluoro hexyl (-(CH₂)₃(CF₂)₂CF₃), 3,3,4,4,5,5,6,6,6-nonafluorohexyl (-(CH₂)₂(CF₂)₃CF₃), and the like.

The cycloalkyl group is preferably a cycloalkyl group having 3 to 8 carbon atoms, and examples thereof include cyclopropyl, cyclobutyl, cyclopentyl, cyclohexyl, cyclobutyl, cyclooctyl, and the like.

The cycloalkyl group may have a substituent. Examples of the substituent include substituents which do not satisfy the G¹ specification out of the above-described substituents W^{P} and an oxo group (=O), preferred examples thereof include an alkyl group, an oxy group, and the like. The number of substituents in the cycloalkyl group is not particularly limited and is, for example, preferably 1 to 3 and more preferably 1.

The cycloalkyl group having an oxy group as the substituent is a group obtained by removing one hydrogen atom from a cycloalkanone compound. The cycloalkyl group having an oxo group as the substituent is not particularly limited, and examples thereof include groups obtained by removing one hydrogen atom from a cycloalkanone compound such as cyclopropanone, cyclobutanone, cyclopentanone, cyclohexanone, cycloheptanone, or cyclooctanone.

The cycloalkenyl group is preferably a cycloalkenyl group having 3 to 8 carbon atoms, and examples thereof include cyclopropenyl, cyclobutenyl, cyclopentenyl, cyclohexenyl, cycloheptenyl, cyclooctenyl, and the like.

The cycloalkadiene group is a cyclic alkenyl group having two unsaturated bonds (alkenyl groups) in a cyclic structure and is preferably a cycloalkadiene group having 4 to 8 carbon atoms. Examples thereof include cyclobutadiene, cyclopentadiene, cyclohexadiene, cycloheptadiene, cyclooctadiene, and the like.

J¹ is a single bond or a linking group, and, in a case in which J¹ is a linking group, J¹ is preferably at least one linking group selected from the group consisting of linking groups represented by Formulae J-1 to J-8 described below. Here, at least one linking group selected from the group consisting of linking groups represented by Formulae J-1 to J-8 refer not only to a linking group represented by any one formula of Formulae J-1 to J-8 but also to a linking group formed of a combination of at least two linking groups selected from the group consisting of linking groups represented by Formulae J-1 to J-8 below. J¹ is preferably a single bond or a linking group represented by Formula J-7 or J-8 described below and more preferably a single bond or a linking group represented by Formula J-7.

p1 is an integer of 1 or higher, preferably an integer of 1 or higher and 4 or lower, and more preferably 1.

The compound represented by Formula (3) is preferably a compound represented by Formula (6) below.

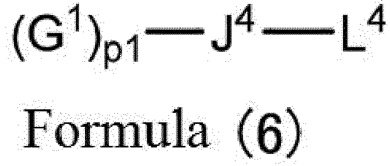

G¹ and p1 are identical to G¹ and p1 in Formula (3).

L⁴ represents a branched alkyl group or an alkyl group or cycloalkyl group having a halogen atom. The branched alkyl group and the cycloalkyl group are respectively identical to the branched alkyl group and the cycloalkyl group described in the section of L¹ described above, and preferred groups are also identical thereto. Examples of the alkyl group having a halogen atom include alkyl groups in which part or all of hydrogen atoms in the alkyl group described in the section of L¹ described above are substituted with halogen atoms, and the alkyl fluoride group is preferred.

J⁴ represents a single bond or a linking group represented by Formula J-7 below.

The linking groups of the compounds J¹ to J⁶ represented by Formulae (3) to (8) will be described below, and preferred examples of the linking groups in the respective formulae will be described together with the description of compounds represented by the following formulae.

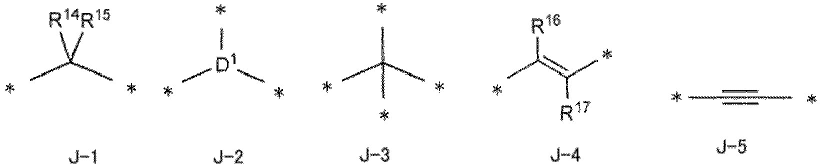

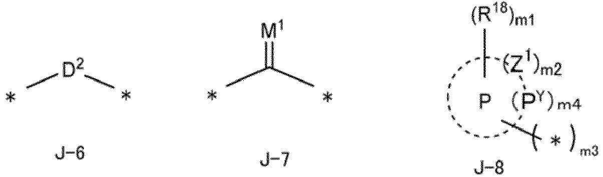

In the formulae, represents a linking portion to G¹, G², G³, G⁴, L¹, or the ring C or a linking portion to other linking groups represented by any formula of Formulae J-1 to J-8.

D¹ represents a nitrogen atom, N⁺R¹⁹, or CR²⁰.

D² represents an oxygen atom, a sulfur atom, or NR²¹, and NR²¹ is preferred.

M¹ represents an oxygen atom, a sulfur atom, or NR²², and an oxygen atom or NR²² is preferred.

Z¹ represents a hetero atom or NR¹³. Examples of the hetero atom include a nitrogen atom, an oxygen atom, and a sulfur atom, and a sulfur atom is preferred.

P^{Y} is a group having ">C=" in P^{Y} as a ring-constituting atom of the ring P, two single bonds of this carbon atom are respectively bonded to the ring-constituting atom of the ring P, and thus the carbon atom is implanted in the ring P. P^{Y} specifically represents >C=CR^{Y1}R^{Y2}, >C=S, or >C=O and is preferably >C=O.

The ring P represents an aliphatic hydrocarbon ring made of a carbon atom group necessary to constitute a ring or an aliphatic hetero ring made up of a carbon atom group necessary to constitute a ring and Z¹. The aliphatic hydrocarbon ring is preferably a 3- to 8-membered ring and more preferably a 5- or 6-membered ring, examples thereof include a cyclopentane ring, a cyclohexane ring, a cyclohexene ring, a cyclohexadiene ring, and a cyclooctane ring, and a cyclohexane ring is preferred. The aliphatic hetero ring is preferably a 5- to 8-membered ring, and examples thereof include pyrrolidine, oxolane, thiolane, piperidine, dioxane, thian, piperazine, morpholine, quinuclidine, azetidine, oxetane, aziridine, dioxane, pentamethylene sulfide, and the like.

R¹⁴ to R¹⁷, R¹⁹, and R²⁰ each independently represent a hydrogen atom or a substituent. R¹⁸, R^{Y1}, and R^{Y2} represent a substituent. Examples of the substituent represented by R¹⁴ to R¹⁷, R¹⁹, and R²⁰ and the substituent as R¹⁸, R^{Y1}, and R^{Y2} include the substituents W^{P}. Among these, an alkyl group and a halogen atom are preferred, and a halogen atom is more preferred. The alkyl group is preferably a substituted or unsubstituted linear or branched alkyl group having 1 to 30 carbon atoms. In a case in which the alkyl group has a substituent, the substituent is not particularly limited, but is preferably the substituent W^{P} and more preferably a halogen atom (a fluorine atom, a chlorine atom, a bromine atom, or the like). Examples of the alkyl group include methyl, ethyl, propyl, butyl, pentyl, hexyl, heptyl, octyl, decyl, and octadecyl. R¹⁴ to R¹⁷, R¹⁹, and R²⁰ each more preferably independently represent a halogen atom or a hydrogen atom.

R^{Y1} and R^{Y2} may be bonded to each other and thus form a ring. Rings formed by R^{Y1} and R^{Y2} are not particularly limited and may be the same ring as the ring P.

R¹³, R²¹, and R²² each independently represent a hydrogen atom or a substituent. In a case in which R¹³, R²¹, and R²² represent a substituent, examples of the substituent include the substituents W^{P}. Among these, an alkyl group is preferred. The alkyl group is preferably a substituted or unsubstituted linear or branched alkyl group having 1 to 30 carbon atoms. In a case in which the alkyl group has a substituent, the substituent is not particularly limited, but is preferably the substituent W^{P} and more preferably a halogen atom (a fluorine atom, a chlorine atom, a bromine atom, or the like). Examples of the alkyl group include methyl, ethyl, propyl, butyl, pentyl, hexyl, heptyl, octyl, decyl, and octadecyl. R¹³, R²¹, and R²² are each more preferably independently an alkyl group or a hydrogen atom and particularly preferably a hydrogen atom.

m1 represents an integer of 0 or higher and is preferably an integer of 0 to 5 and more preferably 0 or 1.

m2 represents an integer of 0 or higher and is preferably an integer of 0 to 3, more preferably 0 or 1, and still more preferably 0.

m3 represents an integer of 2 or higher and is preferably 2.

m4 represents an integer of 0 or higher and, in some cases, is an integer of 1 or higher depending on the presence or absence of the aromaticity of the ring P. m4 preferably represents an integer of 0 to 3 and is more preferably 0 or 1 and still more preferably 0.

Formula J-4 represents a trans body, but may be a cis body.

In the present invention, examples of the linking group formed of a combination of two or more linking groups selected from the group consisting of the linking groups represented by Formulae J-1 to J-8 also include linking groups forming a ring structure by linking two or more linking groups selected from the group consisting of linking groups represented by Formulae J-1 to J-8 as long as the linking groups have a bonding place necessary to form the compound represented by any formula of Formulae (3) to (5).

In Formulae (3) to (5), groups that can be understood as the group represented by G¹, G², G³, G⁴, or L¹ are not considered to be included in the linking groups. For example, in the case of Compound T3-1 described below, it is possible to consider L¹ as a pentyl group and J¹ as a methylene group represented by Formula J-1; however, in the present invention, L¹ is interpreted to be the largest group. In this case, L¹ is considered as a hexyl group and J¹ is considered as a single bond.

In the respective chain lengths of the linking groups L¹ and J¹ in the compound represented by Formula (3), the chain length of the linking group J² in the compound represented by Formula (4), and the chain length of the linking group J³ in the compound represented by Formula (5), the number of atoms forming the chains is preferably in a range of 1 to 30 and more preferably in a range of 1 to 15. Here, the chain length refers to the maximum number of atoms forming a chain of which the length is considered, and, in a case in which the chain lengths of two or more chains need to be considered, the maximum number of atoms is considered as the chain length.

In a case in which the linking groups represented by Formulae J-1 to J-8 are combined together, the following combinations are preferred.

A combination of multiple, preferably 2 to 30, more preferably 2 to 10, still more preferably 2 to 5, and particularly preferably 2 to 4 linking groups represented by Formula J-1;
a combination of one or more linking groups (the upper limit is not particularly limited, 30 linking groups and preferably 10 linking groups) represented by Formula J-1 and one or more linking groups (the upper limit is not particularly limited, 30 linking groups and preferably 10 linking groups) represented by Formula J-6;
a combination of one or more linking groups (the upper limit is not particularly limited, 30 linking groups and preferably 10 linking groups) represented by Formula J-6 and one or more linking groups (the upper limit is not particularly limited, 30 linking groups and preferably 10 linking groups) represented by Formula J-7;
a combination of one or more linking groups (the upper limit is not particularly limited, 15 linking groups and preferably 5 linking groups) represented by Formula J-4 and one or more linking groups (the upper limit is not particularly limited, 30 linking groups and preferably 10 linking groups) represented by Formula J-7;
a combination of one or more linking groups (the upper limit is not particularly limited, 30 linking groups and preferably 10 linking groups) represented by Formula J-1, one or more linking groups (the upper limit is not particularly limited, 15 linking groups and preferably 5 linking groups) represented by Formula J-5, and one or more linking groups (the upper limit is not particularly limited, 30 linking groups and preferably 10 linking groups) represented by Formula J-7; and
a combination of one or more linking groups (the upper limit is not particularly limited, 30 linking groups and preferably 10 linking groups) represented by Formula J-1 and one or more linking groups (the upper limit is not particularly limited, 30 linking groups and preferably 10 linking groups) represented by Formula J-7.

Preferred examples of the linking group formed of a combination of the linking groups represented by Formulae J-1 to J-8 include linking groups having the following structure. Each of the following linking groups may further have the substituent W^{P}.

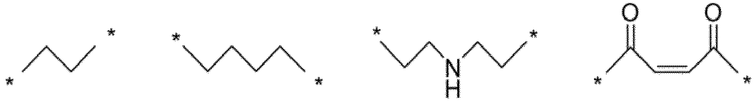

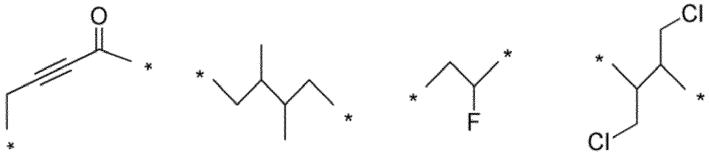

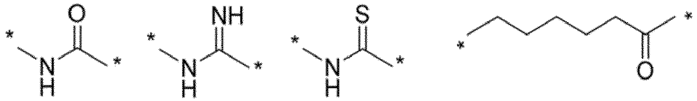

In the formulae, * represents a linking portion to G¹, G², G³, G⁴, L¹, or the ring C.

Hereinafter, specific examples of the compound represented by Formula (3) in the present invention will be described, but the present invention is not limited thereto.

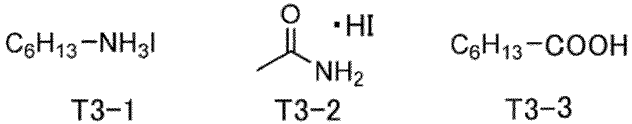

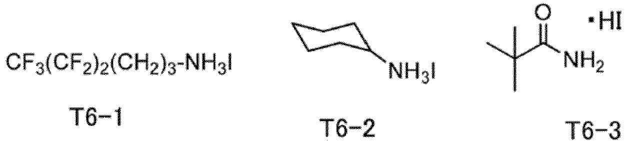

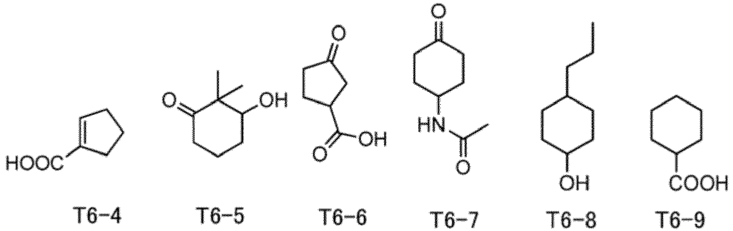

The compound represented by Formula (4) will be described.

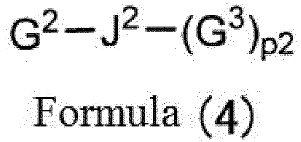

G² and G³ are identical to G¹ in Formula (3), and preferred groups or salts are also identical thereto. The combination of G² and G³ is not particularly limited, a combination of the same kind of groups or salts is preferred, and the groups or salts are more preferably selected from -NR^{a}R^{b} and -(NR^{a}R^{b}R^{c})⁺Ya⁻.

p2 represents an integer of 1 or higher and is preferably 1.

J² is a linking group. J² is preferably at least one linking group selected from the group consisting of the linking groups represented by Formulae J-1 to J-8. In a case in which the linking group is formed by combining two or more linking groups represented by Formulae J-1 to J-8, the above-described combination is preferred. J² is still more preferably the linking group represented by Formula J-1, a linking group formed of a combination of 2 to 30 linking groups (preferably 2 to 10 linking groups and more preferably 2 to 5 linking groups) represented by Formula J-1, a linking group formed of a combination of two linking groups represented by Formula J-1, one linking group represented by Formula J-6, and two linking groups represented by Formula J-1, a linking group formed of a combination of the linking group represented by Formula J-7, one linking group represented by Formula J-4, and two linking groups represented by Formula J-7, a linking group formed of a combination of one linking group represented by Formula J-1, one linking group represented by Formula J-5, and one linking group represented by Formula J-7, or the linking group represented by Formula J-8 and particularly preferably the linking group represented by Formula J-1, a linking group formed of a combination of two or four linking groups represented by Formula J-1, the linking group represented by Formula J-7, or the linking group represented by Formula J-8. Among these, at least one linking group selected from the group consisting of the linking groups represented by Formulae J-1 and J-8 is more preferred.

The compound represented by Formula (4) is preferably a compound represented by Formula (7) below.

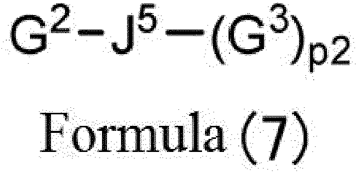

In Formula (7), G² and G³ are each independently identical to G¹ in Formula (3), and preferred groups or salts are also identical thereto. The combinations of G² and G³ are as described above.

p2 is identical to p2 in Formula (4) and preferred integers are also identical thereto.

J⁵ is at least one linking group selected from the group consisting of the linking groups represented by Formulae J-1 and J-8. In Formula (7), J⁵ is still more preferably the linking group represented by Formula J-1, a linking group formed of a combination of 2 to 30 linking groups (preferably 2 to 10 linking groups and more preferably 2 to 5 linking groups) represented by Formula J-1, or the linking group represented by Formula J-8, and particularly preferably the linking group represented by Formula J-1 or a linking group formed of a combination of 2 or 4 linking groups represented by Formula J-1.

In addition, in a case in which J⁵ is a linking group formed only of the linking group represented by Formula J-1 (including a linking group formed of a combination of multiple linking groups represented by Formula J-1), at least one of R¹⁴ and R¹⁵ in Formula J-1 preferably represents a halogen atom (a fluorine atom, a chlorine atom, a bromine atom, or the like), an alkyl group, or an alkyl group having a halogen atom as a substituent (alkyl halide group), more preferably represents a halogen atom, an alkyl group having 1 to 15 carbon atoms, or an alkyl halide group having 1 to 15 carbon atoms (particularly, an alkyl fluoride group or an alkyl chloride group), still more preferably a fluorine atom, an alkyl group having 1 to 6 carbon atoms, or an alkyl halide group having 1 to 6 carbon atoms, and particularly preferably a fluorine atom or an alkyl group having 1 to 6 carbon atoms.

Hereinafter, specific examples of the compound represented by Formula (4) in the present invention will be described, but the present invention is not limited thereto.

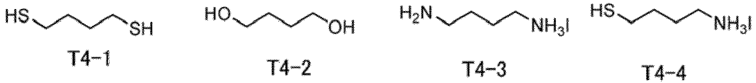

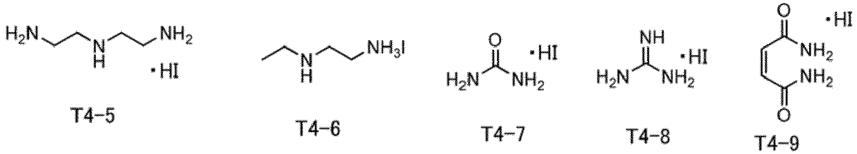

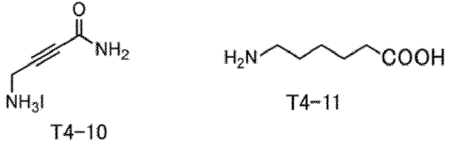

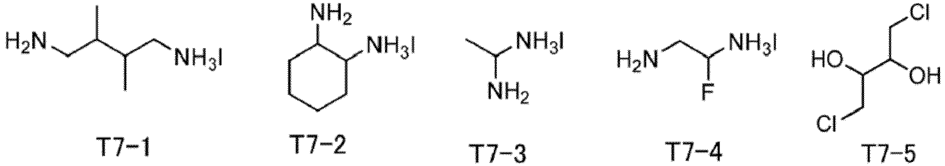

The compound represented by Formula (5) will be described.

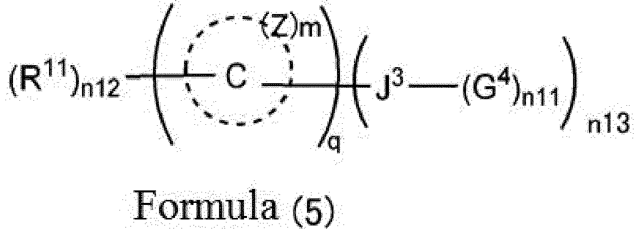

The ring C represents an aromatic hydrocarbon ring made of a carbon atom group necessary to constitute the ring or an aromatic hetero ring made up of the carbon atom group and Z, and Z represents a hetero atom or NR¹².

Examples of the aromatic hydrocarbon ring include benzene rings and polybenzene fused rings (for example, a naphthalene ring and a phenanthrene ring). A hydrocarbon ring that is not an aromatic ring, for example, 3- to 7-membered cycloalkane or 5- to 7-membered cycloalkane may be fused with these rings. The aromatic hydrocarbon ring represented by the ring C is preferably a benzene ring.

The aromatic hetero ring is preferably a 5- to 7-membered ring and more preferably a 5- or 6-membered ring. In addition, an aromatic hydrocarbon ring, a hetero ring including an aliphatic hydrocarbon ring other than aromatic hydrocarbon rings (for example, cycloalkane or cycloalkene), or a hetero ring including an aromatic hetero ring may be fused with these rings. The hetero atom represented by Z is preferably a nitrogen atom, an oxygen atom, or a sulfur atom and more preferably a nitrogen atom or a sulfur atom. R¹² represents a hydrogen atom or a substituent. In a case in which R¹² represents a substituent, examples of the substituent include the above-described substituents W^{P}. Among these, an alkyl group having 1 to 30 carbon atoms is preferred, and an alkyl group having 1 to 15 carbon atoms is more preferred. R¹² is more preferably a hydrogen atom. In addition, m represents an integer of 0 or higher, and, when m is 2 or higher, multiple Z's may be different from each other. m is preferably an integer of 0 to 2. In a case in which the ring C represents an aromatic hetero ring, m is preferably 1 or 2 and more preferably 1.

Examples of the above-described aromatic hetero ring include a pyrrole ring, a thiophene ring, a furan ring, an imidazole ring, a pyrazole ring, an oxazole ring, a thiazole ring, a pyridine ring, a pyrazine ring, a pyrimidine ring, a pyridazine ring, a triazine ring, an oxadiazole ring, a thiadiazole ring, an isoxazole ring, an isothiazole ring, and a triazole ring. In addition, examples of the aromatic hetero ring having a fused structure include a benzothiazole ring, a benzimidazole ring, a benzoxazole ring, an indoline ring, an indazole ring, and the like. The aromatic hetero ring having a fused structure is more preferably a pyridine ring, a pyrazine ring, a pyrimidine ring, a pyridazine ring, a triazine ring, a thiazole ring, or a thiophene ring and still more preferably a pyridine ring or a thiophene ring.

R¹¹ represents a substituent. Examples of the substituent represented by R¹¹ include substituents other than groups corresponding to G⁴ described below out of the above-described substituents W^{P} and a nitro group. Among these, examples thereof include a halogen atom, an alkyl group, an alkenyl group, an alkynyl group, an alkoxy group, an alkylthio group, an aryl group, a heteroaryl group, a nitro group, and a cyano group. In addition, groups having a halogen atom which are obtained by substituting at least one hydrogen atom in each of the substituents such as an alkyl group, an alkenyl group, an alkynyl group, an alkoxy group, an alkylthio group, an aryl group, and a heteroaryl group with a halogen atom (referred to as "groups having a halogen atom") are also preferred. The groups having a halogen atom are preferably an alkyl group substituted with a halogen atom and more preferably an alkyl group substituted with a fluorine atom.

Examples of the halogen atom represented by R¹¹ include a fluorine atom, a chlorine atom, a bromine atom, and an iodine atom. A fluorine atom is preferred.

The alkyl group is preferably the alkyl group described in the section of L¹ described above, and preferred alkyl groups are also identical to the preferred L¹.

The alkenyl group is preferably a linear alkenyl group or branched alkenyl group having 2 to 20 carbon atoms and, for example, preferably ethenyl, 1-propenyl, 2-propenyl, 1-butenyl, 4-pentenyl, or butadiene. In the alkenyl group, the cis-trans isomerism is not particularly limited.

The alkynyl group is preferably a linear alkynyl group or branched alkynyl group having 2 to 20 carbon atoms, and examples thereof include ethynyl and butynyl.

The alkoxy group and an alkyl portion of the alkylthio group are preferably identical to the alkyl group described in the section of L¹ described above. This alkoxy group may be substituted. Examples of the substituent include the substituents W^{P}. The substituted alkoxy group is preferably a 2-methoxyethyloxy group.

The aryl group and the heteroaryl group are identical to the aromatic hydrocarbon ring and aromatic hetero ring described in the section of the ring C and are preferably a benzene ring, a pyridine ring, or a thiophene ring.

R¹¹ is preferably an alkyl group, a branched alkyl group, a halogen atom, or a group having a halogen atom, more preferably a branched alkyl group, a halogen atom, or a group having a halogen atom, and more preferably a branched alkyl group or an alkyl group substituted with a halogen atom.

G⁴ is identical to G¹ in Formula (3), and preferred groups or salts are also identical thereto.

J³'s are each independently a single bond or a linking group. In a case in which J³ is a linking group, J³ is preferably at least one linking group selected from the group consisting of the linking groups represented by Formulae J-1 to J-8. J³ is preferably a single bond or at least one linking group selected from the group consisting of the linking groups represented by Formulae J-1, J-6, and J-7. In a case in which J³ is a linking group, preferred examples thereof include, out of the above-described combinations, combinations including Formula J-1, J-6, or J-7. The linking group as J³ is more preferably a single bond, the linking group represented by Formula J-1, the linking group represented by Formula J-7, a linking group formed of a combination of two linking groups represented by Formula J-1, and a linking group formed of a combination of one linking group represented by Formula J-6 and one linking group represented by Formula J-7.

In a case in which Formula (5) includes "-J³-(G⁴)ₙ₁₁", the bonding location of the ring C is not particularly limited. In a case in which the ring C is an aromatic hetero ring, the bonding location of at least one "-J³-(G⁴)ₙ₁₁" group is preferably the second position (an atom adjacent to the hetero atom) of the ring C (in a case in which a hetero atom is placed in the first position).

n11 represents an integer of 1 or higher and is preferably an integer of 1 to 3, more preferably 1 or 2, and still more preferably 1.

n12 represents an integer of 0 or higher and is preferably an integer of 0 to 2, more preferably 0 or 1, and still more preferably 1.

n13 represents an integer of 0 or higher and is preferably an integer of 0 to 4, more preferably 1 to 4, and still more preferably 1 or 2. Here, in a case in which the ring C does not include any nitrogen atom, n13 represents an integer of 1 or higher and is preferably 1 or 2.

q represents an integer of 1 or higher and is preferably an integer of 1 to 3 and more preferably 1.

The compound represented by Formula (5) is preferably a compound represented by Formula (8) below.

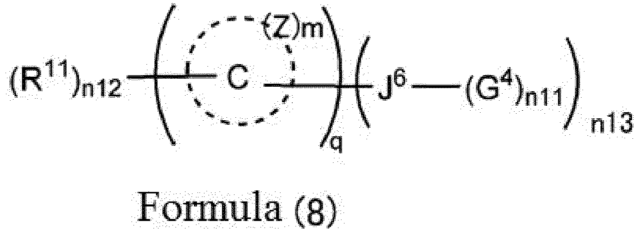

In Formula (8), J⁶ represents a single bond or at least one linking group selected from the group consisting of linking groups represented by Formulae J-1, J-6, and J-7. The linking group as J⁶ is identical to the linking group as J³, and preferred linking groups are also identical thereto.

The ring C, Z, m, q, R¹¹, G⁴, n11, n12, and n13 are each identical to the ring C, Z, m, q, R¹¹, G⁴, n11, n12, and n13 in Formula (5), and preferred rings, hetero atoms, integers, groups, and salts are identical thereto.

In Formula (8), R¹¹ is preferably a branched alkyl group, a halogen atom, or a group having a halogen atom and more preferably a branched alkyl group or an alkyl group substituted with a halogen atom.

Hereinafter, specific examples of the compound represented by Formula (5) in the present invention will be described, but the present invention is not limited thereto.

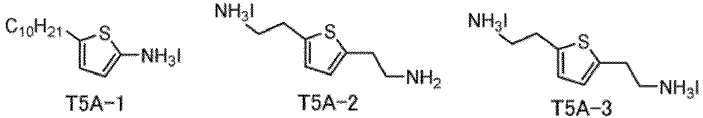

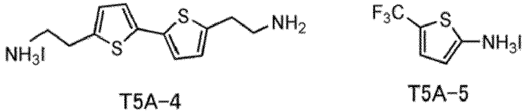

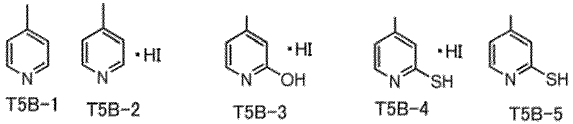

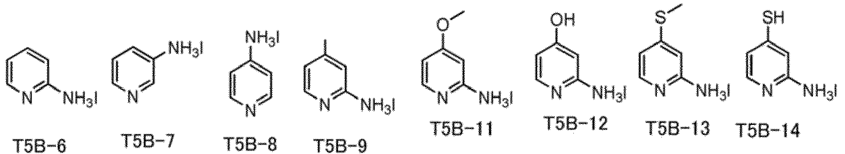

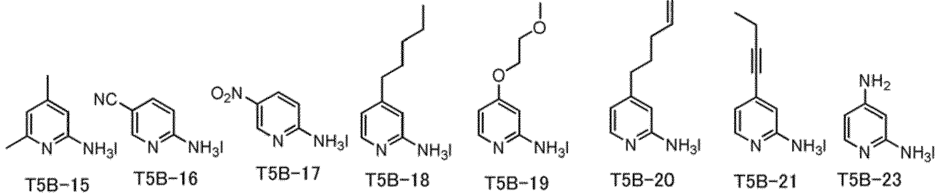

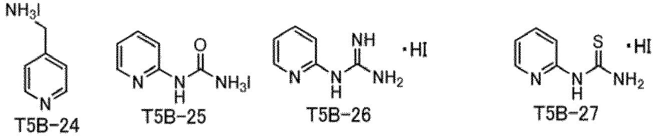

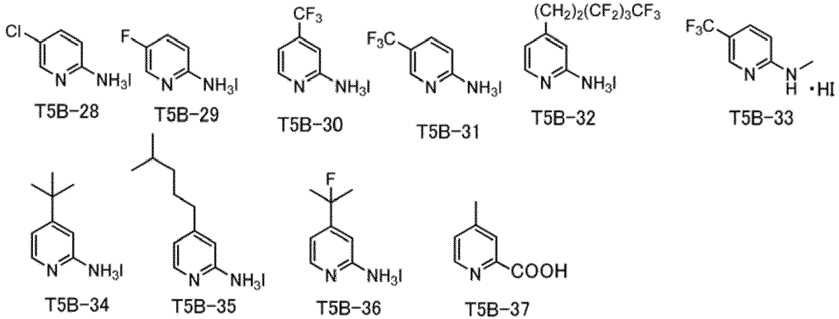

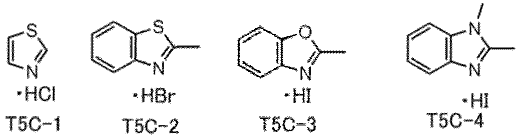

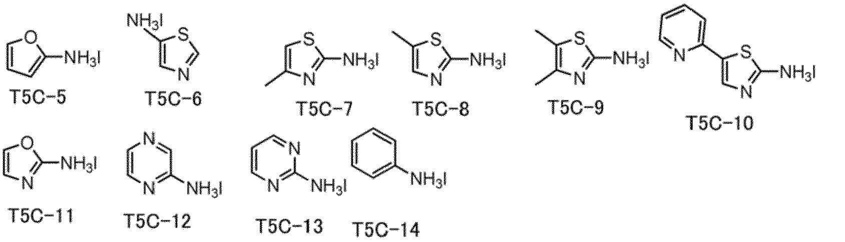

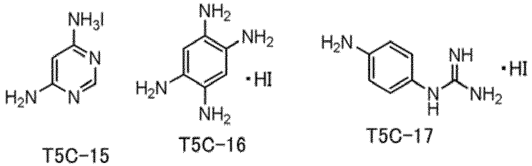

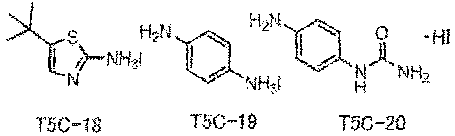

Among the compounds represented by the respective formulae described above, the compound represented by Formula (3) or (5) is preferred, and the compound represented by Formula (5) is more preferred. Among the compounds represented by Formula (5), a compound having two or more G⁴'s (a compound in which the product of n11 and n13 is 2 or more) or a compound having G⁴ and R¹¹ (a compound in which both n12 and n13 are an integer of 1 or more) is still more preferred, and, among the compounds represented by Formula (5), a compound in which the ring C is an aromatic hetero ring is particularly preferred.

The compound represented by any formula of Formulae (3) to (5) which is used in the present invention can be synthesized according to an ordinary method. For example, the compound can be synthesized on the basis of individual methods for synthesizing Compound T5B-35 and T5C-17 described below.

### <Hole transportation layer 3>

In a preferred aspect of the photoelectric conversion element of the present invention, as in the photoelectric conversion elements 10A to 10D, the hole transportation layer 3 is provided between the first electrode 1 and the second electrode 2. Preferably, the hole transportation layer 3 is provided between the photosensitive layer 13 in the first electrode 1 and the second electrode 2 and is in contact with (laminated on) the compound layer 5.

The hole transportation layer 3 has a function of supplementing electrons to the oxidant of the light absorber and is preferably a solid-form layer (a solid hole transportation layer).

A hole-transporting material used to form the hole transportation layer 3 is not particularly limited, and examples thereof include inorganic materials such as Cul and CuNCS, organic hole-transporting materials described in, for example, Paragraphs 0209 to 0212 of JP2001-291534A, and the like. The hole-transporting material is preferably an organic hole-transporting material from the viewpoint of the compatibility with the compound. Preferred examples of the organic hole-transporting material include conductive polymers such as polythiophene, polyaniline, polypyrrole, and polysilane, spiro compounds in which two rings share a central atom having a tetrahedral structure such as C or Si, aromatic amine compounds such as triarylamine, triphenylene compounds, nitrogen-containing heterocyclic compounds, and liquid crystalline cyano compounds.

The hole-transporting material is preferably an organic hole-transporting material which can be applied in a solution form and turns into solid, and specific examples thereof include 2,2'7,7'-tetrakis-(N,N-di-p-methoxyphenylamine)-9,9-spirobifluorene (also referred to as spiro-OMeTAD), poly(3-hexylthiophene-2,5-diyl), 4-(diethylaamino)benzoaldehyde, diphenylhydrazone, polyethylene dioxythiophene (PEDOT), and the like.

The film thickness of the hole transportation layer 3 is not particularly limited, but is preferably 50 µm or less, more preferably in a range of 1 nm to 10 µm, still more preferably in a range of 5 nm to 5 µm, and particularly preferably in a range of 10 nm to 1 µm.

The film thickness of the hole transportation layer 3 corresponds to the average distance the second electrode 2 and the surface of the compound layer 5 or the surface of the first electrode 1 and can be measured by observing the cross section of the photoelectric conversion element 10 using a scanning electron microscope (SEM) or the like.

### <Electron transportation layer 4>

In a preferred aspect of the photoelectric conversion element of the present invention, as in the photoelectric conversion element 10E, the electron transportation layer 4 is provided between the first electrode 1 and the second electrode 2. In this aspect, the electron transportation layer 4 is preferably in contact with (laminated on) the compound layer 5.

The electron transportation layer 4 is identical to the electron transportation layer 15 except for the fact that the electron transportation destination is the second electrode and the electron transportation layer is formed at a different location.

### <Second electrode 2>

The second electrode 2 functions as a positive electrode in solar cells. The second electrode 2 is not particularly limited as long as the second electrode is conductive and, generally, can be provided with the same constitution as that of the conductive support 11. In a case in which a sufficient strength is ensured, the support 11a is not essentially required.

The structure of the second electrode 2 is preferably a structure having a strong power-collection effect. In order to allow light to reach the photosensitive layer 13, at least one of the conductive support 11 and the second electrode 2 needs to be substantially transparent. In the solar cell of the present invention, it is preferable that the conductive support 11 is transparent and sunlight enters the solar cell through the support 11a side. In this case, the second electrode 2 more preferably has a property of reflecting light.

Examples a material used to form the second electrode 2 include metal such as platinum (Pt), gold (Au), nickel (Ni), copper (Cu), silver (Ag), indium (In), ruthenium (Ru), palladium (Pd), rhodium (Rh), iridium (Ir), osmium (Os), and aluminum (Al), the above-described conductive metallic oxides, carbon materials, conductive polymers, and the like. The carbon materials needs to be conductive materials formed of carbon atoms bonded together, and examples thereof include fullerene, carbon nanotubes, graphite, graphene, and the like.

The second electrode 2 is preferably a thin film (including a thin film obtained by means of vapor deposition) of metal or a conductive metallic oxide or a glass or plastic substrate having this thin film. The glass or plastic substrate is preferably a glass substrate having a gold or platinum thin film or a glass substrate on which platinum is vapor-deposited.

The film thickness of the second electrode 2 is not particularly limited, but is preferably in a range of 0.01 to 100 µm, more preferably in a range of 0.01 to 10 µm, and particularly preferably in a range of 0.01 to 1 µm.

### <Other constitutions>

In the present invention, in order to prevent the first electrode 1 and the second electrode 2 from coming into contact with each other, a spacer or a separator can also be used instead of the blocking layer 14 or together with the blocking layer 14.

In addition, a hole-blocking layer may be provided between the second electrode 2 and the hole transportation layer 3.

### <<Solar cell>>

The solar cell of the present invention is constituted using the photoelectric conversion element of the present invention. For example, as illustrated in Figs. 1 to 6, it is possible to use the photoelectric conversion element 10 constituted so as to cause the external circuit 6 to work as a solar cell. As the external circuit 6 which comes into contact with the first electrode 1 (the conductive support 11) and the second electrode 2, a well-known circuit can be used without any particularly limitation.

The present invention can be applied to, for example, solar cells described in KR10-1172374B, WO2013/171517A, J. Am. Chem. Soc., 2009, 131 (17), pp. 6050 and 6051, and Science, 338, p. 643 (2012).

In order to prevent the deterioration, evaporation, and the like of constituent substances, the solar cell of the present invention preferably has a side surface that is sealed with a polymer, an adhesive, or the like.

As described above, the photoelectric conversion element and the solar cell of the present invention include the first electrode having the compound represented by any formula of Formulae (3) to (5) on the surface, allow only a small difference in photoelectric conversion efficiency between solid bodies, and exhibit stable cell performance.

### <<Method for manufacturing photoelectric conversion element and solar cell>>

The photoelectric conversion element and the solar cell of the present invention can be manufactured busing a well-known manufacturing method, for example, methods described in KR10-1172374B, WO2013/171517A, J. Am. Chem. Soc., 2009, 131 (17), pp. 6050 and 6051, and Science, 338, p. 643 (2012).

Hereinafter, the method for manufacturing the photoelectric conversion element and the solar cell of the present invention will be simply described.

In the method for manufacturing the photoelectric conversion element and the solar cell of the present invention (hereinafter, referred to as the manufacturing method of the present invention), other steps and the like are not particularly limited as long as the method includes a step of brining the first electrode which includes the photosensitive layer including the perovskite compound having the above-described cation and anion into contact with liquid containing at least one compound selected from the compounds represented by any formula of Formulae (3) to (5).

In the manufacturing method of the present invention, first, at least one of the blocking layer 14, the porous layer 12, the electron transportation layer 15, or the hole transportation layer 16 are formed on the surface of the conductive support 11 as desired.

The blocking layer 14 can be formed by, for example, applying a dispersion including the above-described insulating substance, a precursor compound thereof, or the like onto the surface of the conductive support 11 and firing the dispersion or thermally decomposing the dispersion by means of spraying.

A material used to form the porous layer 12 is preferably used in a fine particle form and more preferably used in a form of fine particles in a dispersion.

A method for forming the porous layer 12 is not particularly limited, and examples thereof include wet-type methods, dry-type methods, and other methods (for example, methods described in Chemical Review, Vol. 110, p. 6595 (published on 2010)). In these methods, it is preferable to apply the dispersion (paste) onto the surface of the conductive support 11 or the surface of the blocking layer 14 and then fire the dispersion at a temperature in a range of 100°C to 800°C for ten minutes to ten hours, for example, in the air. In such a case, it is possible to bring the fine particles into close contact with each other.

In a case in which firing is performed multiple times, the temperature of firing that is not the final firing (the non-final firing temperature) is preferably set to be lower than the temperature of the final firing (the final firing temperature). For example, in a case in which titanium oxide paste is used, the non-final firing temperature can be set in a range of 50°C to 300°C. In addition, the final firing temperature can be set to be higher than the non-firing firing temperature in a range of 100°C to 600°C. In a case in which a glass support is used as the support 11a, the firing temperature is preferably in a range of 60°C to 500°C.

The amount of a porous material applied to form the porous layer 12 is appropriately set depending on the film thickness of the porous layer 12, the number of times of coating, and the like and is not particularly limited. The amount of the porous material applied to square meter of the surface area of the conductive support 11 is, for example, preferably in a range of 0.5 to 500 g and more preferably in a range of 5 to 100 g.

In a case in which the electron transportation layer 15 or the hole transportation layer 16 is provided, the layer can be formed in the same manner as the hole transportation layer 3 or the electron transportation layer 4 described below.

Next, the photosensitive layer 13 is provided.

A method for providing the photosensitive layer 13 is not particularly limited, and examples thereof include wet-type methods and dry-type methods. In the present invention, wet-type methods are preferred, and, for example, a method in which the surface is brought into contact with a light absorber solution including the perovskite-type light absorber is preferred. In this method, first, the light absorber solution for forming the photosensitive layer is prepared. The light absorber solution includes MX₂ and AX which are raw materials of the perovskite compound. Here, A, M, and X are identical to A, M, and X in Formula (I). In this light absorber solution, the molar ratio between MX₂ and AX is appropriately adjusted depending on the purposes. In a case in which a perovskite compound is formed as the light absorber, the molar ratio between MX₂ and AX is preferably in a range of 1:1 to 10:1. The light absorber solution can be prepared by mixing MX₂ and AX in a predetermined molar ratio and then heating the components. This forming liquid is generally a solution, but may be a suspension. Heating conditions are not particularly limited, but the heating temperature is preferably in a range of 30°C to 200°C and more preferably in a range of 70°C to 150°C. The heating duration is preferably in a range of 0.5 to 100 hours and more preferably in a range of 1 to 3 hours. As a solvent or a dispersion medium, substances described below can be used.

Next, the prepared light absorber solution is brought into contact with the surface of a layer which includes the photosensitive layer 13 (in the photoelectric conversion element 10, any layer of the porous layer 12, the blocking layer 14, the electron transportation layer 15, and the hole transportation layer 16) formed on the surface. Specifically, it is preferable to apply the light absorber solution onto the surface or immerse the surface in the forming liquid. The temperature at which the forming liquid is brought into contact with the surface is preferably in a range of 5°C to 100°C, and the immersion duration is preferably in a range of 5 seconds to 24 hours and more preferably in a range of 20 seconds to 1 hour. In a case in which the applied light absorber solution is dried, the forming liquid is preferably dried using heat and is generally dried by being generally heated at 20°C to 300°C and being preferably heat at 50°C to 170°C.

In addition, it is also possible to for the photosensitive layer according to a method for synthesizing the above-described perovskite compound.

Furthermore, examples thereof also include a method in which an AX solution including the AX and an MX₂ solution including the MX₂ are separately applied (including the immersion method) and are dried as necessary. In this method, any solution may be applied in advance, but the MX₂ solution is preferably applied in advance. In this method, the molar ratio between AX and MX₂, coating conditions, and drying conditions are identical to those in the above-described method. In this method, instead of applying the AX solution and the MX₂ solution, it is also possible to vapor-deposit AX or MX₂.

Furthermore, as another method, it is possible to use a dry-type method such as vapor deposition in a vacuum in which a compound or a mixture obtained by removing the solvent from the light absorber solution is used. For example, it is possible to use a method in which the AX and the MX₂ are simultaneously or sequentially vapor-deposited.

In these method and the like, the perovskite compound is formed on the surface of the porous layer 12, the blocking layer 14, the electron transportation layer 15, or the hole transportation layer 16 as the photosensitive layer.

In the manufacturing method of the present invention, next, the compound represented by any formula of Formulae (3) to (5) is provided on the surface of the first electrode.

In order to provide the above-described compound on the surface of the first electrode, liquid containing the above-described compound is used. This liquid may be a liquid form of the above-described compound or a solution or a suspension (dispersion liquid). A solvent or a dispersant is not particularly limited, examples thereof include solvents or dispersants described below, and isopropanol is preferred. The concentration of the compound in the liquid is not particularly limited, but is, for example, preferably in a range of 0.001 to 100% by mass and more preferably in a range of 0.01 to 100% by mass.

A method for bringing the prepared liquid into contact with the surface of the first electrode is not particularly limited, and examples thereof include wet-type methods such as a method in which liquid is applied to the surface of the first electrode and a method in which the first electrode is immersed in the liquid. In addition, examples of other methods include dry-type methods such as a vacuum vapor-deposition method in which a mixture obtained by removing the solvent of the liquid is used. Wet-type methods are preferred. Examples of a method for applying the liquid include a variety of methods described below.

The application or immersion temperature is preferably in a range of 5°C to 100°C. In this range, it is considered that the structure of the perovskite layer can be maintained.

The immersion duration is preferably in a range of 0.1 seconds to 24 hours, more preferably in a range of 5 seconds to 24 hours, and more preferably in a range of 20 seconds to 1 hour.

After the application or the immersion, the liquid is preferably dried. The drying conditions are not particularly limited. The drying temperature is, for example, preferably in a range of 5°C to 300°C and more preferably in a range of 20°C to 150°C. The drying duration is, for example, preferably in a range of 1 second to 48 hours and more preferably in a range of 1 minute to 5 hours.

In this step, the application amount of the compound represented by any formula of Formulae (3) to (5) is appropriately determined depending on the kinds and the like of the compound and is not particularly limited. In the present invention, the application amount is determined so that at least part of the surface of the first electrode is covered with the above-described abundance of the compound (the compound layer 5). It is preferable that the surface of the first electrode is uniformly covered and the molecules of the compound represented by any formula of Formulae (3) to (5) do not superimpose each other from the viewpoint of preventing backward charge migration.

On the compound layer 5 formed as described above, preferably, the hole transportation layer 3 or the electron transportation layer 4 is formed.

The hole transportation layer 3 can be formed by applying and drying a hole-transporting material solution including a hole-transporting material. In the hole-transporting material solution, the concentration of the hole-transporting material is preferably in a range of 0.1 to 1.0 M (mol/L) since coatability is excellent and, in a case in which the porous layer 12 is provided, the hole-transporting material is capable of easily intruding into the inside of pores in the porous layer 12.

The electron transportation layer 4 can be formed by applying and drying an electron-transporting material solution including an electron-transporting material.

After the hole transportation layer 3 or the electron transportation layer 4 is formed, the second electrode 2 is formed, thereby manufacturing the photoelectric conversion element.

The film thicknesses of the respective layers can be adjusted by appropriately changing the concentrations of the respective dispersions or solutions and the number of times of coating. For example, in a case in which the photosensitive layers 13B and 13C having a thick film thickness are provided, the light absorber solution may be applied and dried multiple times.

The respective dispersions and solutions described above may respectively include additives such as a dispersion aid and a surfactant.

Examples of the solvent or dispersion medium that is used in the method for manufacturing the solar cell include solvents described in JP2001-291534A, but the solvent or dispersion medium is not limited thereto. In the present invention, organic solvents are preferred, and alcohol solvents, amide solvents, nitrile solvents, hydrocarbon solvents, lactone solvents, halogen solvents, and solvent mixtures of two or more thereof are more preferred. The solvent mixture is preferably a solvent mixture of an alcohol solvent and a solvent selected from amide solvents, nitrile solvents, and hydrocarbon solvents, Specifically, methanol, ethanol, isopropanol, γ-butyrolactone, chlorobenzene, acetonitrile, N,N'-dimethylformamide (DMF), dimethylacetoamide, or a solvent mixture thereof is preferred.

A method for applying the solutions or dispersants used to form the respective layers is not particularly limited, and it is possible to use a well-known coating method such as spin coating, extrusion die coating, blade coating, bar coating, screen printing, stencil printing, roll coating, curtain coating, spray coating, dip coating, an inkjet printing method, or an immersion method. Among these, spin coating, screen printing, and the like are preferred.

The photoelectric conversion element of the present invention may be subjected to an efficiency stabilization treatment such as annealing, light soaking, or being left in an oxygen atmosphere as necessary.

The photoelectric conversion element produced as described above can be used as a solar cell by connecting the external circuit 6 to the first electrode 1 and the second electrode 2.

### Examples

Hereinafter, the present invention will be described in more detail on the basis of examples, but the present invention is not limited to the following examples.

### Synthesis Example

Compounds used in the following examples were synthesized according to Synthesis Examples 1 and 2 below.

### (Synthesis Example 1: Synthesis of Compound T5B-35)

Compound T5B-35 was synthesized according to the following scheme.

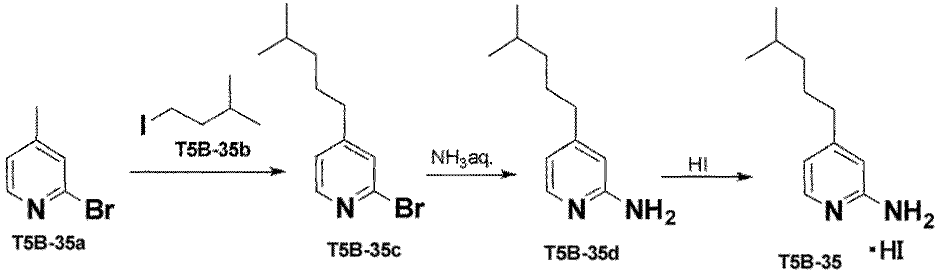

### Synthesis of Compound T5B-35c

Diisopropylamine (DIPA) (9 g) and tetrahydrofuran (THF) (50 mL) were mixed together, the mixture was cooled to -50°C, then, 1.6 M n-BuLi (a hexane solution, 13.1 mL) was added dropwise thereto, and the components were stirred for 30 minutes. Subsequently, T5B-35a (3.0 g) was added thereto, the components were stirred for one hour, then, Compound T5B-35b (3.5 g) was added dropwise thereto, and the components were stirred for two hours. The reacted mixture was returned to room temperature and was further stirred for one hour. After the stirring, water and ethyl acetate were added to the reacted mixture, liquid was separated, an organic phase was condensed and was purified by means of column chromatography, thereby obtaining Compound T5B-35c (3.1 g).

### Synthesis of Compound T5B-35d

Compound T5B-35c (2.0 g), Cu₂O (60 mg), 28% ammonia water (6 mL), potassium carbonate (220 mg), and dimethyl ethylene diamine (2 mL) were mixed together in ethyl glycol (20 mL) and were stirred at 60°C for 10 hours. After cooling, water and ethyl acetate were added to the reacted mixture, liquid was separated, an organic phase was condensed and was purified by means of column chromatography, thereby obtaining Compound T5B-35d (1.1 g).

### Synthesis of Compound T5B-35

Compound T5B-35d and an aqueous solution of 57% by mass of hydrogen iodine were diluted with methanol, were stirred at 0°C in a flask for two hours, and then were condensed, thereby obtaining a coarse body of Compound T5B-35. The obtained coarse body of Compound T5B-35 was dissolved in ethanol and was recrystallized with diethyl ether, the obtained crystals were filtered and dried under reduced pressure at 60°C for five hours, thereby obtaining purified T5B-35.

### Identification of Compound T5B-35

The structure of Compound T5B-35 was confirmed by means of mass spectrometry (MS).
MS-ESI m/z=179.2 (M+H)⁺

### (Synthesis Example 2: Synthesis of Compound T5C-17)

Compound T5C-17 was synthesized according to the following scheme.

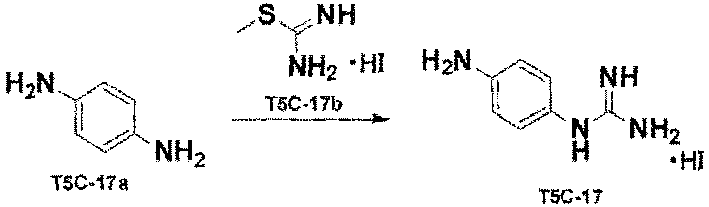

### Synthesis of Compound T5C-17

T5C-17a (2.2 g) and T5C-17b (4.4 g) were stirred at 95°C in water (700 mL) for two hours and then were cooled to 4°C, and the generated crystals were filtered. The obtained crystals were recrystallized using ethanol (EtOH), thereby obtaining T5C-17 (1.5 g).

### Identification of Compound T5C-17

The structure of Compound T5C-17 was confirmed by means of mass spectrometry (MS).
MS-ESI m/z=151.1 (M+H)⁺

### Example 1

### (Manufacturing of photoelectric conversion element and solar cell (Specimen Number 101))

The photoelectric conversion element 10A and the solar cell illustrated in Fig. 1 were manufactured in an order described below. In a case in which the film thickness of the photosensitive layer 13 is thick, the photoelectric conversion element and the solar cell correspond to the photoelectric conversion element 10B and the solar cell illustrated in Fig. 2.

An isopropanol solution containing 15% by mass of titanium diisopropoxide bis(acetylacetonate) (manufactured by Sigma-Aldrich Japan K.K.) was diluted with 1-ethanol, thereby preparing 0.02 M of a solution for a blocking layer.

A conductive support 11 obtained by forming a fluorine-doped SnO₂ conductive film (a transparent electrode 11b, a film thickness of 300 nm) on a glass support 11a (having a thickness of 2 mm) was prepared.

A blocking layer 14 (having a film thickness of 50 nm) was formed on the SnO₂ conductive film using the 0.02 M of a solution for the blocking layer at 450°C by means of a spray thermal decomposition method.

Ethyl cellulose, lauric acid, and terpineol were added to an ethanol dispersion of titanium oxide (TiO₂, acetase, an average particle diameter of 20 nm), thereby preparing titanium oxide paste.

The prepared titanium oxide paste was applied onto the blocking layer 14 by means of a screen printing method and was fired at 500°C in the air for three hours. After that, the obtained titanium oxide fired body was immersed in an aqueous solution of 40 mM of TiCl₄, was heated at 60°C for one hour, and, continuously, was heated at 500°C for 30 minutes, thereby forming the porous layer 12 (having a film thickness of 0.25 µm) made of TiO₂.

A 40% methanol solution of methyl amine (27.86 mL) and an aqueous solution of 57% by mass of hydrogen iodide (hydroiodic acid, 30 mL) were stirred in a flask at 0°C for two hours and then were condensed, thereby obtaining a CH₃NH₃I coarse body. The obtained CH₃NH₃I coarse body was dissolved in ethanol and was recrystallized with diethyl ether, and the obtained crystals were filtered and were dried at 60°C for five hours under reduced pressure, thereby obtaining purified CH₃NH₃I.

Next, the purified CH₃NH₃I and PbI₂ were stirred and mixed together at 60°C in DMF for 12 hours at a molar ratio of 1:1 and then were filtered using a polytetrafluoroethylene (PTFE) syringe filter, thereby preparing 40% by mass of a light absorber solution A.

The prepared light absorber solution A was applied onto the porous layer 12 formed on the conductive support 11 using a spin coating method (at 2,000 rpm for 60 seconds and continuously at 3,000 rpm for 60 seconds) and then was dried at 100°C for 60 minutes using a hot plate, and a photosensitive layer 13A made of a perovskite compound of CH₃NH₃PbI₃ (having a film thickness of 300 nm (including the film thickness of a porous layer 12 which was 250 nm)) was provided, thereby producing a first electrode 1.

A first electrode 1A was produced in the above-described manner.

The first electrode 1A was immersed in a 0.1 M isopropanol solution of Compound T3-1 shown in Table 1 below for ten seconds and then was dried at 100°C for 30 minutes using a hot plate, thereby forming a compound layer 5A. The compound layer 5A was formed on the surface of the photosensitive layer 13A in a film shape. The surface of the first electrode 1A onto which the isopropanol solution including Compound T3-1 was applied was checked using the GPC method in the above-described manner, and the abundance of Compound T3-1 was found to be 5 mg/m².

As a hole-transporting material, spiro-OMeTAD (180 mg) was dissolved in chlorobenzene (1 mL). An acetonitrile solution (37.5 µL) obtained by dissolving lithium-bis(trifluoromethansulfonyl)imide (170 mg) in acetonitrile (1 mL) and t-butylpyridine (TBP, 17.5 µL) were added to and mixed with the chlorobenzene solution, thereby preparing a solution for the hole transportation layer.

Next, the prepared solution for the hole transportation layer was applied using a spin coating method and dried on the compound layer 5A formed on the surface of the first electrode 1A, thereby forming a solid hole transportation layer 3A (having a film thickness of 100 nm).

Gold was vapor-deposited on the solid hole transportation layer 3A using a vapor deposition method, thereby producing a second electrode 2 (having a film thickness of 100 nm).

A photoelectric conversion element and a solar cell (Specimen Number 101) were manufactured as described above.

The respective film thicknesses were observed and measured using a SEM according to the above-described method.

### (Manufacturing of photoelectric conversion elements and solar cells (Specimen Numbers 102 to 117, 120 to 128, 130 to 132, and c101))

Photoelectric conversion elements and solar cells of the present invention (Specimen Numbers 102 to 117, 120 to 128, and 130 to 132) and a photoelectric conversion element and a solar cell for comparison (Specimen Number c101) were respectively manufactured in the same manner as in the manufacturing of the photoelectric conversion element and the solar cell (Specimen Number 101) except for the fact that, in the manufacturing of the photoelectric conversion element and the solar cell (Specimen Number 101), Compound T3-1 was respectively changed to compounds shown in Table 1 or Compound T3-1 was not used (Specimen Number c101).

The abundances of individual compound layers were in a range of 1 to 50 mg/m².

### (Manufacturing of photoelectric conversion element and solar cell (Specimen Number 118))

A photoelectric conversion element and a solar cell of the present invention (Specimen Number 118) was manufactured in the same manner as in the manufacturing of the photoelectric conversion element and the solar cell (Specimen Number 117) except for the fact that, in the manufacturing of the photoelectric conversion element and the solar cell (Specimen Number 117), the following light absorber solution B was used instead of the light absorber solution A.

The abundance of Compound T7-3 was 1.3 mg/m².

### <Preparation of light absorber solution B>

A 40% methanol solution of methylamine (27.86 mL) and an aqueous solution of 57% by mass of hydrogen iodide (hydroiodic acid, 30 mL) were stirred in a flask at 0°C for two hours and then were condensed, thereby obtaining a CH₃NH₃I coarse body. The obtained CH₃NH₃I coarse body was dissolved in ethanol and was recrystallized with diethyl ether, and the obtained crystals were filtered and were dried at 60°C for five hours under reduced pressure, thereby obtaining purified CH₃NH₃I. Next, the purified CH₃NH₃I, PbCl₂, and PbI₂ were stirred and mixed together at 60°C in isopropanol for 12 hours at a molar ratio of 1:0.50:0.50 and then were filtered using a PTFE syringe filter, thereby preparing 40% by mass of a light absorber solution B.

### (Manufacturing of photoelectric conversion element and solar cell (Specimen Number 119))

A photoelectric conversion element and a solar cell of the present invention (Specimen Number 119) was manufactured in the same manner as in the manufacturing of the photoelectric conversion element and the solar cell (Specimen Number 117) except for the fact that, in the manufacturing of the photoelectric conversion element and the solar cell (Specimen Number 117), the following light absorber solution C was used instead of the light absorber solution A.

The abundance of Compound T7-3 was 1.3 mg/m².

### <Preparation of light absorber solution C>

A 40% methanol solution of methylamine (27.86 mL) and an aqueous solution of 57% by mass of hydrogen bromide (hydrobromic acid, 30 mL) were stirred in a flask at 0°C for two hours and then were condensed, thereby obtaining a CH₃NH₃Br coarse body. The obtained CH₃NH₃Br coarse body was dissolved in ethanol and was recrystallized with diethyl ether, and the obtained crystals were filtered and were dried at 60°C for 24 hours under reduced pressure, thereby obtaining purified CH₃NH₃Br. Next, the purified CH₃NH₃Br and PbBr₂ were stirred and mixed together at 60°C in isopropanol for 12 hours at a molar ratio of 1:1 and then were filtered using a PTFE syringe filter, thereby preparing 40% by mass of a light absorber solution C.

### (Manufacturing of photoelectric conversion element and solar cell (Specimen Number 129))

A photoelectric conversion element and a solar cell of the present invention (Specimen Number 129) was manufactured in the same manner as in the manufacturing of the photoelectric conversion element and the solar cell (Specimen Number 101) except for the fact that, in the manufacturing of the photoelectric conversion element and the solar cell (Specimen Number 101), the 0.1 M isopropanol solution of Compound T3-1 was applied onto the first electrode using a spin coating method (for 60 seconds at 5,000 rpm) instead of immersing the first electrode 1 in the 0.1 M isopropanol solution of Compound T3-1.

The abundance of Compound T3-1 was 1.9 mg/m².

### (Manufacturing of photoelectric conversion element and solar cell (Specimen Number 133))

A photoelectric conversion element and a solar cell of the present invention (Specimen Number 133) was manufactured in the same manner as in the manufacturing of the photoelectric conversion element and the solar cell (Specimen Number c102) except for the fact that, in the manufacturing of the photoelectric conversion element and the solar cell (Specimen Number c102), the following light absorber solution D was used instead of the light absorber solution A, and an isopropanol solution including Compound T6-1 (the concentration of Compound T6-1 of 0.01 M) was applied using a spin coating method (for 30 seconds at 5,000 rpm).

The photosensitive layer 3A was made of a perovskite compound of (CH₃CH₂NH₃)₂PbI₄ and had a film thickness of 300 nm (including the film thickness of the porous layer 12 of 250 nm). In addition, the abundance of Compound T6-1 was 3.5 mg/m².

### <Preparation of light absorber solution D>

A 40% ethanol solution of ethylamine (36 g) and an aqueous solution of 57% by mass of hydrogen iodide (hydroiodic acid, 72 g) were stirred in a flask at 0°C for two hours and then were condensed, thereby obtaining a CH₃CH₂NH₃I coarse body. The obtained CH₃CH₂NH₃I coarse body was dissolved in ethanol and was recrystallized with diethyl ether. The precipitated crystals were filtered and were dried at 60°C for 12 hours under reduced pressure, thereby obtaining purified CH₃CH₂NH₃I. Next, the purified CH₃CH₂NH₃I and PbI₂ were stirred and mixed together at 60°C in DMF for five hours at a molar ratio of 2:1 and then were filtered using a polytetrafluoroethylene (PTFE) syringe filter, thereby preparing 40% by mass of a light absorber solution D.

### (Manufacturing of photoelectric conversion elements and solar cells (Specimen Numbers 134 to 136))

Photoelectric conversion elements and solar cells of the present invention (Specimen Numbers 134 to 136) were respectively manufactured in the same manner as in the manufacturing of the photoelectric conversion element and the solar cell (Specimen Number 103, 106, or 112) except for the fact that, in the manufacturing of the photoelectric conversion element and the solar cell (Specimen Number 103, 106, or 112), the following light absorber solution D was used instead of the light absorber solution A, and a 0.01 M isopropanol solution was applied onto the first electrode using a spin coating method (for 60 seconds at 5,000 rpm) instead of immersing the first electrode in the 0.1 M isopropanol solution of each compound. In the photoelectric conversion elements of the respective specimen numbers, the abundances of the respective compounds were almost the same as that in the photoelectric conversion element of Specimen Number 133.

### (Manufacturing of photoelectric conversion element and solar cell (Specimen Number c102))

A photoelectric conversion element and a solar cell of the present invention (Specimen Number c102) for a comparative example were manufactured in the same manner as in the manufacturing of the photoelectric conversion element and the solar cell (Specimen Number c101) except for the fact that, in the manufacturing of the photoelectric conversion element and the solar cell (Specimen Number c101), the following light absorber solution D was used instead of the light absorber solution A.

### Example 2

### (Manufacturing of photoelectric conversion element and solar cell (Specimen Number 201))

A photoelectric conversion element 10E and a solar cell illustrated in Fig. 5 were manufactured in an order described below.

An aqueous solution of 1.5% by mass of polyethylene dioxythiophene:polystyrene sulfonate (PEDOT:PSS) was applied onto the conductive support 11 obtained by forming a tin-doped In₂O₃ conductive film (the transparent electrode 11b having a film thickness of 300 nm) on the glass support 11a (thickness: 1 mm) using a spin coating method (for 30 seconds at 2,000 rpm) and then was dried at 120°C for ten minutes using a hot plate. The hole transportation layer 16 was formed in the above-described manner.

Next, the purified CH₃NH₃I obtained in Example 1 and PbI₂ were stirred and mixed together at 60°C in γ-butyrolactone for 12 hours at a molar ratio of 3:1 and then were filtered using a PTFE syringe filter, thereby preparing 40% by mass of a light absorber solution E.

The prepared light absorber solution E was applied onto the hole transportation layer 16 using a spin coating method (for 60 seconds at 3,500 rpm) and was dried at 90°C for 90 minutes using a hot plate, and the photosensitive layer 13C (having a film thickness of 200 nm) made of a perovskite compound of CH₃NH₃PI₃ was provided, thereby producing a first electrode 1E.

Next, a compound layer was formed on the surface of the photosensitive layer 13C in the same manner as in the manufacturing of the photoelectric conversion element and the solar cell of Example 1 (Specimen Number 129). The abundance of Compound T3-1 was 2.5 mg/m².

A 1% by mass chlorobenzene solution of PC₆₁BM was prepared, and this solution was applied onto the compound layer using a spin coating method (for 60 seconds at 1,000 rpm). The applied solution was dried at 60°C for five minutes using a hot plate. The electron transportation layer 4 was formed in the above-described manner.

Furthermore, alumina was vapor-deposited on the electron transportation layer 4 using a vapor deposition method, thereby producing the second electrode 2 (having a film thickness of 100 nm).

A photoelectric conversion element 10E and a solar cell (Specimen Number 201) were manufactured in the above-described manner.

### Example 3

### (Manufacturing of photoelectric conversion element and solar cell (Specimen Number 301))

A photoelectric conversion element not including the hole transportation layer (refer to the photoelectric conversion element 10F illustrated in Fig. 6) and a solar cell were manufactured in an order described below.

A photoelectric conversion element and a solar cell of the present invention (Specimen Number 301) were manufactured in the same manner as in the manufacturing of the photoelectric conversion element and the solar cell (Specimen Number 101) except for the fact that, in manufacturing of the photoelectric conversion element and the solar cell (Specimen Number 101), the second electrode 2 (having a film thickness of 0.1 µm) was produced by vapor-depositing gold on the compound layer 5C using a vapor deposition method without forming the hole transportation layer 3A.

### (Evaluation of variation of photoelectric conversion efficiency)

For each of the solar cells having a different specimen number, the variation of photoelectric conversion efficiency was evaluated in the following manner.

That is, ten test bodies of each of the solar cells having a different specimen number were manufactured in the same manner, cell characteristics tests were performed, and the photoelectric conversion efficiencies (η/%) were measured. The cell characteristic tests were performed by radiating 1,000 W/m² of simulated sunlight which had passed through an AM 1.5 filter from a xenon lamp using a solar simulator "WXS-85H" (manufactured by Wacom Electric Co., Ltd.). The current-voltage characteristics were measured using an I-V tester, and the photoelectric conversion efficiencies (η/%) were obtained.

For each specimen number, the average value of the photoelectric conversion efficiencies of the ten test bodies was computed, and the average value was set to "1". The photoelectric conversion efficiency (relative value) of each of the ten test bodies of the solar cell with respect to this standard "1" was obtained, ranges including the maximum value of a difference (absolute value) between this photoelectric conversion efficiency (relative value) and the standard were classified on the basis of the following standards, and the variation of photoelectric conversion efficiency was evaluated. At this time, whether the maximum value of the difference (absolute value) is larger or smaller than the average value (standard "1") is not differentiated.

A: 0 or more and 0.18 or less
B: More than 0.18 and 0.21 or less
C+: More than 0.21 and 0.24 or less
C: More than 0.24 and 0.27 or less
D: More than 0.27 and 0.30 or less
E: More than 0.30

In the evaluation of the variation in the photoelectric conversion efficiency, the photoelectric conversion efficiency of the respective solar cells of the present invention was at a level at which the solar cells were capable of sufficiently functioning as a solar cell.

**[Table 1]**

| Specimen Number | Compound | Perovskite composition | Variation | Note |
|---|---|---|---|---|
| c101 | None | CH₃NH₃PbI₃ | E | Comparative Example |
| 101 | T3-1 | CH₃NH₃PbI₃ | C+ | Present Invention |
| 102 | T6-1 | CH₃NH₃PbI₃ | B | Present Invention |
| 103 | T4-1 | CH₃NH₃PbI₃ | D | Present Invention |
| 104 | T4-2 | CH₃NH₃PbI₃ | D | Present Invention |
| 105 | T4-3 | CH₃NH₃PbI₃ | C | Present Invention |
| 106 | T7-1 | CH₃NH₃PbI₃ | C+ | Present Invention |
| 107 | T7-4 | CH₃NH₃PbI₃ | C+ | Present Invention |
| 108 | T4-7 | CH₃NH₃PbI₃ | C | Present Invention |
| 109 | T4-8 | CH₃NH₃PbI₃ | C | Present Invention |
| 110 | T5A-2 | CH₃NH₃PbI₃ | B | Present Invention |
| 111 | T5A-3 | CH₃NH₃PbI₃ | B | Present Invention |
| 112 | T5A-1 | CH₃NH₃PbI₃ | B | Present Invention |
| 113 | T5A-5 | CH₃NH₃PbI₃ | A | Present Invention |
| 114 | T5B-18 | CH₃NH₃PbI₃ | B | Present Invention |
| 115 | T5B-30 | CH₃NH₃PbI₃ | A | Present Invention |
| 116 | T5B-34 | CH₃NH₃PbI₃ | A | Present Invention |
| 117 | T7-3 | CH₃NH₃PbI₃ | C+ | Present Invention |
| 118 | T7-3 | CH₃NH₃PbI₂Cl | C+ | Present Invention |
| 119 | T7-3 | CH₃NH₃PbBr₃ | C+ | Present Invention |
| 120 | T5C-17 | CH₃NH₃PbI₃ | C+ | Reference Example |
| 121 | T5B-25 | CH₃NH₃PbI₃ | B | Present Invention |
| 122 | T6-3 | CH₃NH₃PbI₃ | B | Present Invention |
| 123 | T5B-2 | CH₃NH₃PbI₃ | C+ | Present Invention |
| 124 | T5B-6 | CH₃NH₃PbI₃ | B | Present Invention |
| 125 | T5C-14 | CH₃NH₃PbI₃ | C+ | Reference Example |
| 126 | T3-3 | CH₃NH₃PbI₃ | C | Present Invention |
| 127 | T4-11 | CH₃NH₃PbI₃ | C | Present Invention |
| 128 | T5B-37 | CH₃NH₃PbI₃ | C | Present Invention |
| 129 | T3-1 | CH₃NH₃PbI₃ | C+ | Present Invention |
| 130 | T6-9 | CH₃NH₃PbI₃ | C+ | Present Invention |
| 131 | T7-5 | CH₃NH₃PbI₃ | C | Present Invention |
| 132 | T5B-24 | CH₃NH₃PbI₃ | B | Present Invention |
| c102 | None | (CH₃CH₂NH₃)₂PbI₄ | E | Comparative Example |
| 133 | T6-1 | (CH₃CH₂NH₃)₂PbI₄ | B | Present Invention |
| 134 | T4-1 | (CH₃CH₂NH₃)₂PbI₄ | D | Present Invention |
| 135 | T7-1 | (CH₃CH₂NH₃)₂PbI₄ | C+ | Present Invention |
| 136 | T5A-1 | (CH₃CH₂NH₃)₂PbI₄ | B | Present Invention |
| 201 | T3-1 | CH₃NH₃PbI₃ | C+ | Present Invention |
| 301 | T3-1 | CH₃NH₃PbI₃ | C+ | Present Invention |

As shown in Table 1, in all of the solar cells of the present invention which had the compound represented by any formula of Formulae (3) to (5) on the surface of the first electrode, the variation of photoelectric conversion efficiency was decreased. It was found that the effect of decreasing the variation of photoelectric conversion efficiency enhances in an order of the compound represented by Formula (4), the compound represented by Formula (3), and the compound represented by Formula (5).

In the compound represented by Formula (3), it was found that, when L¹ is a branched alkyl group or an alkyl group having a halogen atom, the effect of decreasing the variation of photoelectric conversion efficiency enhances.

In the compound represented by Formula (4), it was found that, when the linking group J² has an alkyl group or a fluorine atom as the substituent W^{P} or G² and G³ are an amino group, the effect of decreasing the variation of photoelectric conversion efficiency enhances.

In the compound represented by Formula (5), it was found that the effect of decreasing the variation of photoelectric conversion efficiency improves when the substituent R¹¹ is a branched alkyl group or an alkyl group substituted with a fluorine atom, n13 is 1 or higher, and, furthermore, the ring C is an aromatic heterocyclic group.

It was found that the effect of the compound represented by any formula of Formulae (3) to (5) decreasing the variation of photoelectric conversion efficiency is exhibited in the same manner even when the method for forming the photosensitive layer is different (the method for bringing the light absorber solution into contact is different), the crystal structure (Formulae (I-1) or (I-2)) of the perovskite compound is different, and the layer constitutions of the solar cell is different.

In contrast, in all of the solar cells (Specimen Numbers c101 and c102) not having the compound represented by any formula of Formulae (3) to (5) on the surface of the first electrode, the variation of photoelectric conversion efficiency was great.

### Explanation of References

1A to 1F: first electrode
11: conductive support
11a: support
11b: transparent electrode
12: porous layer
13Ato 13C: photosensitive layer
14: blocking layer
2: second electrode
3A, 3B, 16: hole transportation layer
4, 15: electron transportation layer
5A to 5C: compound layer
6: external circuit (lead)
10A to 10F: photoelectric conversion element
100A to 100F: system in which solar cell is used
M: electric motor

## Claims

1. A photoelectric conversion element comprising:
a first electrode (1A to 1F) having a photosensitive layer (13A to 13C) including a light absorber on a conductive support (11); and
a second electrode (2) facing the first electrode (1A to 1F),
wherein the light absorber includes a compound having a perovskite-type crystal structure represented by Formula (I) below having a cation of a cationic organic group A, a cation of a metallic atom M, and an anion that is an anionic atom or atomic group X,
Formula (I): AₐMₘXₓ
in Formula (I), A represents a cationic organic group represented by Formula (1) below, M represents Pb, Sn, or Pb and Sn, X represents an anionic atom or atomic group, a represents 1 or 2, m represents 1, and a, m, and x satisfy a+2m=x,
Formula (1): R^{1a}-NH₃
in Formula (1), R^{1a} represents a substituent;
**characterized in that** a layer of at least one compound selected from compounds represented by any formula of Formulae (3) to (5) below is provided on a surface of the first electrode (1A to IF): 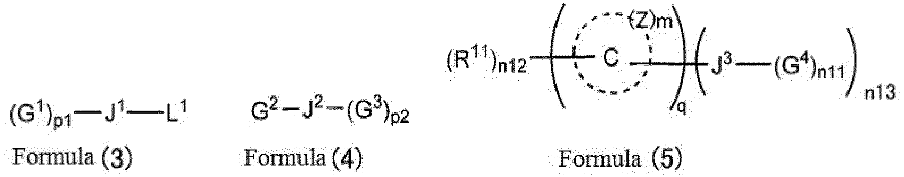
in Formula (3), G¹ represents a group or a salt selected from the group consisting of -OR^{a}, -O⁻Ya⁺, -SR^{a}, -S⁻Ya⁺, -NR^{a}R^{b}, and -(NR^{a}R^{b}R^{c})⁺ Ya⁻, R^{a}, R^{b}, and R^{c} each independently represent a hydrogen atom or a substituent, Ya represents a counter salt, L¹ represents an alkyl group, a cycloalkyl group, a cycloalkenyl group, or a cycloalkadiene group, J¹ represents a single bond or at least one linking group selected from the group consisting of linking groups represented by Formulae J-1 to J-8 below, and p1 is an integer of 1 or higher,
in Formula (4), G² and G³ are each independently identical to G¹, J² represents at least one linking group selected from the group consisting of linking groups represented by Formulae J-1 to J-8 below, and p2 represents an integer of 1 or higher,
in Formula (5), a ring C represents an aromatic hetero ring, Z represents a hetero atom or NR¹², m represents 1 or 2, R¹¹ represents a substituent, R¹² represents a hydrogen atom or a substituent, G⁴ is identical to G¹, J³ represents a single bond or a linking group, n11 represents an integer of 1 or higher, and n12 and n13 each independently represent an integer of 0 or higher; here, in a case in which a nitrogen atom is not a constituent atom of the ring C, n13 represents an integer of 1 or higher, and q represents an integer of 1 or higher, 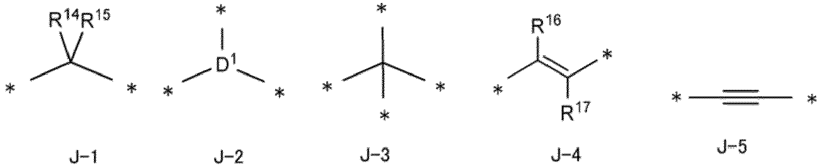 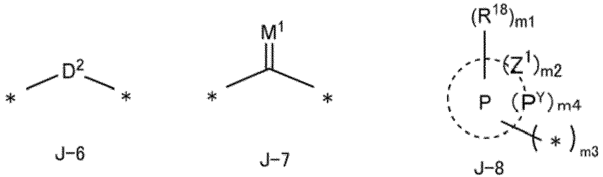
in the formulae, * represents a linking portion to L¹, G¹, G² or G³, or a linking portion to other linking groups represented by any formula of Formulae J-1 to J-8, D¹ represents a nitrogen atom, N⁺R¹⁹, or CR²⁰, D² represents an oxygen atom, a sulfur atom, or NR²¹, M¹ represents an oxygen atom, a sulfur atom, or NR²², Z¹ represents a hetero atom or NR¹³, P^{Y} represents >C=CR^{Y1}R^{Y2}, >C=S, or >C=O, a ring P represents an aliphatic hydrocarbon ring or an aliphatic hetero ring, R¹³ to R¹⁷ and R¹⁹ to R²² each independently represent a hydrogen atom or a substituent, R¹⁸, R^{Y1} , and R^{Y2} each independently represent a substituent, m1 represents an integer of 0 or higher, m2 represents an integer of 0 or higher, m3 represents an integer of 2 or higher, and m4 represents an integer of 0 or higher.

2. The photoelectric conversion element according to claim 1,
wherein R^{1a} is an alkyl group, a cycloalkyl group, an alkenyl group, an alkynyl group, an aryl group, a heteroaryl group, or a group that can be represented by Formula (2) below, 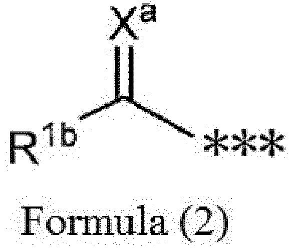 in the formula, X^{a} represents NR^{1c}, an oxygen atom, or a sulfur atom, R^{1b} and R^{1c} each independently represent a hydrogen atom or a substituent, and *** represents a bonding location to the nitrogen atom in Formula (1).

3. The photoelectric conversion element according to any one of claims 1 or 2,
wherein the linking group J³ is at least one linking group selected from the group consisting of linking groups represented by Formulae J-1 to J-8 below, 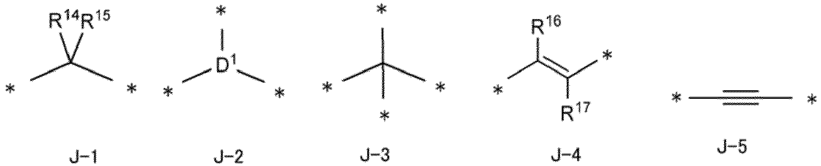 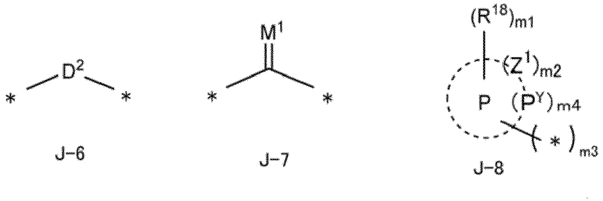 in the formulae, * represents a linking portion to G⁴, or the ring C or a linking portion to other linking groups represented by any formula of Formulae J-1 to J-8, D¹ represents a nitrogen atom, N⁺R¹⁹, or CR²⁰, D² represents an oxygen atom, a sulfur atom, or NR²¹, M¹ represents an oxygen atom, a sulfur atom, or NR²², Z¹ represents a hetero atom or NR¹³, P^{Y} represents >C=CR^{Y1}R^{Y2}, >C=S, or >C=O, a ring P represents an aliphatic hydrocarbon ring or an aliphatic hetero ring, R¹³ to R¹⁷ and R¹⁹ to R²² each independently represent a hydrogen atom or a substituent, R¹⁸, R^{Y1}, and R^{Y2} each independently represent a substituent, m1 represents an integer of 0 or higher, m2 represents an integer of 0 or higher, m3 represents an integer of 2 or higher, and m4 represents an integer of 0 or higher.

4. The photoelectric conversion element according to any one of claim 1 to 3,
wherein the compounds represented by Formulae (3) to (5) are respectively compounds represented by Formula (6) to (8) below, 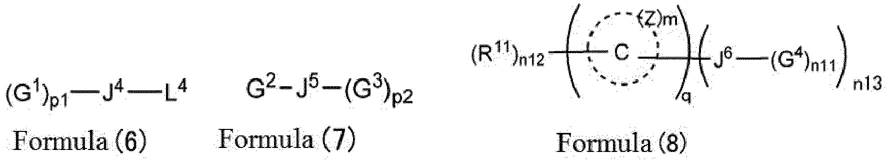 in Formula (6), G¹ and p1 are identical to G¹ and p1 in Formula (3), L⁴ represents a branched alkyl group or an alkyl group or cycloalkyl group having a halogen atom, J⁴ represents a single bond or a linking group represented by Formula J-7 below,
in Formula (7), G² and G³ are each independently identical to G¹ in Formula (3), p2 is identical to p2 in Formula (4), J⁵ represents at least one linking group selected from the group consisting of linking groups represented by Formulae J-1 and J-8 below, and, in a case in which J⁵ only represents the linking group represented by Formula J-1, at least one of R¹⁴ and R¹⁵ in Formula J-1 represents a halogen atom, an alkyl group, or an alkyl group having a halogen atom,
in Formula (8), J⁶ represents a single bond or at least one linking group selected from the group consisting of linking groups represented by Formulae J-1, J-6, and J-7 below, and the ring C, Z, m, q, R¹¹, G⁴, n11, n12, and n13 are each identical to the ring C, Z, m, q, R¹¹, G⁴, n11, n12, and n13 in Formula (5), 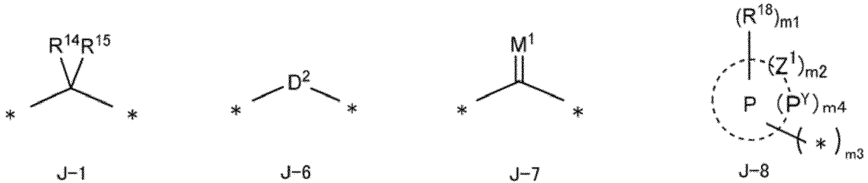 in the formulae, * represents a linking portion to G¹, G², G³, G⁴, L⁴, or the ring C or a linking portion to other linking groups, D² represents an oxygen atom, a sulfur atom, or NR²¹, M¹ represents an oxygen atom, a sulfur atom, or NR²², Z¹ represents a hetero atom or NR¹³, P^{Y} represents >C=CR^{Y1}R^{Y2}, >C=S, or >C=O, a ring P represents an aliphatic hydrocarbon ring or an aliphatic hetero ring, R¹³ to R¹⁵, R²¹, and R²² each independently represent a hydrogen atom or a substituent, R¹⁸, R^{Y1}, and R^{Y2} each independently represent a substituent, m1 represents an integer of 0 or higher, m2 represents an integer of 0 or higher, m3 represents an integer of 2 or higher, and m4 represents an integer of 0 or higher.

5. The photoelectric conversion element according to any one of claims 1 to 4,
wherein n13 represents an integer of 1 or higher.

6. The photoelectric conversion element according to any one of claims 1 to 5,
wherein G¹, G², G³, and G⁴ are each independently represented by -NR^{a}R^{b} or - (NR^{a}R^{b}R^{c})⁺Ya⁻.

7. The photoelectric conversion element according to any one of claims 1 to 6,
wherein R¹¹ is a halogen atom, a branched alkyl group, or a group having a halogen atom.

8. The photoelectric conversion element according to any one of claims 1 to 7,
wherein M is at least one metallic atom selected from the group consisting of lead and tin.

9. The photoelectric conversion element according to any one of claims 1 to 8,
wherein X represents a halogen atom.

10. The photoelectric conversion element according to any one of claims 1 to 9, further comprising:
a porous layer (12) between the conductive support (11) and the photosensitive layer (13A to 13C).

11. The photoelectric conversion element according to any one of claims 1 to 10, further comprising:
a hole transportation layer (3A, 3B, 16) between the first electrode (1A to 1F) and the second electrode (2).

12. A solar cell comprising:
the photoelectric conversion element according to any one of claims 1 to 11.

13. A method for manufacturing a photoelectric conversion element,
wherein a first electrode (1A to 1F) having, on a conductive support (11), a photosensitive layer (13A to 13C) in which a compound having a perovskite-type crystal structure represented by Formula (I) below having a cation of a cationic organic group A, a cation of a metallic atom M, and an anion that is an anionic atom or atomic group X is included as a light absorber
Formula (I): AₐMₘXₓ
in Formula (I), A represents a cationic organic group represented by Formula (1) below, M represents Pb, Sn, or Pb and Sn, X represents an anionic atom or atomic group, a represents 1 or 2, m represents 1, and a, m, and x satisfy a+2m=x,
Formula (1): R^{1a}-NH₃
in Formula (1), R^{1a} represents a substituent;
**characterized in that** the perovskite-type crystal structure represented by Formula (I) is brought into contact with liquid containing at least one compound selected from compounds represented by any formula of Formulae (3) to (5) below, thereby forming a layer of the compound on a surface of the first electrode: 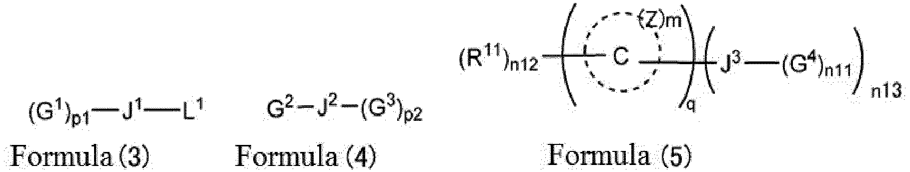
in Formula (3), G¹ represents a group or a salt selected from the group consisting of -OR^{a}, -O⁻Ya⁺, -SR^{a}, -S⁻Ya⁺, -NR^{a}R^{b}, and -(NR^{a}R^{b}R^{c})⁺ Ya⁻, R^{a}, R^{b}, and R^{c} each independently represent a hydrogen atom or a substituent, Ya represents a counter salt, L¹ represents an alkyl group, a cycloalkyl group, a cycloalkenyl group, or a cycloalkadiene group, J¹ represents a single bond or at least one linking group selected from the group consisting of linking groups represented by Formulae J-1 to J-8 below, and p1 is an integer of 1 or higher,
in Formula (4), G² and G³ are each independently identical to G¹, J² represents at least one linking group selected from the group consisting of linking groups represented by Formulae J-1 to J-8 below, and p2 represents an integer of 1 or higher,
in Formula (5), a ring C represents an aromatic hetero ring, Z represents a hetero atom or NR¹², m represents 1 or 2, R¹¹ represents a substituent, R¹² represents a hydrogen atom or a substituent, G⁴ is identical to G¹, J³ represents a single bond or a linking group, n11 represents an integer of 1 or higher, and n12 and n13 each independently represent an integer of 0 or higher; here, in a case in which a nitrogen atom is not a constituent atom of the ring C, n13 represents an integer of 1 or higher, and q represents an integer of 1 or higher, 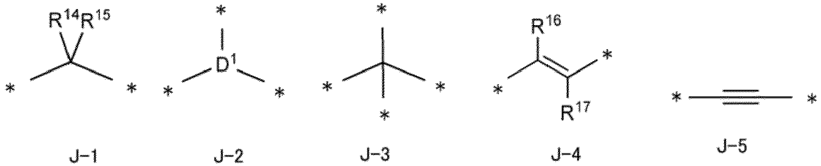 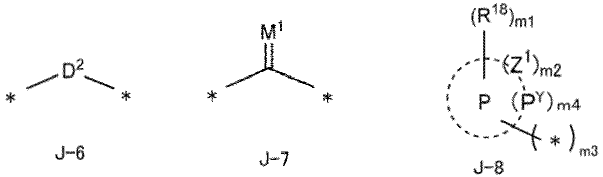
in the formulae, * represents a linking portion to L¹, G¹, G² or G³, or a linking portion to other linking groups represented by any formula of Formulae J-1 to J-8, D¹ represents a nitrogen atom, N⁺R¹⁹ , or CR²⁰, D² represents an oxygen atom, a sulfur atom, or NR²¹, M¹ represents an oxygen atom, a sulfur atom, or NR²², Z¹ represents a hetero atom or NR¹³, P^{Y} represents >C=CR^{Y1}R^{Y2}, >C=S, or >C=O, a ring P represents an aliphatic hydrocarbon ring or an aliphatic hetero ring, R¹³ to R¹⁷ and R¹⁹ to R²² each independently represent a hydrogen atom or a substituent, R¹⁸, R^{Y1}, and R^{Y2} each independently represent a substituent, m1 represents an integer of 0 or higher, m2 represents an integer of 0 or higher, m3 represents an integer of 2 or higher, and m4 represents an integer of 0 or higher.

## Patentansprüche

1. Fotoelektrisches Umwandlungselement, umfassend:
eine erste Elektrode (1A bis 1F), die eine fotoempfindliche Schicht (13A bis 13C), die einen Lichtabsorber enthält, auf einem leitfähigen Träger (11) aufweist; und
eine zweite Elektrode (2), die der ersten Elektrode (1A bis 1F) gegenüberliegt,
worin der Lichtabsorber eine durch die nachstehende Formel (I) dargestellte Verbindung mit einer Kristallstruktur vom Perowskit-Typ umfasst, die ein Kation einer kationischen organischen Gruppe A, ein Kation eines metallischen Atoms M und ein Anion, das ein anionisches Atom oder eine atomare Gruppe X ist, aufweist:
Formel (I): AₐMₘXₓ
worin in Formel (I) A eine durch die nachstehende Formel (1) dargestellte kationische organische Gruppe darstellt, M Pb, Sn oder Pb und Sn darstellt, X ein anionisches Atom oder atomare Gruppe darstellt, a 1 oder 2 darstellt, m 1 darstellt und a, m und x a+2m=x erfüllen,
Formel (1): R^{1a}-NH₃
worin in Formel (1) R^{1a} einen Substituenten darstellt; **dadurch gekennzeichnet, dass** eine Schicht von zumindest einer Verbindung, die aus den Verbindungen ausgewählt ist, die durch irgendeine der nachstehenden Formeln (3) bis (5) dargestellt werden, auf einer Oberfläche der ersten Elektrode (1A bis 1F) vorgesehen ist: 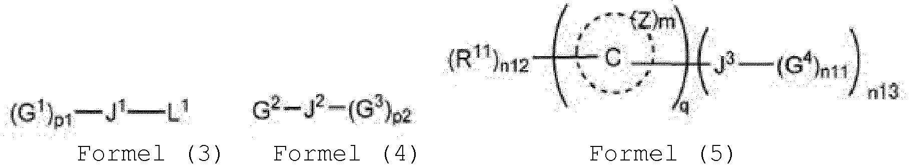
worin in Formel (3) G¹ eine Gruppe oder ein Salz darstellt, ausgewählt aus der Gruppe, bestehend aus -OR^{a}, -O⁻Ya⁺, -SR^{a}, -S⁻Ya⁺, -NR^{a}R^{b} und -(NR^{a}R^{b}R^{c})⁺Ya⁻, R^{a}, R^{b} und R^{c} jeweils unabhängig ein Wasserstoffatom oder einen Substituenten darstellen, Ya ein Gegensalz darstellt, L¹ eine Alkylgruppe, eine Cycloalkylgruppe, eine Cycloalkenylgruppe oder eine Cycloalkadiengruppe darstellt, J¹ eine Einfachbindung oder zumindest eine Verknüpfungsgruppe darstellt, die ausgewählt ist aus der Gruppe, bestehend aus den Verknüpfungsgruppen, die durch die nachstehenden Formeln J 1 bis J-8 dargestellt werden, und p1 eine ganze Zahl von 1 oder größer ist,
in Formel (4) G² und G³ jeweils unabhängig identisch zu G¹ sind, J² zumindest eine Verknüpfungsgruppe darstellt, die ausgewählt ist aus der Gruppe, bestehend aus den durch die nachstehenden Formeln J-1 bis J-8 dargestellten Verknüpfungsgruppen, und p2 eine ganze Zahl von 1 oder größer darstellt,
in der Formel (5) ein Ring C einen aromatischen Heteroring darstellt, Z ein Heteroatom oder NR¹² darstellt, m 1 oder 2 darstellt, R¹¹ einen Substituenten darstellt, R¹² ein Wasserstoffatom oder einen Substituenten darstellt, G⁴ zu G¹ identisch ist, J³ eine Einfachbindung oder eine Verknüpfungsgruppe darstellt, n11 eine ganze Zahl von 1 oder größer darstellt, und n12 und n13 jeweils unabhängig eine ganze Zahl von 0 oder größer darstellen; hier stellt in dem Fall, in dem ein Stickstoffatom kein Aufbauatom des Rings C ist, n13 eine ganze Zahl von 1 oder größer dar, und q eine ganze Zahl von 1 oder größer darstellt, 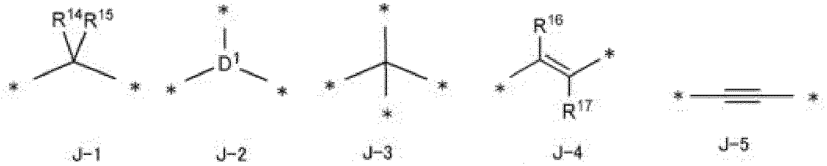 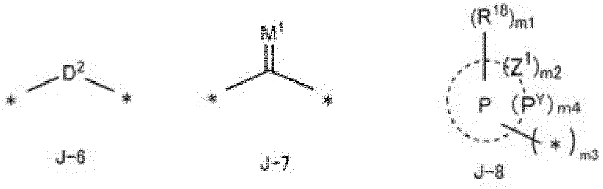
worin in den Formeln * einen Verknüpfungsteil zu L¹, G¹, G² oder G³ oder einen Verknüpfungsteil zu anderen Verknüpfungsgruppen, die durch irgendeine der Formeln J-1 bis J-8 dargestellt werden, darstellt, D¹ ein Stickstoffatom, N⁺R¹⁹ oder CR²⁰ darstellt, D² ein Sauerstoffatom, ein Schwefelatom oder NR²¹ darstellt, M¹ ein Sauerstoffatom, ein Schwefelatom oder NR²² darstellt, Z¹ ein Heteroatom oder NR¹³ darstellt, P^{Y} >C=CR^{Y1}R^{Y2}, >C=S oder >C=O darstellt, ein Ring P einen aliphatischen Kohlenwasserstoffring oder einen aliphatischen Heteroring darstellt, R¹³ bis R¹⁷ und R¹⁹ bis R²² jeweils unabhängig ein Wasserstoffatom oder einen Substituenten darstellten, R¹⁸, R^{Y1} und R^{Y2} jeweils unabhängig einen Substituenten darstellen, m1 eine ganze Zahl von 0 oder größer darstellt, m2 eine ganze Zahl 0 oder größer darstellt, m3 eine ganze Zahl von 2 oder größer darstellt und m4 eine ganze Zahl von 0 oder größer darstellt.

2. Fotoelektrisches Umwandlungselement gemäß Anspruch 1, worin R^{1a} eine Alkylgruppe, eine Cycloalkylgruppe, eine Alkenylgruppe, eine Alkinylgruppe, eine Arylgruppe, eine Heteroarylgruppe oder eine Gruppe, die durch die nachstehende Formel (2) dargestellt werden kann, darstellt: 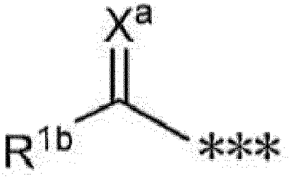 worin in der Formel X^{a} NR^{1c}, ein Sauerstoffatom oder ein Schwefelatom darstellt, R^{1b} und R^{1c} jeweils unabhängig ein Wasserstoffatom oder einen Substituenten darstellen und *** eine Verbindungsposition zum Stickstoffatom in Formel (1) darstellt.

3. Fotoelektrisches Umwandlungselement gemäß Anspruch 1 oder 2, worin die Verknüpfungsgruppe J³ zumindest eine Verknüpfungsgruppe ist, die ausgewählt ist aus der Gruppe, bestehend aus den durch die nachstehenden Formeln J-1 bis J-8 dargestellten Verknüpfungsgruppen: 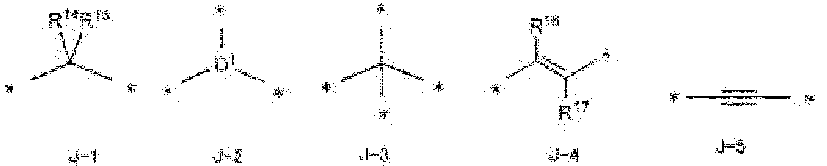 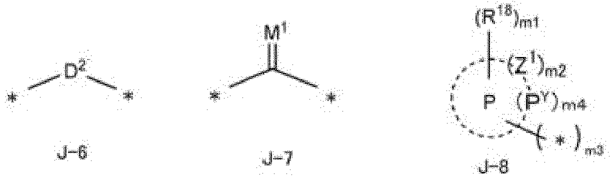 worin in den Formeln * einen Verknüpfungsteil zu G⁴, oder dem Ring C oder einen Verknüpfungsteil zu anderen Verknüpfungsgruppen, die durch irgendeine der Formeln J-1 bis J-8 dargestellt werden, darstellt, D¹ ein Stickstoffatom, N⁺R¹⁹ oder CR²⁰ darstellt, D² ein Sauerstoffatom, ein Schwefelatom oder NR²¹ darstellt, M¹ ein Sauerstoffatom, ein Schwefelatom oder NR²² darstellt, Z¹ ein Heteroatom oder NR¹³ darstellt, P^{Y} >C=CR^{Y1}R^{Y2}, >C=S oder >C=O darstellt, ein Ring P einen aliphatischen Kohlenwasserstoffring oder einen aliphatischen Heteroring darstellt, R¹³ bis R¹⁷ und R¹⁹ bis R²² jeweils unabhängig ein Wasserstoffatom oder einen Substituenten darstellten, R¹⁸, R^{Y1} und R^{Y2} jeweils unabhängig einen Substituenten darstellen, m1 eine ganze Zahl von 0 oder größer darstellt, m2 eine ganze Zahl 0 oder größer darstellt, m3 eine ganze Zahl von 2 oder größer darstellt und m4 eine ganze Zahl von 0 oder größer darstellt.

4. Fotoelektrisches Umwandlungselement gemäß irgendeinem der Ansprüche 1 bis 3,
worin die durch die Formeln (3) bis (5) dargestellten Verbindungen jeweils Verbindungen sind, die durch die nachstehenden Formeln (6) bis (8) dargestellt werden: 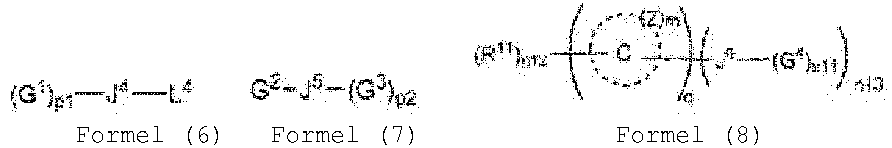 worin in Formel (6) G¹ und p1 identisch zu G¹ und p1 in Formel (3) sind, L⁴ eine verzweigte Alkylgruppe oder eine Alkylgruppe oder eine Cycloalkylgruppe mit einem Halogenatom darstellt, J⁴ eine Einfachbindung oder eine durch die nachstehende Formel J-7 dargestellte Verknüpfungsgruppe darstellt,
in der Formel (7) G² und G³ jeweils unabhängig identisch zu G¹ in Formel (3) sind, p2 identisch zu p2 in Formel (4) ist, J⁵ zumindest eine Verknüpfungsgruppe darstellt, ausgewählt aus der Gruppe, bestehend aus den durch die nachstehenden Formeln J-1 und J-8 dargestellten Verknüpfungsgruppen, und wenn J⁵ nur die durch die Formel J-1 dargestellte Verknüpfungsgruppe darstellt, zumindest eines von R¹⁴ und R¹⁵ in Formel J-1 ein Halogenatom, eine Alkylgruppe oder eine Alkylgruppe, die ein Halogenatom aufweist, darstellt,
in der Formel (8) J⁶ eine Einfachbindung oder zumindest eine Verknüpfungsgruppe darstellt, ausgewählt aus der Gruppe, bestehend aus den durch die nachstehenden Formeln J-1, J-6 und J-7 dargestellten Verknüpfungsgruppen, und der Ring C, Z, m, q, R¹¹, G⁴, n11, n12 und n13 jeweils identisch zu dem Ring C, Z, m, q, R¹¹, G⁴, n11, n12 und n13 in Formel (5) sind: 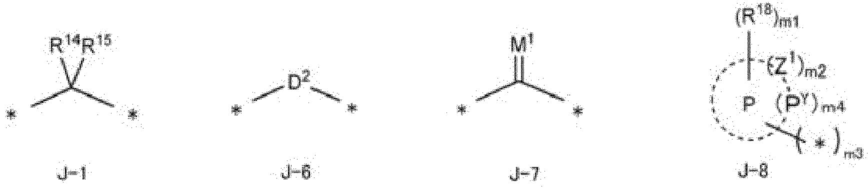 worin in den Formeln * einen Verknüpfungsteil zu G¹, G², G³, G⁴, L⁴ oder dem Ring C oder einen Verknüpfungsteil zu einer anderen Verknüpfungsgruppe darstellt, D² ein Sauerstoffatom, ein Schwefelatom oder NR²¹ darstellt, M¹ ein Sauerstoffatom, ein Schwefelatom oder NR²² darstellt, Z¹ ein Heteroatom oder NR¹³ darstellt, P^{Y} >C=CR^{Y1}R^{Y2}, >C=S oder >C=O darstellt, ein Ring P einen aliphatischen Kohlenwasserstoffring oder einen aliphatischen Heteroring darstellt, R¹³ bis R¹⁵, R²¹ und R²² jeweils unabhängig ein Wasserstoffatom oder einen Substituenten darstellen, R¹⁸, R^{Y1} und R^{Y2} jeweils unabhängig einen Substituenten darstellen, m1 eine ganze Zahl von 0 oder größer darstellt, m2 eine ganze Zahl von 0 oder größer darstellt, m3 eine ganze Zahl von 2 oder größer darstellt und m4 eine ganze Zahl von 0 oder größer darstellt.

5. Fotoelektrisches Umwandlungselement gemäß irgendeinem der Ansprüche 1 bis 4, worin n13 eine ganze Zahl von 1 oder größer darstellt.

6. Fotoelektrisches Umwandlungselement gemäß irgendeinem der Ansprüche 1 bis 5, worin G¹, G², G³ und G⁴ jeweils unabhängig durch -NR^{a}R^{b} oder -(NR^{a}R^{b}R^{c})⁺Ya⁻ dargestellt werden.

7. Fotoelektrisches Umwandlungselement gemäß irgendeinem der Ansprüche 1 bis 6, worin R¹¹ ein Halogenatom, eine verzweigte Alkylgruppe oder eine Gruppe, die ein Halogenatom aufweist, ist.

8. Fotoelektrisches Umwandlungselement gemäß irgendeinem der Ansprüche 1 bis 7, worin M zumindest ein metallisches Atom ist, ausgewählt aus der Gruppe, bestehend aus Blei und Zinn.

9. Fotoelektrisches Umwandlungselement gemäß irgendeinem der Ansprüche 1 bis 8, worin X ein Halogenatom darstellt.

10. Fotoelektrisches Umwandlungselement gemäß irgendeinem der Ansprüche 1 bis 9, ferner umfassend:
eine poröse Schicht (12) zwischen dem leitfähigen Träger (11) und der fotoempfindlichen Schicht (13A bis 13C).

11. Fotoelektrisches Umwandlungselement gemäß irgendeinem der Ansprüche 1 bis 10, ferner umfassend:
eine Lochtransportschicht (3A, 3B, 16) zwischen der ersten Elektrode (1A bis 1F) und der zweiten Elektrode (2) .

12. Solarzelle, umfassend:
das fotoelektrische Umwandlungselement gemäß irgendeinem der Ansprüche 1 bis 11.

13. Verfahren zur Herstellung eines fotoelektrischen Umwandlungselement,
worin eine erste Elektrode (1A bis 1F), die auf einem leitfähigen Träger (11) eine fotoempfindliche Schicht (13A bis 13C) aufweist, worin eine durch die nachstehende Formel (I) dargestellte Verbindung mit einer Kristallstruktur vom Perowskit-Typ, die ein Kation einer kationischen organischen Gruppe A, ein Kation eines metallischen Atoms M und ein Anion, das ein anionisches Atom oder eine atomare Gruppe X ist, aufweist, als ein Lichtabsorber inkludiert ist:
Formel (I): AₐMₘXₓ
worin in Formel (I) A eine durch die nachstehende Formel (1) dargestellte kationische organische Gruppe darstellt, M Pb, Sn oder Pb und Sn darstellt, X ein anionisches Atom oder atomare Gruppe darstellt, a 1 oder 2 darstellt, m 1 darstellt und a, m und x a+2m=x erfüllen,
Formel (1): R^{1a}-NH₃
worin in Formel (1) R^{1a} einen Substituenten darstellt;
**dadurch gekennzeichnet, dass** die durch die Formel (I) dargestellte Verbindung mit einer Kristallstruktur vom Perowskit-Typ in Kontakt mit einer Flüssigkeit gebracht wird, die zumindest eine Verbindung enthält, ausgewählt aus Verbindungen, die durch irgendeine der nachstehenden Formeln (3) bis (5) dargestellt werden, wodurch eine Schicht der Verbindung auf einer Oberfläche der ersten Elektrode gebildet wird: 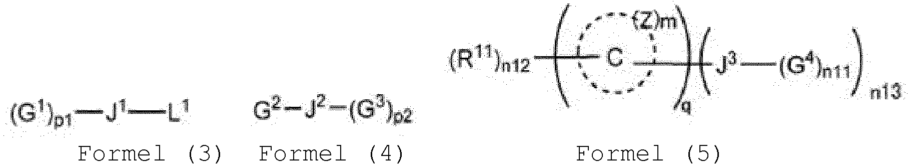 worin in Formel (3) G¹ eine Gruppe oder ein Salz darstellt, ausgewählt aus der Gruppe, bestehend aus -OR^{a}, -O⁻Ya⁺, -SR^{a}, -S⁻Ya⁺, -NR^{a}R^{b} und -(NR^{a}R^{b}R^{c})⁺Ya^{~}, R^{a}, R^{b} und R^{c} jeweils unabhängig ein Wasserstoffatom oder einen Substituenten darstellten, Ya ein Gegensalz darstellt, L¹ eine Alkylgruppe, eine Cycloalkylgruppe, eine Cycloalkenylgruppe oder eine Cycloalkadiengruppe darstellt, J¹ eine Einfachbindung oder zumindest eine Verknüpfungsgruppe darstellt, die ausgewählt ist aus der Gruppe, bestehend aus den Verknüpfungsgruppen, die durch die nachstehenden Formeln J-1 bis J-8 dargestellt werden und p1 eine ganze Zahl von 1 oder größer ist,
in Formel (4) G² und G³ jeweils unabhängig identisch zu G¹ sind, J² zumindest eine Verknüpfungsgruppe darstellt, die ausgewählt ist aus der Gruppe, bestehend aus den durch die nachstehenden Formeln J-1 bis J-8 dargestellten Verknüpfungsgruppen, und p2 eine ganze Zahl von 1 oder größer darstellt,
in der Formel (5) ein Ring C einen aromatischen Heteroring darstellt, Z ein Heteroatom oder NR¹² darstellt, m 1 oder 2 darstellt, R¹¹ einen Substituenten darstellt, R¹² ein Wasserstoffatom oder einen Substituenten darstellt, G⁴ zu G¹ identisch ist, J³ eine Einfachbindung oder eine Verknüpfungsgruppe darstellt, n11 eine ganze Zahl von 1 oder größer darstellt, und n12 und n13 jeweils unabhängig eine ganze Zahl von 0 oder größer darstellen; hier stellt in dem Fall, in dem ein Stickstoffatom kein Aufbauatom des Rings C ist, n13 eine ganze Zahl von 1 oder größer dar, und q eine ganze Zahl von 1 oder größer darstellt, 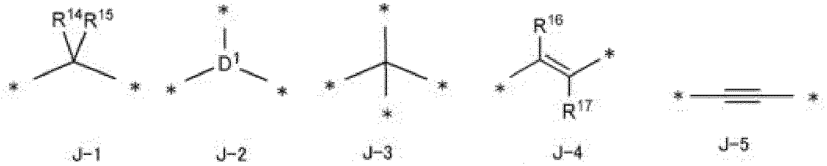 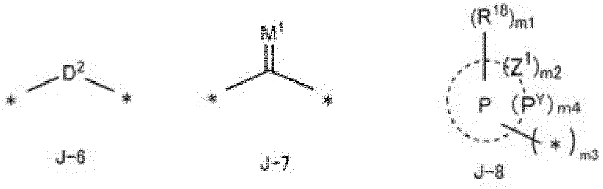 worin in den Formeln * einen Verknüpfungsteil zu L¹, G¹, G² oder G³ oder einen Verknüpfungsteil zu anderen Verknüpfungsgruppen, die durch irgendeine der Formeln J-1 bis J-8 dargestellt werden, darstellt, D¹ ein Stickstoffatom, N⁺R¹⁹ oder CR²⁰ darstellt, D² ein Sauerstoffatom, ein Schwefelatom oder NR²¹ darstellt, M¹ ein Sauerstoffatom, ein Schwefelatom oder NR²² darstellt, Z¹ ein Heteroatom oder NR¹³ darstellt, P^{Y} >C=CR^{Y1}R^{Y2}, >C=S oder >C=O darstellt, ein Ring P einen aliphatischen Kohlenwasserstoffring oder einen aliphatischen Heteroring darstellt, R¹³ bis R¹⁷ und R¹⁹ bis R²² jeweils unabhängig ein Wasserstoffatom oder einen Substituenten darstellten, R¹⁸, R^{Y1} und R^{Y2} jeweils unabhängig einen Substituenten darstellen, m1 eine ganze Zahl von 0 oder größer darstellt, m2 eine ganze Zahl 0 oder größer darstellt, m3 eine ganze Zahl von 2 oder größer darstellt und m4 eine ganze Zahl von 0 oder größer darstellt.

## Revendications

1. Élément de conversion photoélectrique comprenant :
une première électrode (1A à 1F) comportant une couche photosensible (13A à 13C) incluant un absorbeur de lumière sur un support conducteur (11) ; et
une seconde électrode (2) faisant face à la première électrode (1A à 1F),
dans lequel l'absorbeur de lumière inclut un composé ayant une structure cristalline de type pérovskite représentée par la Formule (I) ci-dessous, ayant un cation d'un groupe organique cationique A, un cation d'un atome métallique M, et un anion qui est un atome anionique ou un groupe atomique X,
Formule (I) : AₐMₘXₓ
dans la Formule (I), A représente un groupe organique cationique représenté par la Formule (1) ci-dessous, M représente Pb, Sn, ou Pb et Sn, X représente un atome anionique ou un groupe atomique, a représente 1 ou 2, m représente 1, et a, m et x satisfont à a + 2m = x,
Formule (1) : R^{1a}-NH₃
dans la Formule (1), R^{1a} représente un substituant ;
**caractérisé en ce qu'**une couche d'au moins un composé choisi parmi des composés représentés par une quelconque formule parmi les Formules (3) à (5) ci-dessous est agencée sur une surface de la première électrode (1A à 1F) : 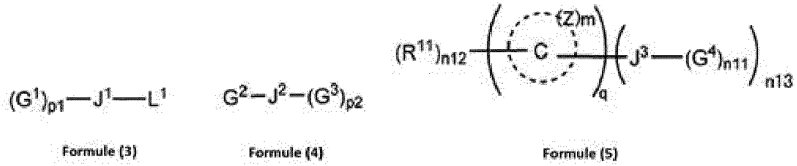
dans la Formule (3), G¹ représente un groupe ou un sel choisi parmi le groupe constitué de -OR^{a}, -O⁻Ya⁺, -SR^{a}, -S⁻Ya⁺, -NR^{a}R^{b}, et -(NR^{a}R^{b}R^{c})⁺Ya⁻, R^{a}, R^{b}, et R^{c} représentent chacun indépendamment un atome d'hydrogène ou un substituant, Ya représente un contre-sel, L¹ représente un groupe alkyle, un groupe cycloalkyle, un groupe cycloalcényle ou un groupe cycloalkadiène, J¹ représente une liaison unique ou au moins un groupe de liaison choisi parmi le groupe constitué de groupes de liaison représentés par les Formules J-1 à J-8 ci-dessous, et p1 est un nombre entier égal ou supérieur à 1,
dans la Formule (4), G² et G³ sont chacun indépendamment identiques à G¹, J² représente au moins un groupe de liaison sélectionné parmi le groupe constitué de groupes de liaison représentés par les Formules J-1 à J-8 ci-dessous, et p2 représente un nombre entier égal ou supérieur à 1,
dans la Formule (5), un cycle C représente un hétérocycle aromatique, Z représente un hétéroatome ou NR¹², m représente 1 ou 2, R¹¹ représente un substituant, R¹² représente un atome d'hydrogène ou un substituant, G⁴ est identique à G¹, J³ représente une liaison unique ou un groupe de liaison, n11 représente un nombre entier égal ou supérieur à 1, et n12 et n13 représentent chacun indépendamment un nombre entier égal ou supérieur à 0; ici, dans le cas où un atome d'azote n'est pas un atome constituant du cycle C, n13 représente un nombre entier égal ou supérieur à 1, et q représente un nombre entier égal ou supérieur à 1, 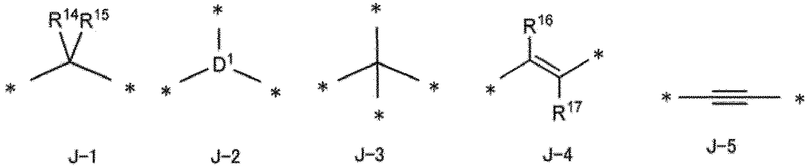 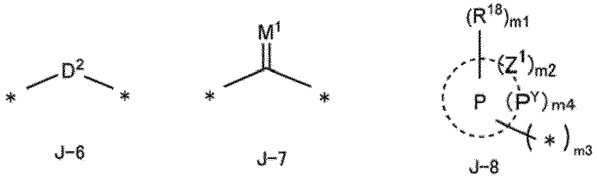
dans les formules, * représente une partie de liaison à L¹, G¹, G² ou G³, ou une partie de liaison à d'autres groupes de liaison représentés par une formule quelconque parmi les Formules J-1 à J-8, D¹ représente un atome d'azote, N⁺R¹⁹, ou CR²⁰, D² représente un atome d'oxygène, un atome de soufre, ou NR²¹, M¹ représente un atome d'oxygène, un atome de soufre, ou NR²², Z¹ représente un hétéroatome ou NR¹³, P^{Y} représente >C=CR^{Y1}R^{Y2}, >C=S, ou >C=O, un cycle P représente un cycle hydrocarboné aliphatique ou un hétérocycle aliphatique, R¹³ à R¹⁷ et R¹⁹ à R²² représentent chacun indépendamment un atome d'hydrogène ou un substituant, R¹⁸, R^{Y1}, et R^{Y2} représentent chacun indépendamment un substituant, m1 représente un nombre entier égal ou supérieur à 0, m2 représente un nombre entier égal ou supérieur à 0, m3 représente un nombre entier égal ou supérieur à 2, et m4 représente un nombre entier égal ou supérieur à 0.

2. Élément de conversion photoélectrique selon la revendication 1,
dans lequel R^{1a} est un groupe alkyle, un groupe cycloalkyle, un groupe alcényle, un groupe alcynyle, un groupe aryle, un groupe hétéroaryle, ou un groupe pouvant être représenté par la Formule (2) ci-dessous, 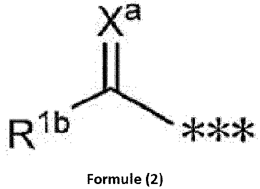 dans la formule, X^{a} représente NR^{1c}, un atome d'oxygène, ou un atome de soufre, R^{1b} et R^{1c} représentent chacun indépendamment un atome d'hydrogène ou un substituant, et *** représente un emplacement de liaison à l'atome d'azote dans la Formule (1).

3. Élément de conversion photoélectrique selon l'une quelconque des revendications 1 ou 2,
dans lequel le groupe de liaison J³ est au moins un groupe de liaison choisi parmi le groupe constitué de groupes de liaison représentés par les Formules J-1 à J-8 ci-dessous, 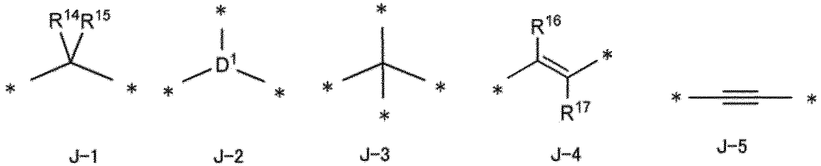 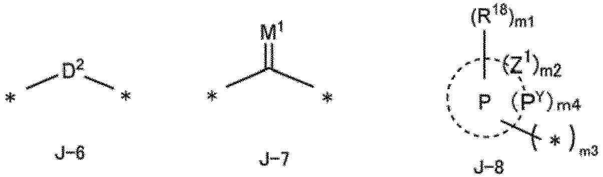 dans les Formules, * représente une partie de liaison à G⁴, ou au cycle C ou une partie de liaison à d'autres groupes de liaison représentés par une formule quelconque parmi les Formules J-1 à J-8, D¹ représente un atome d'azote, N⁺R¹⁹, ou CR²⁰, D² représente un atome d'oxygène, un atome de soufre, ou NR²¹, M¹ représente un atome d'oxygène, un atome de soufre, ou NR²², Z¹ représente un hétéroatome ou NR¹³, P^{Y} représente >C=CR^{Y1}R^{Y2}, >C=S, ou >C=O, un cycle P représente un cycle hydrocarboné aliphatique ou un hétérocycle aliphatique, R¹³ à R¹⁷ et R¹⁹ à R²² représentent chacun indépendamment un atome d'hydrogène ou un substituant, R¹⁸, R^{Y1}, et R^{Y2} représentent chacun indépendamment un substituant, m1 représente un nombre entier égal ou supérieur à 0, m2 représente un nombre entier égal ou supérieur à 0, m3 représente un nombre entier égal ou supérieur à 2, et m4 représente un nombre entier égal ou supérieur à 0.

4. Élément de conversion photoélectrique selon l'une quelconque des revendications 1 à 3,
dans lequel les composés représentés par les Formules (3) à (5) sont respectivement des composés représentés par les Formules (6) à (8) ci-dessous, 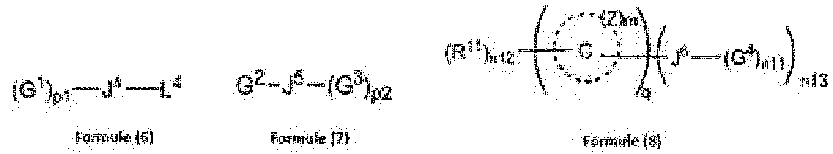 dans la Formule (6), G¹ et p1 sont identiques à G¹ et p1 de la Formule (3), L⁴ représente un groupe alkyle ramifié ou un groupe alkyle ou un groupe cycloalkyle ayant un atome d'halogène, J⁴ représente une liaison unique ou un groupe de liaison représenté par la Formule J-7 ci-dessous,
dans la Formule (7), G² et G³ sont chacun indépendamment identiques à G¹ de la Formule (3), p2 est identique à p2 de la la Formule (4), J⁵ représente au moins un groupe de liaison choisi parmi le groupe constitué de groupes de liaison représentés par les Formules J-1 et J-8 ci-dessous, et, dans le cas où J⁵ représente uniquement le groupe de liaison représenté par la Formule J-1, au moins l'un parmi R¹⁴ et R¹⁵ dans la Formule J-1 représente un atome d'halogène, un groupe alkyle, ou un groupe alkyle ayant un atome d'halogène,
dans la Formule (8), J⁶ représente une liaison unique ou au moins un groupe de liaison choisi parmi le groupe constitué de groupes de liaison représentés par les Formules J-1, J-6, et J-7 ci-dessous, et le cycle C, Z, m, q, R¹¹, G⁴, n11, n12 et n13 sont chacun identiques aux cycle C, Z, m, q, R¹¹, G⁴, n11, n12 et n13 de la Formule (5), 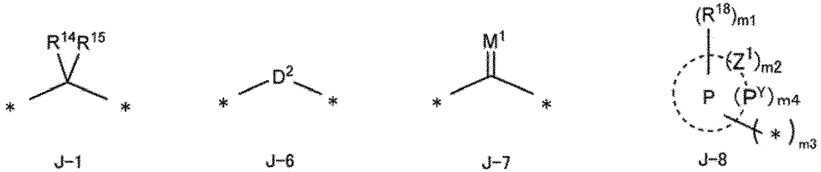 dans les Formules, * représente une partie de liaison à G¹, G², G³, G⁴, L⁴ ou au cycle C ou une partie de liaison à d'autres groupes de liaison, D² représente un atome d'oxygène, un atome de soufre, ou NR²¹, M¹ représente un atome d'oxygène, un atome de soufre, ou NR²², Z¹ représente un hétéroatome ou NR¹³, P^{Y} représente >C=CR^{Y1}R^{Y2}, >C=S, ou >C=O, un cycle P représente un cycle hydrocarboné aliphatique ou un hétérocycle aliphatique, R¹³ à R¹⁵, R²¹, et R²² représentent chacun indépendamment un atome d'hydrogène ou un substituant, R¹⁸, R^{Y1}, et R^{Y2} représentent chacun indépendamment un substituant, m1 représente un nombre entier égal ou supérieur à 0, m2 représente un nombre entier égal ou supérieur à 0, m3 représente un nombre entier égal ou supérieur à 2, et m4 représente un nombre entier égal ou supérieur à 0.

5. Élément de conversion photoélectrique selon l'une quelconque des revendications 1 à 4,
dans lequel n13 représente un nombre entier égal ou supérieur à 1.

6. Élément de conversion photoélectrique selon l'une quelconque des revendications 1 à 5,
dans lequel G¹, G², G³, et G⁴ sont chacun indépendamment représentés par -NR^{a}R^{b} ou -(NR^{a}R^{b}R^{c})⁺Ya⁻.

7. Élément de conversion photoélectrique selon l'une quelconque des revendications 1 à 6,
dans lequel R¹¹ est un atome d'halogène, un groupe alkyle ramifié, ou un groupe ayant un atome d'halogène.

8. Élément de conversion photoélectrique selon l'une quelconque des revendications 1 à 7,
dans lequel M est au moins un atome métallique choisi parmi le groupe constitué de plomb et d'étain.

9. Élément de conversion photoélectrique selon l'une quelconque des revendications 1 à 8,
dans lequel X représente un atome d'halogène.

10. Élément de conversion photoélectrique selon l'une quelconque des revendications 1 à 9, comprenant en outre :
une couche poreuse (12) entre le support conducteur (11) et la couche photosensible (13A à 13C).

11. Élément de conversion photoélectrique selon l'une quelconque des revendications 1 à 10, comprenant en outre :
une couche de transport de trous (3A, 3B, 16) entre la première électrode (1A à 1F) et la seconde électrode (2).

12. Cellule solaire comprenant:
l'élément de conversion photoélectrique selon l'une quelconque des revendications 1 à 11.

13. Procédé de fabrication d'un élément de conversion photoélectrique,
dans lequel une première électrode (1A à 1F) ayant, sur un support conducteur (11), une couche photosensible (13A à 13C) dans laquelle un composé ayant une structure cristalline de type pérovskite représentée par la Formule (I) ci-dessous ayant un cation d'un groupe organique cationique A, un cation d'un atome métallique M, et un anion qui est un atome anionique ou un groupe atomique X est inclus en tant qu'absorbeur de lumière :
Formule (I) : AₐMₘXₓ
dans la Formule (I), A représente un groupe organique cationique représenté par la Formule (1) ci-dessous, M représente Pb, Sn, ou Pb et Sn, X représente un atome anionique ou un groupe atomique, a représente 1 ou 2, m représente 1, et a, m, et x satisfont à a + 2m = x,
Formula (1) : R^{1a}-NH₃
dans la Formule (1), R^{1a} représente un substituant ;
**caractérisé en ce que** la structure cristalline de type pérovskite représentée par la Formule (I) est mise en contact avec un liquide contenant au moins un composé choisi parmi des composés représentés par une quelconque formule parmi les Formules (3) à (5) ci-dessous, formant ainsi une couche du composé sur une surface de la première électrode : 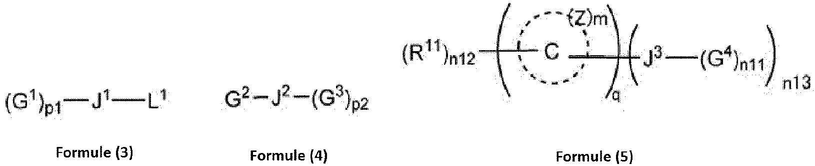 dans la Formule (3), G¹ représente un groupe ou un sel choisi parmi le groupe constitué de -OR^{a}, -O⁻Ya⁺, -SR^{a}, -S⁻Ya⁺, -NR^{a}R^{b}, et -(NR^{a}R^{b}R^{c})⁺Ya⁻, R^{a}, R^{b}, et R^{c} représentent chacun indépendamment un atome d'hydrogène ou un substituant, Ya représente un contre-sel, L¹ représente un groupe alkyle, un groupe cycloalkyle, un groupe cycloalcényle, ou un groupe cycloalkadiène, J¹ représente une liaison unique ou au moins un groupe de liaison choisi parmi le groupe constitué de groupes de liaison représentés par les Formules J-1 à J-8 ci-dessous, et p1 est un nombre entier égal ou supérieur à 1,
dans la Formule (4), G² et G³ sont chacun indépendamment identiques à G¹, J² représente au moins un groupe de liaison sélectionné parmi le groupe constitué de groupes de liaison représentés par les Formules J-1 à J-8 ci-dessous, et p2 représente un nombre entier égal ou supérieur à 1,
dans la Formule (5), un cycle C représente un hétérocycle aromatique, Z représente un hétéroatome ou NR¹², m représente 1 ou 2, R¹¹ représente un substituant, R¹² représente un atome d'hydrogène ou un substituant, G⁴ est identique à G¹, J³ représente une liaison unique ou un groupe de liaison, n11 représente un nombre entier égal ou supérieur à 1, et n12 et n13 représentent chacun indépendamment un nombre entier égal ou supérieur à 0; ici, dans le cas où un atome d'azote n'est pas un atome constituant du cycle C, n13 représente un nombre entier égal ou supérieur à 1, et q représente un nombre entier égal ou supérieur à 1, 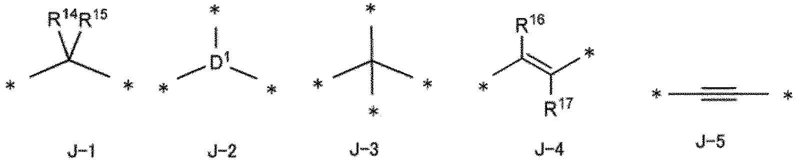 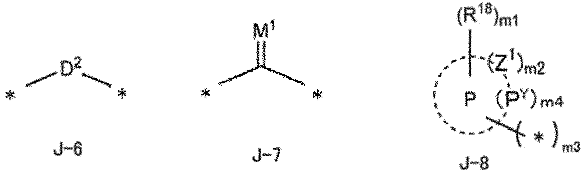 dans les formules, * représente une partie de liaison à L¹, G¹, G² ou G³, ou une partie de liaison à d'autres groupes de liaison représentés par une formule quelconque parmi les Formules J-1 à J-8, D¹ représente un atome d'azote, N⁺R¹⁹, ou CR²⁰, D² représente un atome d'oxygène, un atome de soufre, ou NR²¹, M¹ représente un atome d'oxygène, un atome de soufre, ou NR²², Z¹ représente un hétéroatome ou NR¹³, P^{Y} représente >C=CR^{Y1}R^{Y2}, >C=S, ou >C=O, un cycle P représente un cycle hydrocarboné aliphatique ou un hétérocycle aliphatique, R¹³ à R¹⁷ et R¹⁹ à R²² représentent chacun indépendamment un atome d'hydrogène ou un substituant, R¹⁸, R^{Y1}, et R^{Y2} représentent chacun indépendamment un substituant, m1 représente un nombre entier égal ou supérieur à 0, m2 représente un nombre entier égal ou supérieur à 0, m3 représente un nombre entier égal ou supérieur à 2, et m4 représente un nombre entier égal ou supérieur à 0.
